# EUROPEAN PATENT APPLICATION

(11) **EP 2 123 691 A1**
(43) Date of publication of application: **25.11.2009**
(21) Application number: 08722081.0
(22) Date of filing: 07.03.2008
(51) Int. Cl.: C08G 61/12, C08K 5/56, C08L 65/00, C09K 11/06, H01L 51/50

(54) **POLYMER COMPOUND AND COMPOSITION CONTAINING THE SAME**

(30) Priority: 09.03.2007 JP 2007059820
(71) Applicant: Sumitomo Chemical Company, Limited, Tokyo 104-8260 (JP); Sumation Co., Ltd., Chuo-ku Tokyo 104-8260 (JP)
(72) Inventor: MIKAMI, Satoshi, Tsukuba-shi Ibaraki 305-0045 (JP); SEKINE, Chizu, Tsukuba-shi Ibaraki 300-4249 (JP)
(74) Representative: Duckworth, Timothy John
(86) International application number: PCT/JP2008/054684
(87) International publication number: WO 2008/111658

(57) **Abstract**

A polymer compound comprising as repeating units an optionally substituted fluorenediyl group and a phenylene group having one or more substituents, and comprising a repeating unit of the following formula (1) and/or a group of the following formula (2): 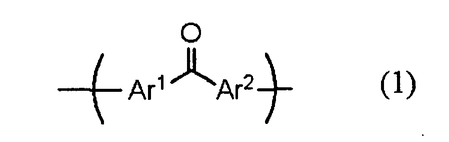 (in the formula (1), Ar¹ and Ar² represent an arylene group or di-valent aromatic heterocyclic group, and Ar¹ and Ar² may be the same or different.) 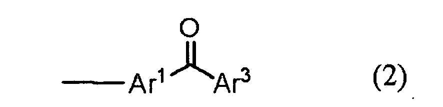 (in the formula (2), Ar¹ represents the same meaning as described above. Ar³ represents an aryl group or mono-valent aromatic heterocyclic group.).

## Description

### Technical Field

The present invention relates to a polymer compound and a composition containing the same.

### Background Art

Recently, in the field of an organic electroluminescence device (hereinafter, abbreviated as "organic EL device" in some cases), various light emitting materials are studied and developed actively. In particular, light emitting materials containing a compound showing light emission from the triplet excited state (hereinafter, abbreviated as "triplet compound" in some cases) are expected as materials emitting light at high luminous efficiency.

As a method, in production of an organic EL device using a light emitting material containing a triplet compound, for fabricating a thin film containing the light emitting material, a method is known in which a composition obtained by mixing the triplet compound with a polymer compound is dissolved in a solvent, and a thin film is formed by an application method. When the triplet compound is thus mixed with a polymer compound and used, the polymer compound may exert an significant influence on the property of the organic EL device. Owing to this reason, there are various investigations on a polymer compound which can be suitably used in the above-described composition. As such a polymer compound, for example, a polymer compound containing a 2,7-fluorenediyl group and a 4,4'-benzophenonediyl group is known (WO 2005/40302).

### Disclosure of the Invention

In the case of fabrication of an organic EL device using a composition containing the above-described known polymer compound and a triplet compound, however, the maximum luminous efficiency of the device is not sufficient yet:

Then, the present invention has an object of providing a polymer compound capable of providing a polymer light emitting device showing high maximum luminous efficiency.

In a first aspect, the present invention provides a polymer compound comprising,as repeating units, an optionally substituted fluorenediyl group and a phenylene group having one or more substituents, and comprising a repeating unit of the following formula (1) and/or a group of the following formula (2): 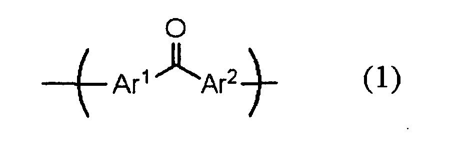 (in the formula (1), Ar¹ and Ar² represent an arylene group or di-valent aromatic heterocyclic group, and Ar¹ and Ar² may be the same or different.) 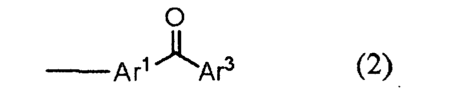 (in the formula (2), Ar¹ represents the same meaning as described above. Ar³ represents an aryl group or mono-valent aromatic heterocyclic group.).

In a second aspect, the present invention provides a composition comprising the above-described polymer compound and a triplet compound.

In a third aspect, the present invention provides a polymer light emitting device comprising the above-described polymer compound or the above-described composition.

### Mode for Carrying Out the Invention

### <Polymer compound>

The polymer compound of the present invention comprises as repeating units an optionally substituted fluorenediyl group and a phenylene group having one or more substituents, and comprises a repeating unit of the above-described formula (1) and/or a group of the above-described formula (2).

### -Fluorenediyl group-

The fluorenediyl group contained as a repeating unit in the polymer compound of the present invention denotes a di-valent group derived by removing two hydrogen atoms from fluorene, and means a group obtained by removing two hydrogen atoms among hydrogen atoms at 1- to 9-positions (preferably, 1- to 8-positions) of fluorene. From the standpoint of easiness of polymerization of the polymer compound, preferable are groups obtained by removing one hydrogen atom among hydrogen atoms at 1- to 4-positions of fluorene and removing one hydrogen atom among hydrogen atoms at 5- to 8-positions of fluorene. The fluorenediyl group optionally has a substituent.

The substituent optionally carried on the above-described fluorenediyl group includes an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group, cyano group or group of the above-described formula (2), and the like. A hydrogen atom contained in these substituents may be substituted by a fluorine atom.

The above-described alkyl group may be any of linear, branched or cyclic, and has a carbon number of usually about 1 to 20, preferably 3 to 20. Examples of the alkyl group include a methyl group, ethyl group, propyl group, i-propyl group, n-butyl group, i-butyl group, s-butyl group, t-butyl group, pentyl group, isoamyl group, hexyl group, cyclohexyl group, heptyl group, octyl group, 2-ethylhexyl group, nonyl group, decyl group, 3,7-dimethyloctyl group, lauryl group, trifluoromethyl group, pentafluoroethyl group, perfluorobutyl group, perfluorohexyl group, perfluorooctyl group and the like, and preferable due to a balance between heat resistance and standpoints of solubility of a polymer compound in an organic solvent, device properties, easiness of synthesis of a polymer compound and the like are a pentyl group, isoamyl group, hexyl group, octyl group, 2-ethylhexyl group, decyl group and 3,7-dimethyloctyl group.

The above-described alkoxy group may be any of linear, branched or cyclic, and has a carbon number of usually about 1 to 20, preferably 3 to 20. Examples of the alkoxy group include a methoxy group, ethoxy group, n-propyloxy group, i-propyloxy group,n-butoxy group, i-butoxy group, s-butoxy group, t-butoxy group, pentyloxy group, hexyloxy group, cyclohexyloxy group, heptyloxy group, octyloxy group, 2-ethylhexyloxy group, nonyloxy group, decyloxy group, 3,7-dimethyloctyloxy group, lauryloxy group, trifluoromethoxy group, pentafluoroethoxy group, perfluorobutoxy group, perfluorohexyloxy group, perfluorooctyloxy group, methoxymethyloxy group, 2-methoxyethyloxy group and the like, and preferable due to a balance between heat resistance and standpoints of solubility of a polymer compound in an organic solvent, device properties, easiness of synthesis of a polymer compound and the like are a pentyloxy group, hexyloxy group, octyloxy group, 2-ethylhexyloxy group, decyloxy group and 3,7-dimethyloctyloxy group.

The above-described alkylthio group may be any of linear, branched or cyclic, and has a carbon number of usually about 1 to 20, preferably 3 to 20. Specific examples of the alkylthio group include a methylthio group, ethylthio group, n-propylthio group, i-propylthio group, butylthio group, i-butylthio group, s-butylthio group, t-butylthio group, pentylthio group, hexylthio group, cyclohexylthio group, heptylthio group, octylthio group, 2-ethylhexylthio group, nonylthio group, decylthio group, 3,7-dimethyloctylthio group, laurylthio group, trifluoromethylthio group and the like, and preferable due to a balance between heat resistance and standpoints of solubility of a polymer compound in an organic solvent, device properties, easiness of synthesis of a polymer compound and the like are a pentylthio group, hexylthio group, octylthio group, 2-ethylhexylthio group, decylthio group and 3,7-dimethyloctylthio group.

The above-described aryl group is an atomic group obtained by removing one hydrogen atom from an aromatic hydrocarbon, and includes atomic groups obtained by removing one hydrogen atom from aromatic hydrocarbons having a benzene ring, aromatic hydrocarbons having a condensed ring, aromatic hydrocarbons having independent two or more benzene rings or condensed rings connected directly or via a group such as vinylene or the like, etc. The aryl group has a carbon number of usually about 6 to 60, preferably 7 to 48. Examples of the aryl group include a phenyl group, C₁ to C₁₂ alkoxyphenyl groups ("C₁ to C₁₂ alkoxy" means that the carbon number of the alkoxy portion is 1 to 12, being applicable also in the following descriptions), C₁ to C₁₂ alkylphenyl groups ("C₁ to C₁₂ alkyl" means that the carbon number of the alkyl portion is 1 to 12, being applicable also in the following descriptions), 1-naphtyl group, 2-naphtyl group, 1-anthracenyl group, 2-anthracenyl group, 9-anthracenyl group, pentafluorophenyl group and the like, and preferable from the standpoint of solubility of a polymer compound in an organic solvent, device properties, easiness of synthesis of a polymer compound and the like are C₁ to C₁₂ alkoxyphenyl groups and C₁ to C₁₂ alkylphenyl groups. Examples of the C₁ to C₁₂ alkoxyphenyl group include a methoxyphenyl group, ethoxyphenyl group, propyloxyphenyl group, i-propyloxyphenyl group, butoxyphenyl group, i-butoxyphenyl group, t-butoxyphenyl group, pentyloxyphenyl group, hexyloxyphenyl group, cyclohexyloxyphenyl group, heptyloxyphenyl group, octyloxyphenyl group, 2-ethylhexyloxyphenyl group, nonyloxyphenyl group, decyloxyphenyl group, 3,7-dimethyloctyloxyphenyl group, lauryloxyphenyl group and the like. Examples of the C₁ to C₁₂ alkylphenyl group are a methylphenyl group, ethylphenyl group, dimethylphenyl group, propylphenyl group, mesityl group, methylethylphenyl group, i-propylphenyl group, butylphenyl group, i-butylphenyl group, t-butylphenyl group, pentylphenyl group, isoamylphenyl group, hexylphenyl group, heptylphenyl group, octylphenyl group, nonylphenyl group, decylphenyl group, dodecylphenyl group and the like.

The above-described aryloxy group has a carbon number of usually about 6 to 60, preferably 7 to 48. Examples of the aryloxy group include a phenoxy group, C₁ to C₁₂ alkoxyphenoxy groups, C₁ to C₁₂ alkylphenoxy groups, 1-naphthyloxy group, 2-naphthyloxy group, pentafluorophenyloxy group and the like, and preferable from the standpoint of solubility of a polymer compound in an organic solvent, device properties, easiness of synthesis of a polymer compound and the like are C₁ to C₁₂ alkoxyphenoxy groups and C₁ to C₁₂ alkylphenoxy groups. Examples of the C₁ to C₁₂ alkoxyphenoxy group include a methoxyphenoxy group, ethoxyphenoxy group, n-propyloxyphenoxy group, i-propyloxyphenoxy group, n-butoxyphenoxy group, i-butoxyphenoxy group, s-butoxyphenoxy group, t-butoxyphenoxy group, pentyloxyphenoxy group, hexyloxyphenoxy group, cyclohexyloxyphenoxy group, heptyloxyphenoxy group, octyloxyphenoxy group, 2-ethylhexyloxyphenoxy group, nonyloxyphenoxy group, decyloxyphenoxy group, 3,7-dimethyloctyloxyphenoxy group, lauryloxyphenoxy group and the like. Examples of the C₁ to C₁₂ alkylphenoxy group include a methylphenoxy group, ethylphenoxy group, dimethylphenoxy group, propylphenoxy group, 1,3,5-trimethylphenoxy group, methylethylphenoxy group, i-propylphenoxy group, butylphenoxy group, i-butylphenoxy group, t-butylphenoxy group, pentylphenoxy group, isoamylphenoxy group, hexylphenoxy group, heptylphenoxy group, octylphenoxy group, nonylphenoxy group, decylphenoxy group, dodecylphenoxy group and the like.

The above-described arylthio group has a carbon number of usually about 6 to 60. Examples of the arylthio group include a phenylthio group, C₁ to C₁₂ alkoxyphenylthio groups, C₁ to C₁₂ alkylphenylthio groups, 1-naphthylthio group, 2-naphthylthio group, pentafluorophenylthio group and the like, and preferable from the standpoint of solubility of a polymer compound in an organic solvent, device properties, easiness of synthesis of a polymer compound and the like are C₁ to C₁₂ alkoxyphenylthio groups and C₁ to C₁₂ alkylphenylthio groups.

The above-described arylalkyl group has a carbon number of usually about 7 to 60, preferably 7 to 48.

Examples of the arylalkyl group include phenyl-C₁ to C₁₂ alkyl groups, C₁ to C₁₂ alkoxyphenyl-C₁ to C₁₂ alkyl groups, C₁ to C₁₂ alkylphenyl-C₁ to C₁₂ alkyl groups, 1-naphthyl C₁ to C₁₂ alkyl groups, 2-naphthyl C₁ to C₁₂ alkyl groups and the like, and preferable from the standpoint of solubility of a polymer compound in an organic solvent, device properties, easiness of synthesis of a polymer compound and the like are C₁ to C₁₂ alkoxyphenyl-C₁ to C₁₂ alkyl groups and C₁ to C₁₂ alkylphenyl-C₁ to C₁₂ alkyl groups.

The above-described arylalkoxy group has a carbon number of usually about 7 to 60, preferably 7 to 48. Examples of the arylalkoxy group include phenyl-C₁ to C₁₂ alkoxy groups such as a phenylmethoxy group, phenylethoxy group, phenylbutoxy group, phenylpentyloxy group, phenylhexyloxy group, phenylheptyloxy group, phenyloctyloxy group and the like, C₁ to C₁₂ alkoxyphenyl-C₁ to C₁₂ alkoxy groups, C₁ to C₁₂ alkylphenyl-C₁ to C₁₂ alkoxy groups, 1-naphthyl C₁ to C₁₂ alkoxy groups, 2-naphthyl C₁ to C₁₂ alkoxy groups and the like, and preferable from the standpoint of solubility of a polymer compound in an organic solvent, device properties, easiness of synthesis of a polymer compound and the like are C₁ to C₁₂ alkoxyphenyl-C₁ to C₁₂ alkoxy groups and C₁ to C₁₂ alkylphenyl-C₁ to C₁₂ alkoxy groups.

The above-described arylalkylthio group has a carbon number of usually about 7 to 60, preferably 7 to 48. Examples of the arylalkylthio group include phenyl-C₁ to C₁₂ alkylthio groups, C₁ to C₁₂ alkoxyphenyl-C₁ to C₁₂ alkylthio groups, C₁ to C₁₂ alkylphenyl-C₁ to C₁₂ alkylthio groups, 1-naphthyl C₁ to C₁₂ alkylthio groups, 2-naphthyl C₁ to C₁₂ alkylthio groups and the like, and preferable from the standpoint of solubility of a polymer compound in an organic solvent, device properties, easiness of synthesis of a polymer compound and the like are C₁ to C₁₂ alkoxyphenyl-C₁ to C₁₂ alkylthio groups and C₁ to C₁₂ alkylphenyl-C₁ to C₁₂ alkylthio groups.

The above-described arylalkenyl group has a carbon number of usually about 8 to 60. Examples of the arylalkenyl group include phenyl-C₂ to C₁₂ alkenyl groups ("C₂ to C₁₂ alkenyl" means that the carbon number of the alkenyl portion is 2 to 12, being applicable also in the following descriptions), C₁ to C₁₂ alkoxyphenyl-C₂ to C₁₂ alkenyl groups, C₁ to C₁₂ alkylphenyl-C₂ to C₁₂ alkenyl groups, 1-naphthyl C₂ to C₁₂ alkenyl groups, 2-naphthyl C₂ to C₁₂ alkenyl groups and the like, and preferable from the standpoint of solubility of a polymer compound in an organic solvent, device properties, easiness of synthesis of a polymer compound and the like are C₁ to C₁₂ alkoxyphenyl-C₂ to C₁₂ alkenyl groups and C₂ to C₁₂ alkylphenyl-C₁ to C₁₂ alkenyl groups.

The above-described arylalkynyl group has a carbon number of usually about 8 to 60. Examples of the arylalkynyl group include phenyl-C₂ to C₁₂ alkynyl groups ("C₂ to C₁₂ alkynyl" means that the carbon number of the alkynyl portion is 2 to 12, being applicable also in the following descriptions), C₁ to C₁₂ alkoxyphenyl-C₂ to C₁₂ alkynyl groups, C₁ to C₁₂ alkylphenyl-C₂ to C₁₂ alkynyl groups, 1-naphthyl C₂ to C₁₂ alkynyl groups, 2-naphthyl C₂ to C₁₂ alkynyl groups and the like, and preferable from the standpoint of solubility of a polymer compound in an organic solvent, device properties, easiness of synthesis of a polymer compound and the like are C₁ to C₁₂ alkoxyphenyl-C₂ to C₁₂ alkynyl groups and C₁ to C₁₂ alkylphenyl-C₂ to C₁₂ alkynyl groups.

The above-described substituted amino group includes amino groups substituted with one or two groups selected from alkyl groups, aryl groups, arylalkyl groups and monovalent heterocyclic groups. These alkyl groups, aryl groups, arylalkyl groups and monovalent heterocyclic groups optionally have a substituent. The carbon number of the substituted amino group is usually about 1 to 60, preferably 2 to 48, not including the carbon number of the substituent. Examples of the substituted amino group include a methylamino group, dimethylamino group, ethylamino group, diethylamino group, propylamino group, dipropylamino group, i-propylamino group, diisopropylamino group, butylamino group, i-butylamino group, t-butylamino group, pentylamino group, hexylamino group, cyclohexylamino group, heptylamino group, octylamino group, 2-ethylhexylamino group, nonylamino group, decylamino group, 3,7-dimethyloctylamino group, laurylamino group, cyclopentylamino group, dicyclopentylamino group, cyclohexylamino group, dicyclohexylamino group, pyrrolidyl group, piperidyl group, ditrifluoromethylamino group , phenylamino group, diphenylamino group, C₁ to C₁₂ alkoxyphenylamino groups, di (C₁ to C₁₂ alkoxyphenyl)amino groups, di(C₁ to C₁₂ alkylphenyl)amino groups, 1-naphthylamino group, 2-naphthylamino group, pentafluorophenylamino group, pyridylamino group, pyridazinylamino group, pyrimidylamino group, pyrazylamino group, triazylamino group, phenyl-C₁ to C₁₂ alkylamino groups, C₁ to C₁₂ alkoxyphenyl-C₁ to C₁₂ alkylamino groups, C₁ to C₁₂ alkylphenyl-C₁ to C₁₂ alkylamino groups, di(C₁ to C₁₂ alkoxyphenyl-C₁ to C₁₂ alkyl)amino groups, di(C₁ to C₁₂ alkylphenyl-C₁ to C₁₂ alkyl)amino groups, 1-naphthyl C₁ to C₁₂ alkylamino groups, 2-naphthyl C₁ to C₁₂ alkylamino groups and the like.

The above-described substituted silyl group includes silyl groups substituted with one, two or three groups selected from alkyl groups, aryl groups, arylalkyl groups and monovalent heterocyclic groups. The carbon number of the substituted silyl group is usually about 1 to 60, preferably 3 to 48. These alkyl groups, aryl groups, arylalkyl groups and monovalent heterocyclic groups optionally have a substituent. Examples of the substituted silyl group include a trimethylsilyl group, triethylsilyl group, tripropylsilyl group, tri-i-propylsilyl group, dimethyl-i-propylisilyl group, diethyl-i-propylsilyl group, t-butylsilyldimethylsilyl group, pentyldimethylsilyl group, hexyldimethylsilyl group, heptyldimethylsilyl group, octyldimethylsilyl group, 2-ethylhexyldimethylsilyl group, nonyldimethylsilyl group, decyldimethylsilyl group, 3,7-dimethyloctyl-dimethylsilyl group, lauryldimethylsilyl group, phenyl-C₁ to C₁₂ alkylsilyl groups, C₁ to C₁₂ alkoxyphenyl-C₁ to C₁₂ alkylsilyl groups, C₁ to C₁₂ alkylphenyl-C₁ to C₁₂ alkylsilyl groups, 1-naphthyl C₁ to C₁₂ alkylsilyl groups, 2-naphthyl C₁ to C₁₂ alkylsilyl groups, phenyl-C₁ to C₁₂ alkyldimethylsilyl groups, triphenylsilyl group, tri-p-xylylsilyl group, tribenzylsilyl group, diphenylmethylsilyl group, t-butyldiphenylsilyl group, dimethylphenylsilyl group and the like.

Examples of the above-described halogen atom include a fluorine atom, chlorine atom, bromine atom and iodine atom.

The above-described acyl group has a carbon number of usually about 2 to 20, preferably 2 to 18. Examples of the acyl group include an acetyl group, propionyl group, butylyl group, isobutylyl group, pivaloyl group, benzoyl group, trifluoroacetyl group, pentafluorobenzoyl group and the like.

The above-described acyloxy group has a carbon number of usually about 2 to 20, preferably 2 to 18.

Examples of the acyloxy group include an acetoxy group, propionyloxy group, butylyloxy group, isobutylyloxy group, pivaloyloxy group, benzoyloxy group, trifluoroacetyloxy group, pentafluorobenzoyloxy group and the like.

The above-described imine residue includes residues obtained by removing one hydrogen atom from imine compounds (namely, meaning organic compounds having -N=C- in the molecule. Examples thereof include aldimines, ketimines, and compounds obtained by substituting a hydrogen atom on N in these compounds by an alkyl group or the like). The imine residue has a carbon number of usually about 2 to 20, preferably 2 to 18. Examples of the imine residue include groups of the following structural formulae, and the like. 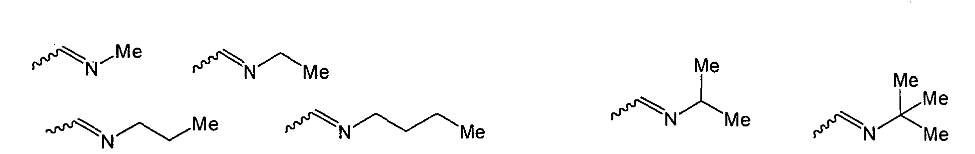 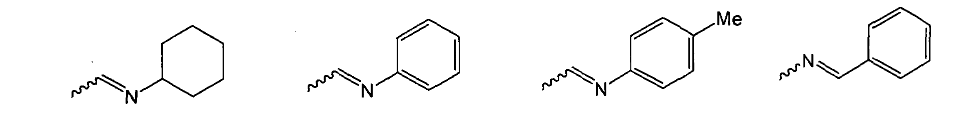 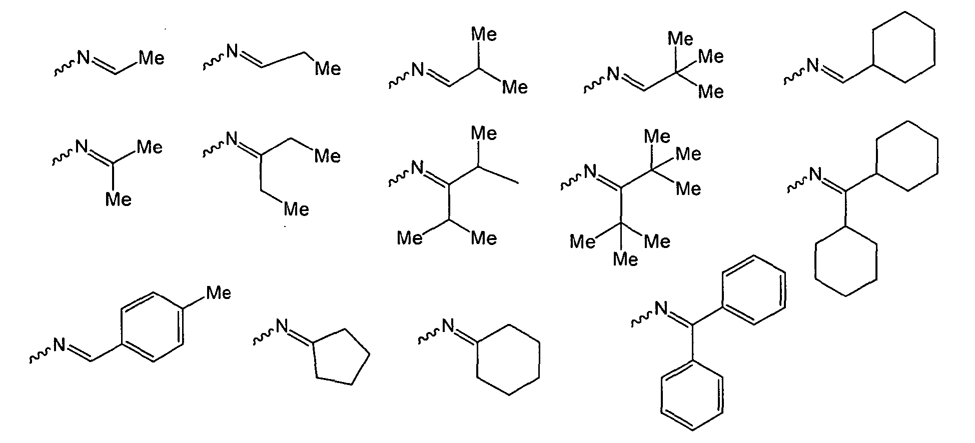 (in the formulae, Me represents a methyl group. The wavy line represents a connecting bond, and means a possibility of a geometric isomer such as a cis isomer, trans isomer or the like depending on the kind of the imine residue.).

The above-described amide group has a carbon number of usually about 2 to 20, preferably 2 to 18. Examples of the amide group include a formamide group, acetamide group, propioamide group, butyroamide group, benzamide group, trifluoroacetamide group, pentafluorobenzamide group, diformamide group, diacetamide group, dipropioamide group, dibutyroamide group, dibenzamide group, ditrifluoroacetamide group, dipentafluorobenzamide group and the like.

As the above-described acid imide group, there are mentioned residues obtained by removing one hydrogen atom bonded to its nitrogen atom from an acid imide, and the carbon number thereof is usually about 4 to 20. Examples of the acid imide group include the following groups, and the like.

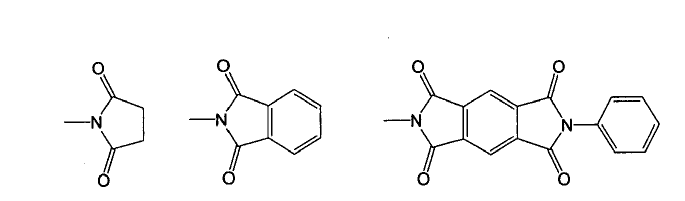

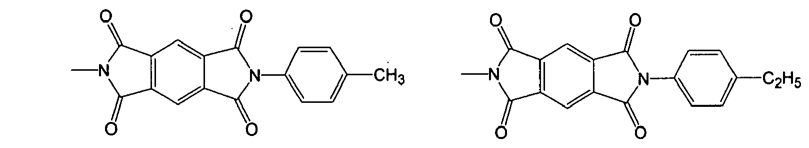

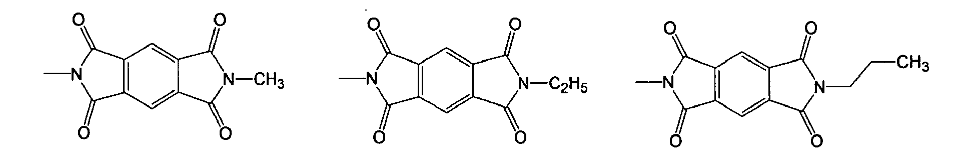

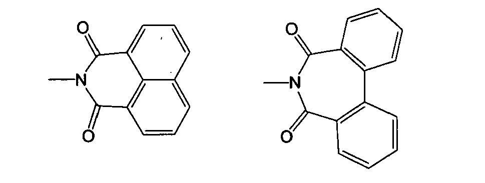

The above-described monovalent heterocyclic group refers to an atomic group remaining after removing one hydrogen atom from a heterocyclic compound. The carbon number of the monovalent heterocyclic group is usually about 4 to 60, preferably 4 to 20. The carbon number of the monovalent heterocyclic group does not include the carbon number of the substituent. The above-described heterocyclic compound refers to organic compounds having a cyclic structure in which elements constituting the ring include not only a carbon atom, but also a hetero atom such as oxygen, sulfur, nitrogen, phosphorus, boron, silicon and the like contained in the ring. Of monovalent heterocyclic groups, monovalent aromatic heterocyclic groups are preferable.

Examples of the monovalent heterocyclic group include a thienyl group, C₁ to C₁₂ alkylthienyl groups, pyrrolyl group, furyl group, pyridyl group, C₁ to C₁₂ alkylpyridyl groups, piperidyl group, quinolyl group, isoquinolyl group and the like, and preferable are a thienyl group, C₁ to C₁₂ alkylthienyl groups, pyridyl group and C₁ to C₁₂ alkylpyridyl groups.

The above-described substituted carboxyl group includes carboxyl groups substituted with an alkyl group, aryl group, arylalkyl group or monovalent heterocyclic group. The above-described alkyl group, aryl group, arylalkyl group or monovalent heterocyclic group optionally has a substituent. The carbon number of the substituted carboxyl group is usually about 2 to 60, preferably 2 to 48. Examples of the substituted carboxyl group include a methoxycarbonyl group, ethoxycarbonyl group, propoxycarbonyl group, i-propoxycarbonyl group, butoxycarbonyl group, i-butoxycarbonyl group, t-butoxycarbonyl group, pentyloxycarbonyl group, hexyloxycarbonyl group, cyclohexyloxycarbonyl group, heptyloxycarbonyl group, octyloxycarbonyl group, 2-ethylhexyloxycarbonyl group, nonyloxycarbonyl group, decyloxycarbonyl group, 3,7-dimethyloctyloxycarbonyl group, dodecyloxycarbonyl group, trifluoromethoxycarbonyl group, pentafluoroethoxycarbonyl group, perfluorobutoxycarbonyl group, perfluorohexyloxycarbonyl group, perfluorooctyloxycarbonyl group, phenoxycarbonyl group, naphthoxycarbonyl group, pyridyloxycarbonyl group and the like. These groups optionally further have a substituent. The carbon number of the substituted carboxyl group does not include the carbon number of the substituent.

The optionally substituted fluorenediyl group includes groups of the following formula (3). 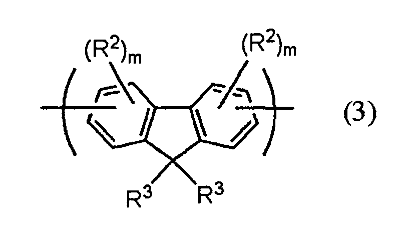 (in the formula (3), R² represents a substituent, R³ represents an alkyl group, alkoxy group, aryl group or mono-valent heterocyclic group, and m's represent independently an integer of 0 to 3. When there exist a plurality of R²'s, they may be the same or different. A plurality of R³'s may be the same or different.).

In the above-described formula (3), m's represent independently an integer of 0 to 3, and it is preferable from the standpoint of easiness of synthesis of a polymer compound that m represents 0 or 1, and it is more preferable that both m's are 0 or both m's are 1. The substituent represented by R² includes an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group, cyano group and the like, and as examples of these groups, the same groups as exemplified for the substituent on the fluorenediyl group described above are mentioned.

Of these substituents, preferable from the standpoint of solubility of a polymer compound in an organic solvent and easiness of synthesis of a polymer compound are an alkyl group, alkoxy group, alkylthio group, aryl group, aryloxy group, arylthio group, arylalkyl group, arylalkoxy group and mono-valent heterocyclic group, and more preferable are an alkyl group, alkoxy group, aryl group and mono-valent heterocyclic group.

In the above-described formula (3), if R³ is an aryl group, it is preferable from the standpoint of easiness of synthesis of a polymer compound, device properties and the like that R³ represents a phenyl group, C₁ to C₁₂ alkoxyphenyl group, C₁ to C₁₂ alkylphenyl group, 1-naphthyl group, 2-naphthyl group, 1-anthracenyl group, 2-anthracenyl group, 9-anthracenyl group or pentafluorophenyl group, and it is more preferable that R³ represents a C₁ to C₁₂ alkoxyphenyl group or C₁ to C₁₂ alkylphenyl group. If R³ is a mono-valent heterocyclic group, it is preferable from the standpoint of easiness of synthesis of a polymer compound, device properties and the like that R³ represents a thienyl group, pyrrolyl group, furyl group, pyridyl group, piperidyl group, quinolyl group, isoquinolyl group or the like.

From the standpoint of device properties and the like, it is preferable that R³ represents an alkyl group or aryl group.

As the group of the above-described formula (3), preferable from the standpoint of easiness of synthesis of a polymer compound, device properties and the like are groups of the following formula (3-1): 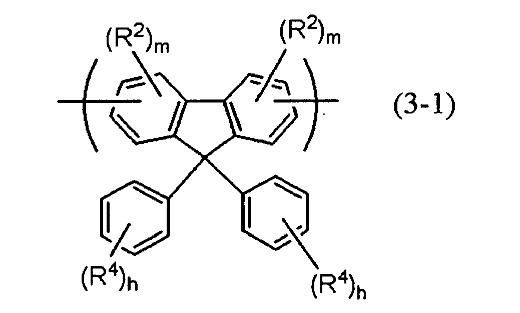 (in the formula (3-1), R² and m represent the same meanings as described above, R⁴ represents a substituent, and h represents an integer of 0 to 5. When there exist a plurality of R²'s and R⁴'s, they each may be the same or different. A plurality of m's and h's each may be the same or different.).

The substituent represented by R⁴ includes an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group, cyano group and the like. A hydrogen atom contained in these substituents may be substituted by a fluorine atom or other groups. Among these substituents, preferable from the standpoint of solubility of a polymer compound in an organic solvent and easiness of synthesis of a polymer compound are an alkyl group, alkoxy group, alkylthio group, aryl group, aryloxy group, arylthio group, arylalkyl group, arylalkoxy group and mono-valent heterocyclic group, and more preferably are an alkyl group, alkoxy group, aryl group and mono-valent heterocyclic group. Among these substituents, preferable from the standpoint of device properties are an unsubstituted or substituted alkyl group, unsubstituted or substituted alkoxy group (the carbon number is usually 1 to 12, preferably 5 to 8) and substituted carboxyl group. The substituent represented by R⁴ is the same as explained and exemplified for the substituent of the fluorenediyl group described above.

When R⁴ is an unsubstituted or substituted alkoxy group, preferable from the standpoint of device properties are groups of the following formula (a):

*-O-(CH₂)ₙ₁CH₃ (a)

(in the formula (a), n1 represents and integer of 0 to 9. A hydrogen atom in the formula may be substituted by an alkyl group having 1 to 5 carbon atoms. A position of * is connected to a benzene ring in the above-described formula (3-1).) or the following formula (b):

*-O-(CH₂)ₙ₂-O-(CH₂)ₙ₃CH₃ (b)

(in the formula (b), n2 represents and integer of 1 to 10, n3 represents and integer of 1 to 9. A hydrogen atom in the formula may be substituted by an alkyl group having 1 to 5 carbon atoms. A position of * is connected to a benzene ring in the above-described formula (3-1).).

From the standpoint of heat resistance of a polymer compound, h is prefeably an integer of 1 to 5.

As the group of the above-described formula (3-1), more preferable are groups of the following formula (3-2): 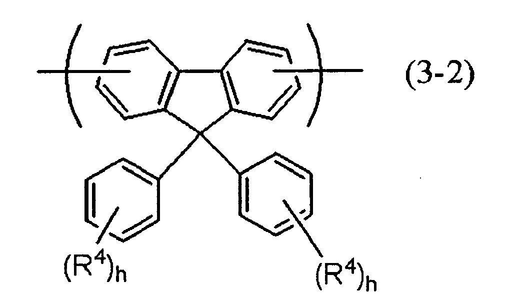 (in the formula (3-2), R⁴ and h represent each independently the same meanings as described above. When there exist a plurality of R⁴'s, they each may be the same or different. A plurality of h's may be the same or different.) or the following formula (3-3): 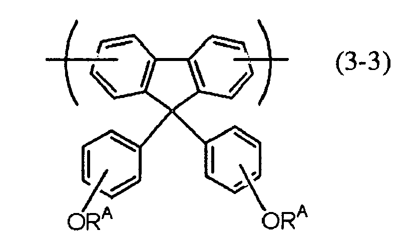 (in the formula (3-3), R^{A} represents an alkyl group. A plurality of R^{A}'s may be the same or different.).

### --Phenylene group having one or more substituents--

The phenylene group contained as a repeating unit in the polymer compound of the present invention includes an o-phenylene group, m-phenylene group and p-phenylene group, and a p-phenylene group is preferable from the standpoint of easiness of polymerization of a polymer compound. The phenylene group used in the polymer compound of the present invention has one or more substituents.

The substituent to be carried on the phenylene group includes an alkyl group, alkoxy group, alkylthio group, aryl group, aryloxy group, arylthio group, arylalkyl group, arylalkoxy group, arylalkylthio group, arylalkenyl group, arylalkynyl group, mono-valet heterocyclic group, or a group of the above-described formula (2) and the like. A hydrogen atom contained in these substituents may be substituted by a fluorine atom.

The phenylene group having one or more substituents includes groups of the following formula (4). 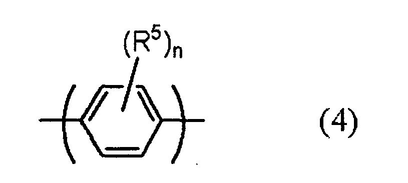 (in the formula (4), R⁵ represents an alkyl group, alkoxy group, alkylthio group, aryl group, aryloxy group, arylthio group, arylalkyl group, arylalkoxy group, arylalkylthio group, arylalkenyl group, arylalkynyl group or mono-valent heterocyclic group. n represents an integer of 1 to 4. When there exist a plurality of R⁵'s, they may be the same or different.).

As R⁵ in the above-described formula (4), preferable from the standpoint of solubility of a polymer compound in an organic solvent and easiness of synthesis of a polymer compound are an alkyl group, alkoxy group, alkylthio group, aryl group, aryloxy group, arylthio group, arylalkyl group, arylalkoxy group and mono-valent heterocyclic group, and more preferable are an alkyl group, alkoxy group, aryl group and mono-valent heterocyclic group.

Here, explanations of the alkyl group, alkoxy group, alkylthio group, aryl group, aryloxy group, arylthio group, arylalkyl group, arylalkoxy group, arylalkylthio group, arylalkenyl group, arylalkynyl group and mono-valent heterocyclic group are the same as explained and exemplified for the substituent on the fluorenediyl group described above.

In the above-described formula (4), n represents an integer of 1 to 4, and from the standpoint of easiness of synthesis of a polymer compound, n represents preferably 1 or 2. When there exist a plurality of R⁴s, they may be the same or different.

Examples of the group of the above-described formula (4) include the following groups.

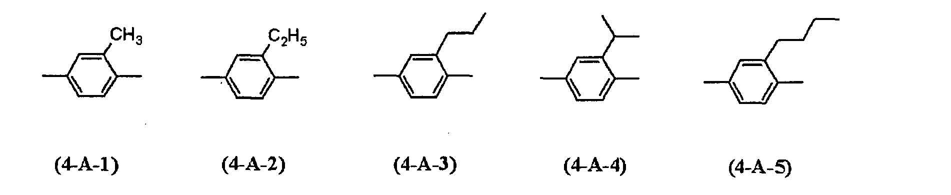

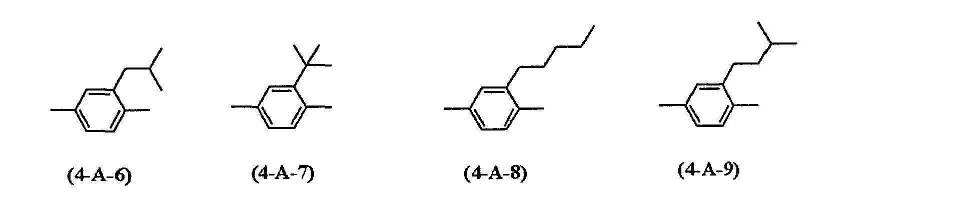

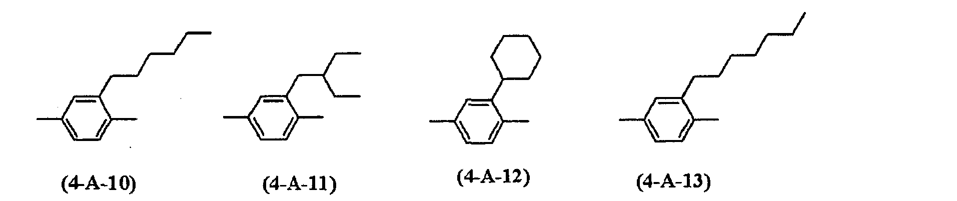

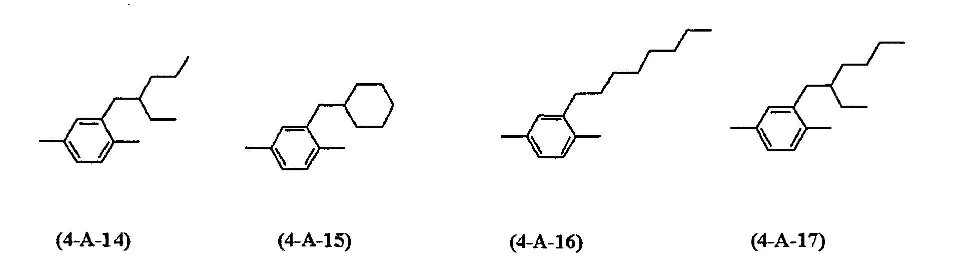

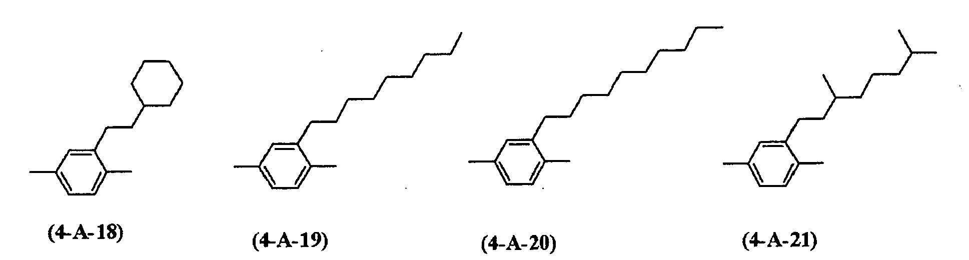

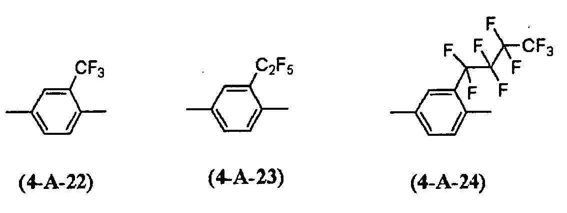

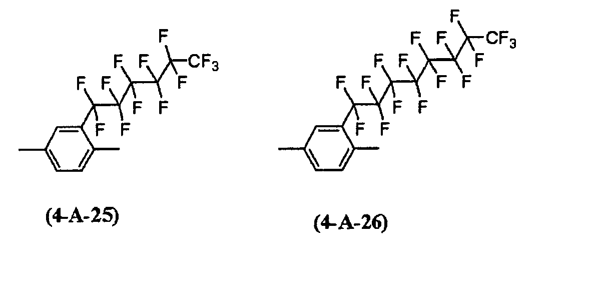

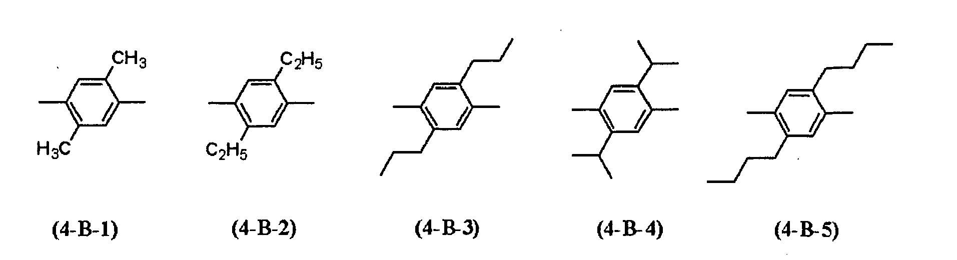

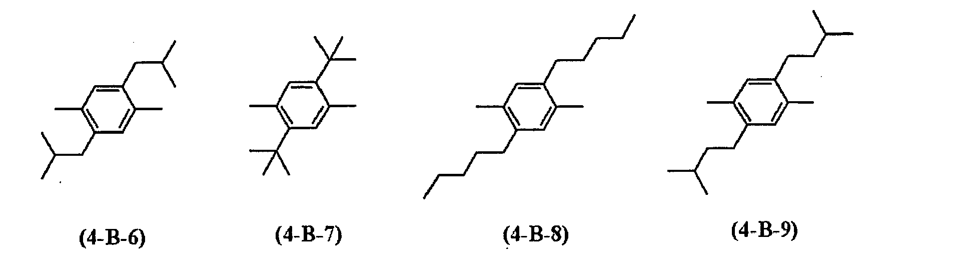

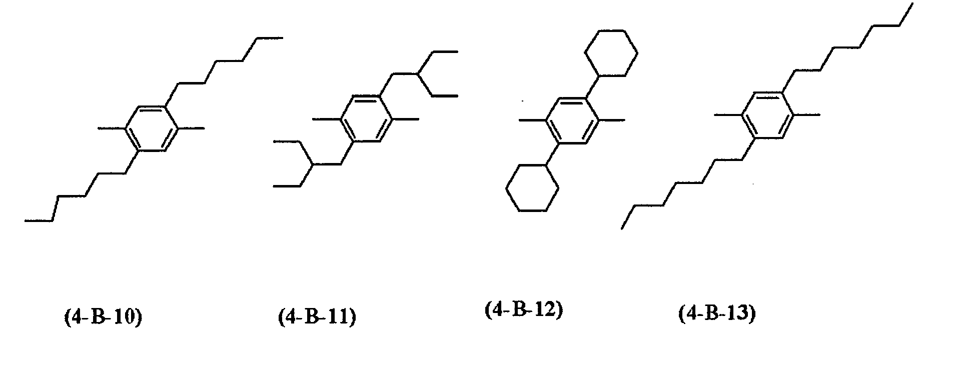

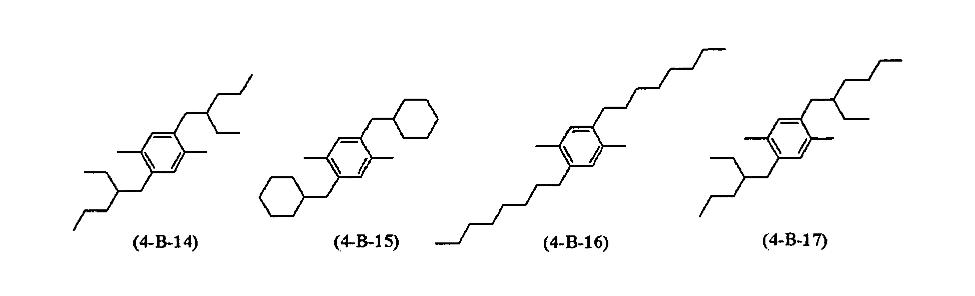

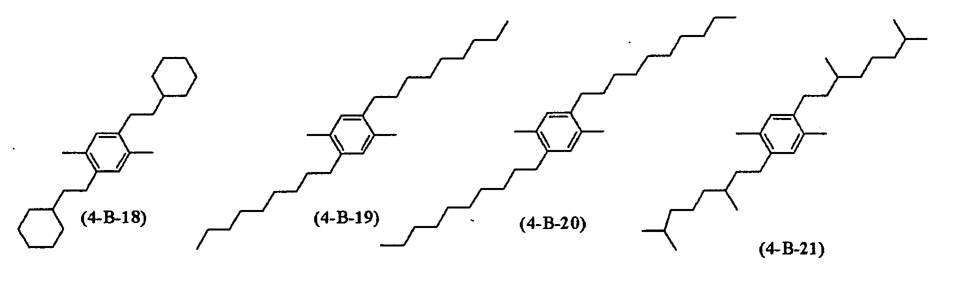

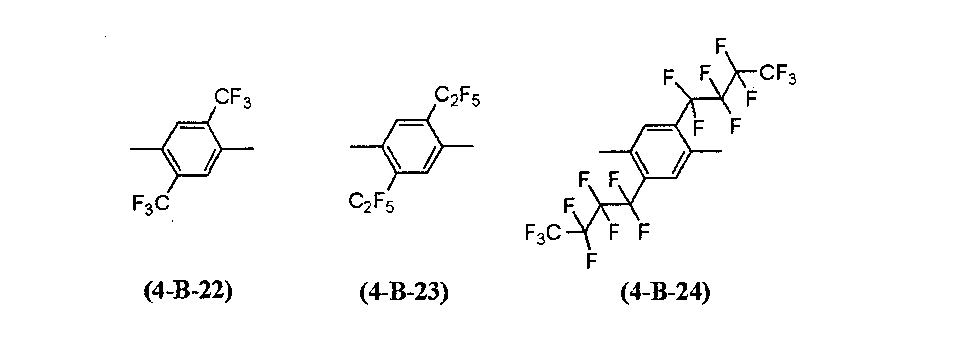

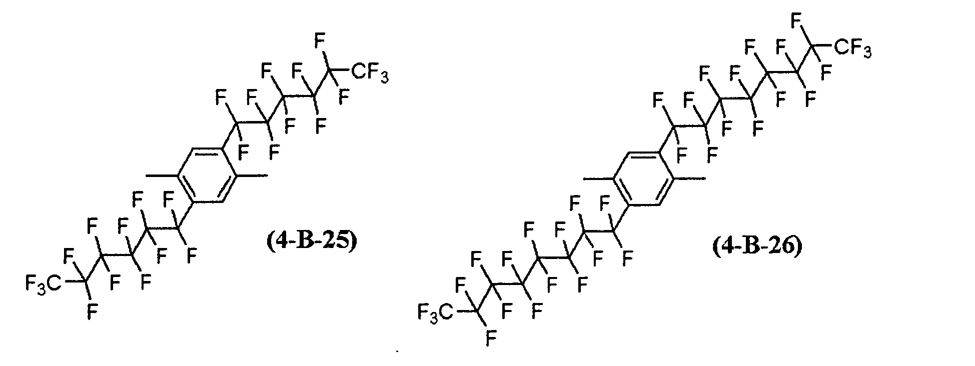

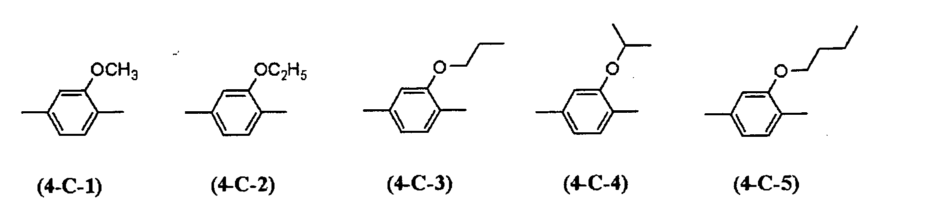

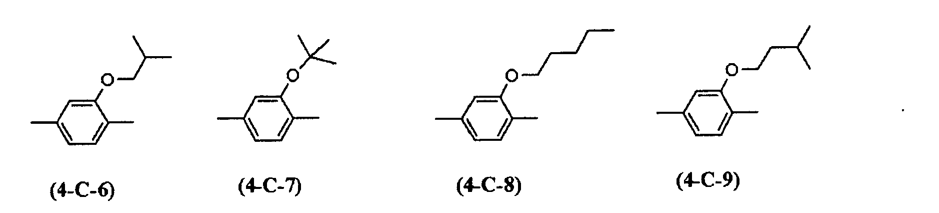

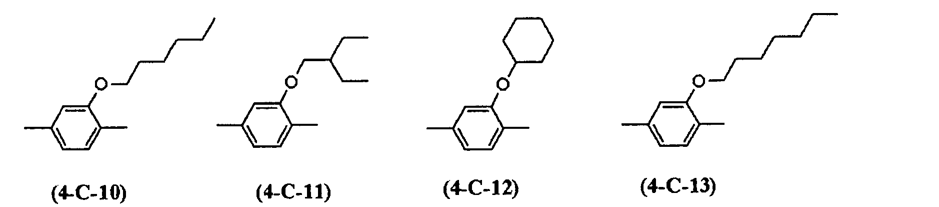

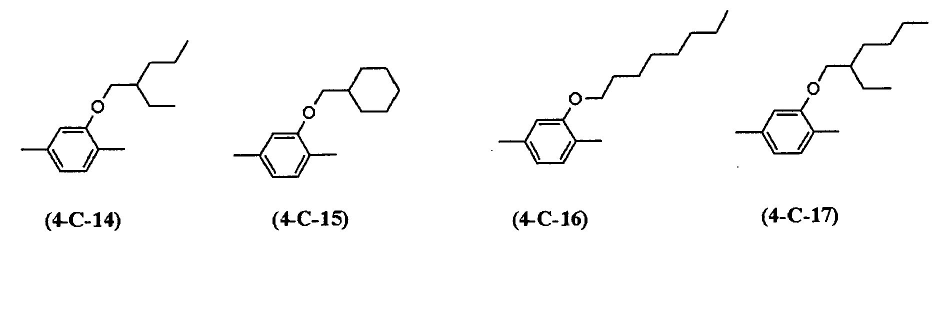

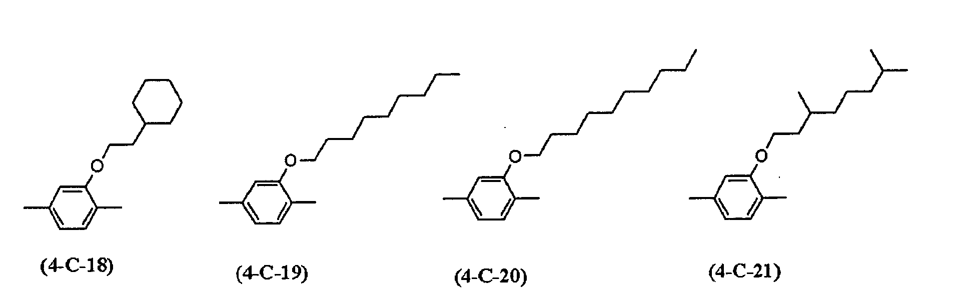

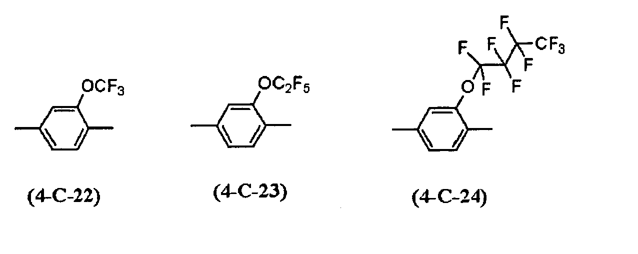

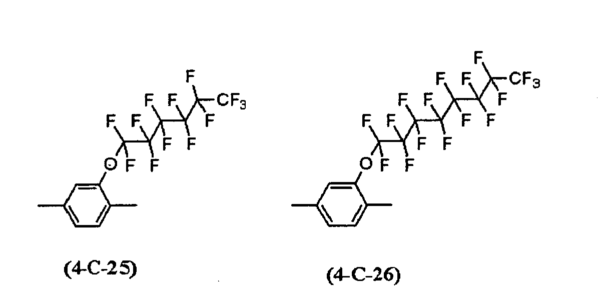

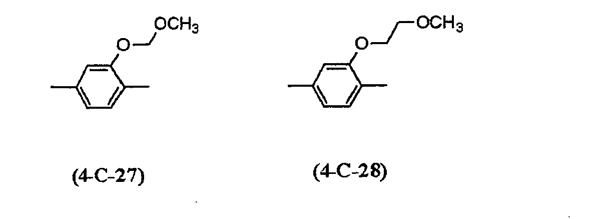

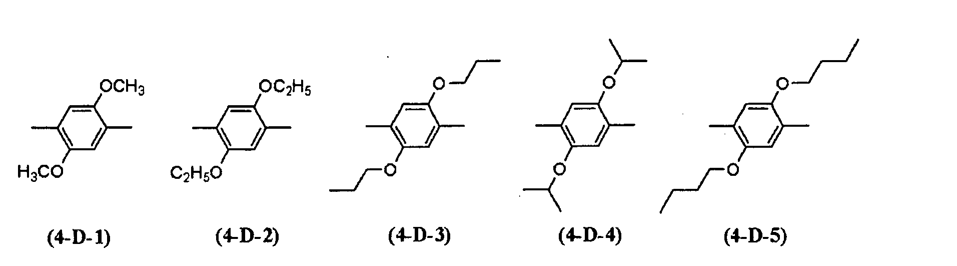

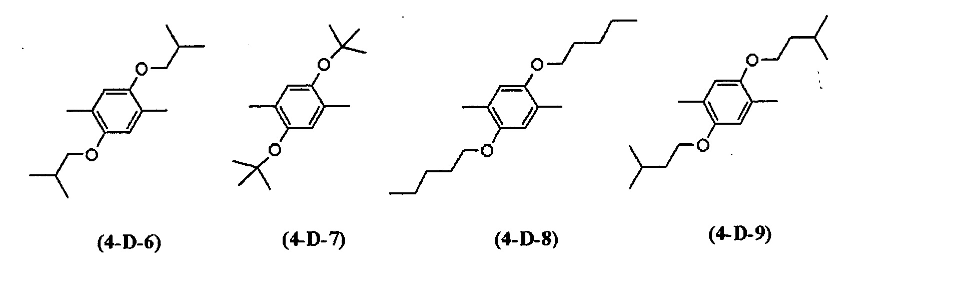

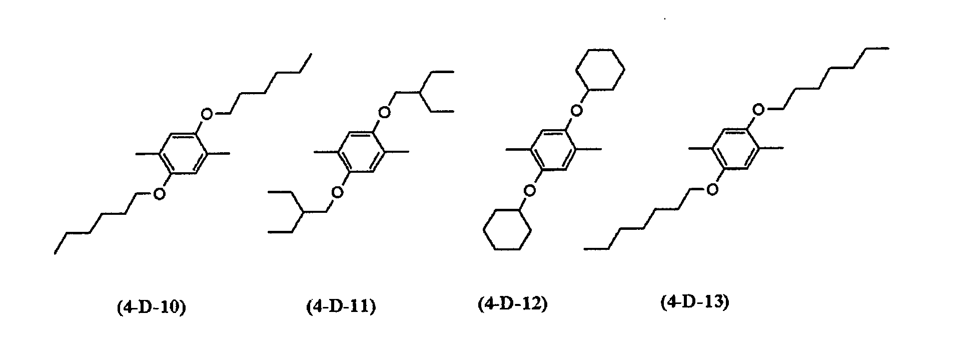

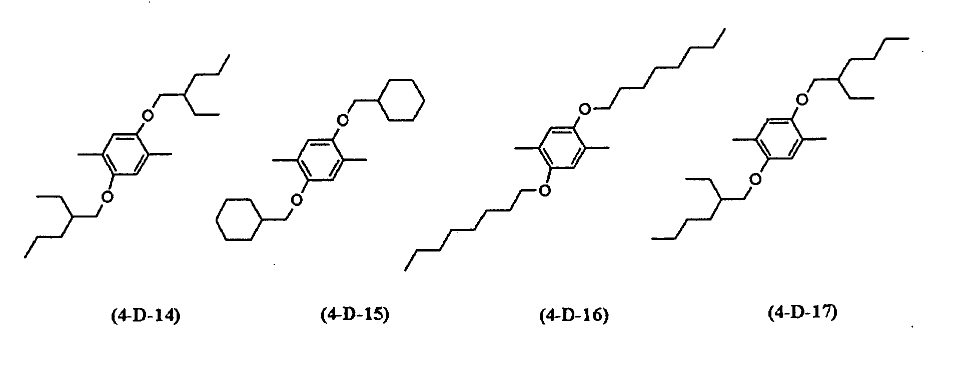

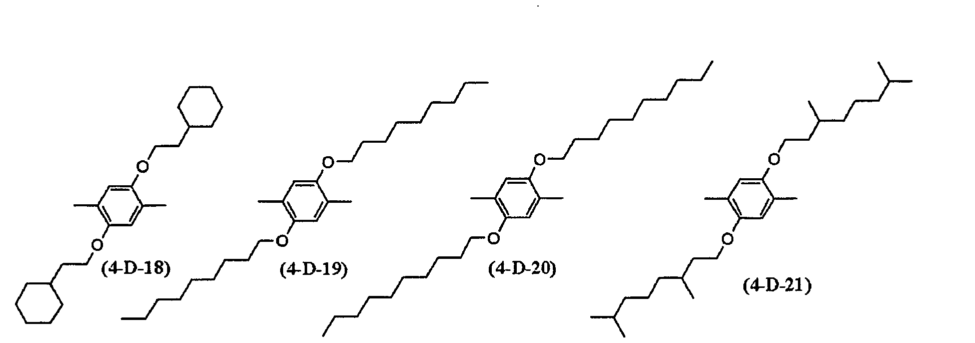

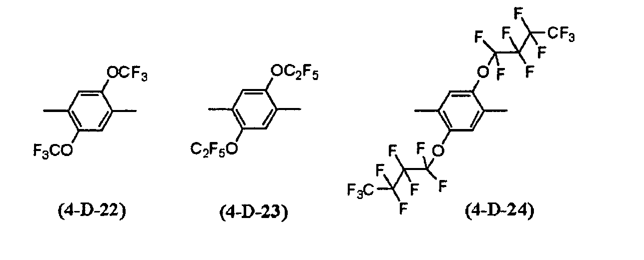

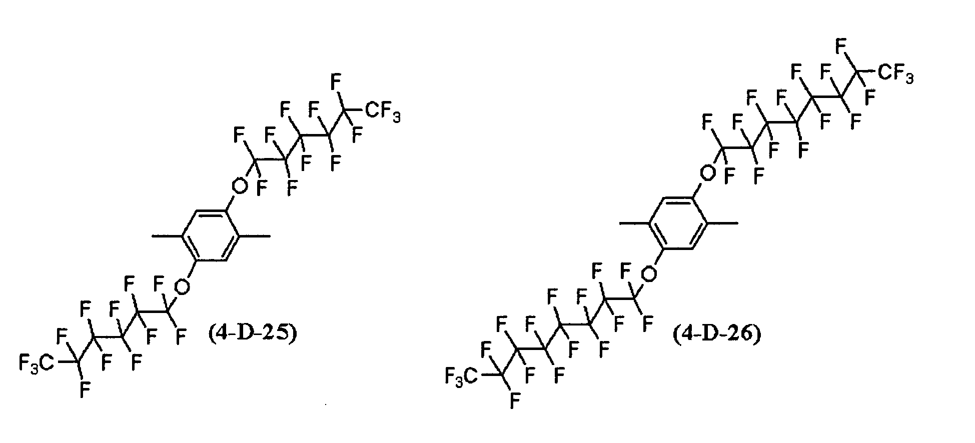

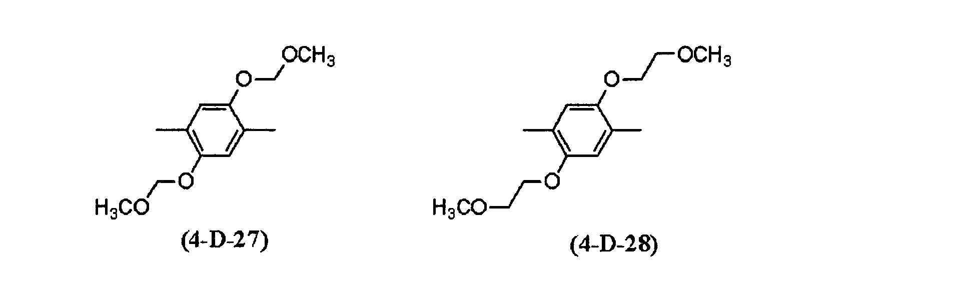

The polymer compound of the present invention is **characterized in that** it comprises,as repeating units, an optionally substituted fluorenediyl group and a phenylene group having one or more substituents, and comprises a repeating unit of the above-described formula (1) and/or a group of the above-described formula (2). In the above-described formula (1), Ar¹ and Ar² represent an arylene group or di-valent aromatic heterocyclic group, and Ar¹ and Ar² may be the same or different.

Here, the arylene group means an atomic group obtained by removing two hydrogen atoms from an aromatic hydrocarbon, and includes atomic groups obtained by removing two hydrogen atoms from those having an independent benzene ring or condensed ring. The arylene group has a carbon number of usually about 6 to 60, preferably 6 to 48, more preferably 6 to 30, preferably 6 to 18, more preferably 6 to 10, preferably 6. These carbon numbers do not include the carbon number of the substituent. Examples of the arylene group include a 1,4-phenylene group, 1,3-phenylene group, 1,2-phenylene group, 1,4-naphthalenediyl group, 1,5-naphthalenediyl group, 2,6-naphthalenediyl group, 1,4-anthracenediyl group, 1,5-anthracenediyl group, 2,6-anthracenediyl group, 9,10-anthracenediyl group, 2,7-phenanthrenediyl group, 1,7-naphthacenediyl group, 2,8-naphthacenediyl group and the like, preferably a 1,4-phenylene group, 1,3-phenylene group, 1,2-phenylene group, 1,5-naphthalenediyl group, 2,6-naphthalenediyl group, 1,4-anthracenediyl group, 1,5-anthracenediyl group, 2,6-anthracenediyl group, 9,10-anthracenediyl group, more preferably a 1,4-phenylene group, 1,3-phenylene group, 1,2-phenylene group, 1,5-naphthalenediyl group, 2,6-naphthalenediyl group, preferably a 1,4-phenylene group, 1,3-phenylene group, 1,2-phenylene group, and more preferably a 1,4-phenylene group.

The di-valent aromatic heterocyclic group means an atomic group remaining after removal of two hydrogen atoms from an aromatic heterocyclic compound, and has a carbon number of usually about 4 to 60, preferably 4 to 20, more preferably 4 to 9, further preferably 4 to 5. Examples of the di-valent aromatic heterocyclic group include a 2,5-thiophenediyl group, N-methyl-2,5-pyrrolediyl group, 2,5-furanediyl group, 2,5-pyridinediyl group, 2,6-pyridinediyl group, 2,4-quinolinediyl group, 2,6-quinolinediyl group, 1,4-isoquinolinediyl group, 1,5-isoquinolinediyl group and the like, preferably a 2,5-thiophenediyl group, 2,5-pyridinediyl group, 2,6-pyridinediyl group, 2,4-quinolinediyl group, 2,6-quinolinediyl group, 1,4-isoquinolinediyl group, 1,5-isoquinolinediyl group, more preferably a 2,5-thiophenediyl group, 2,5-pyridinediyl group, 2,6-pyridinediyl group, further preferably a 2,5-pyridinediyl group, 2,6-pyridinediyl group. When Ar¹ and Ar² have a substituent, it is preferable from the standpoint of solubility in an organic solvent, device properties, easiness of synthesis of a polymer compound and the like that the substituent is selected from an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group and cyano group. The substituent is selected, more preferably from an alkyl group, alkoxy group, aryl group, aryloxy group, arylalkyl group, arylalkoxy group, substituted amino group, substituted silyl group, acyl group, substituted carboxyl group and cyano group, still preferably from an alkyl group, alkoxy group, aryl group, aryloxy group, arylalkyl group and arylalkoxy group, further preferably from an alkyl group, alkoxy group, aryl group, particularly preferably an alkyl group.

As the repeating unit of the above-described formula (1), preferable are repeating units of the following formula (1-1). 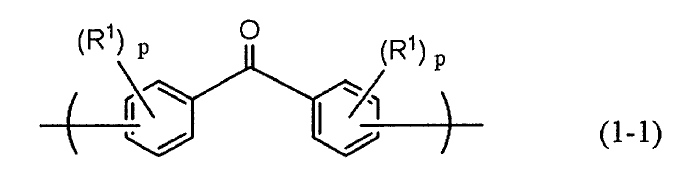 (in the formula (1-1), R¹ represents an alkyl group, alkoxy group, alkylthio group, aryl group, aryloxy group, arylthio group, arylalkyl group, arylalkoxy group, arylalkylthio group, arylalkenyl group, arylalkynyl group, amino group or mono-valent heterocyclic group. p's represent independently an integer of 0 to 4. When there exist a plurality of R¹'s, they may be the same or different.).

As the repeating unit of the above-described formula (1-1), preferable are repeating units of the following formula (1-2).

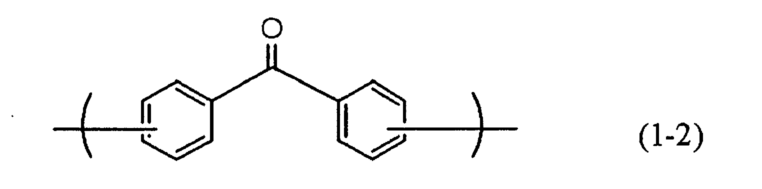

The repeating unit of the above-described formula (1) includes residual groups obtained by removing two hydrogen atoms from the following compounds (formulae A, B, C, D, E, F, G, H, I, J, K, L, M, N, O, P, Q, S, T, U, V and W), and residual groups obtained by removing two hydrogen atoms from the following compounds and further in which one or mo hydrogen atoms,are substituted by a substituent such as an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group and cyano group and the like.

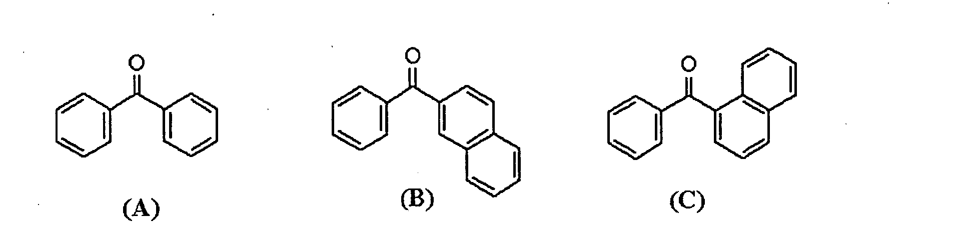

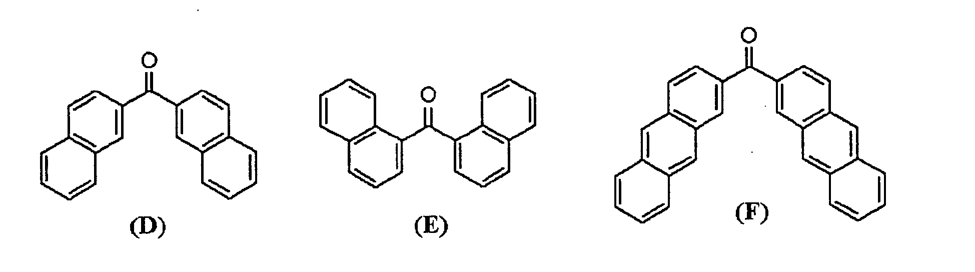

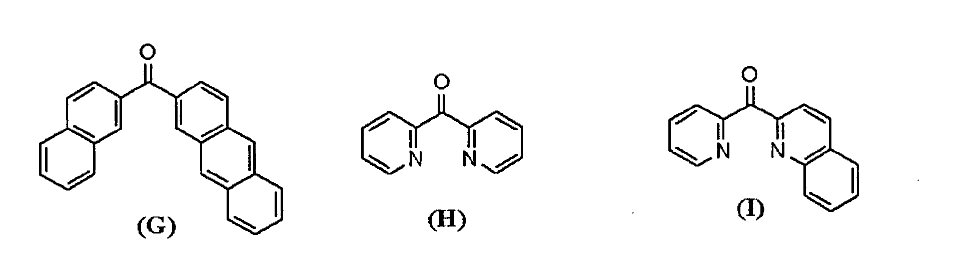

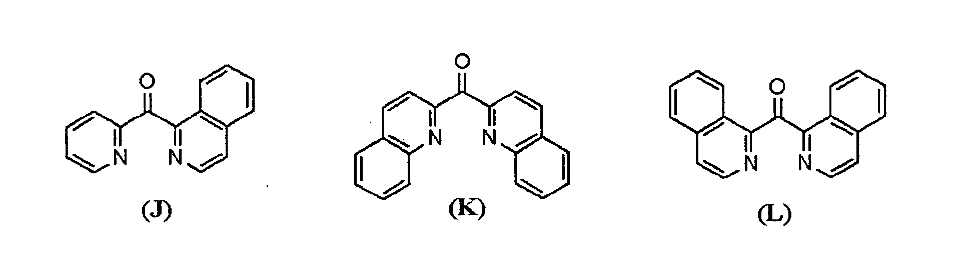

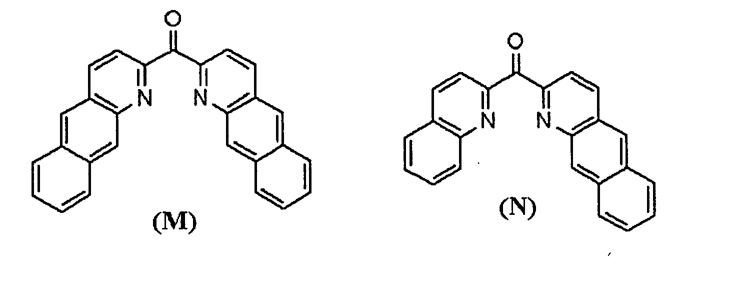

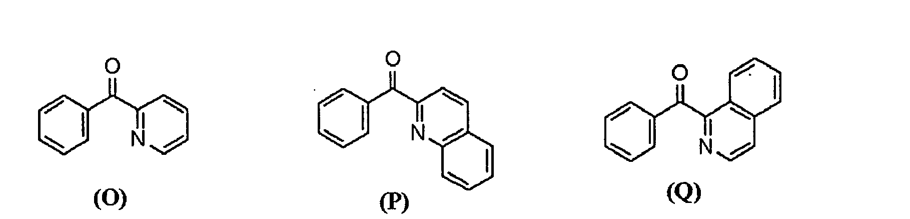

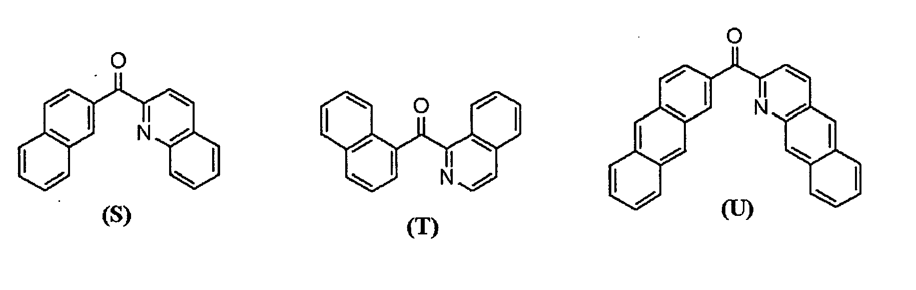

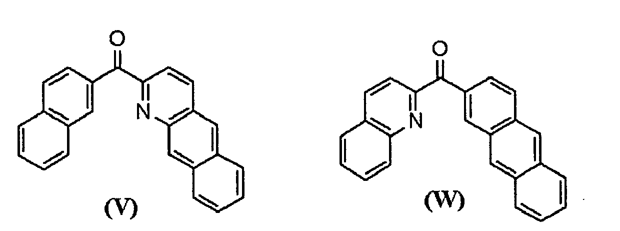

As examples of the above-described formula (1), the following repeating units are mentioned.

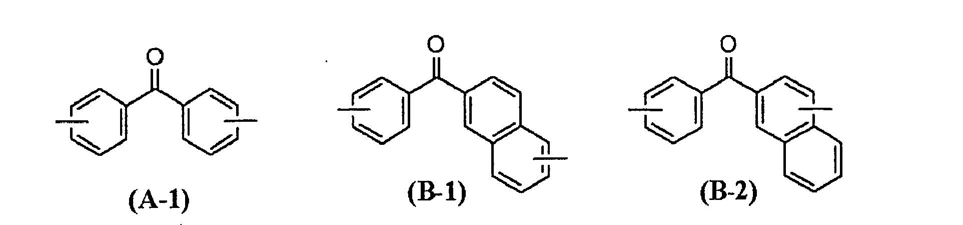

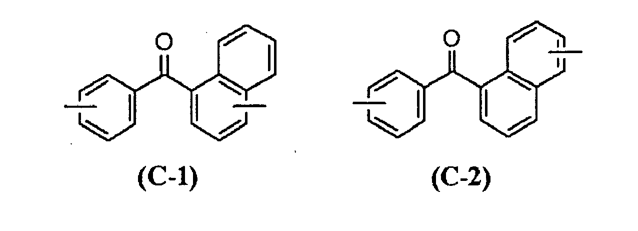

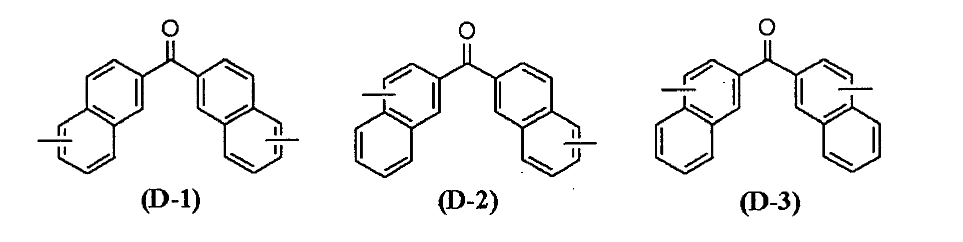

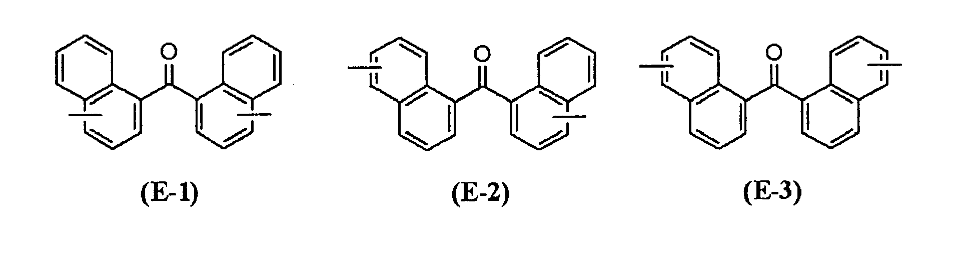

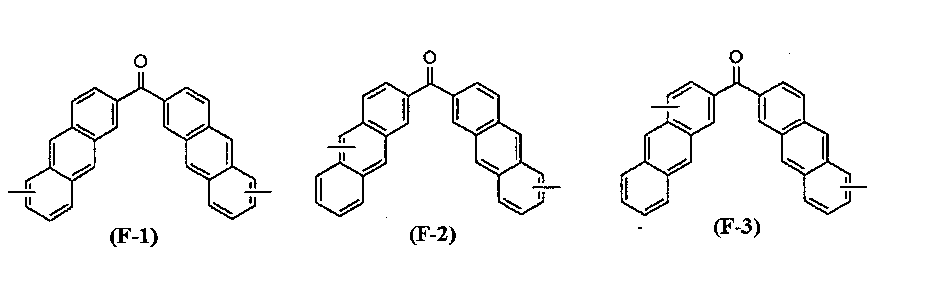

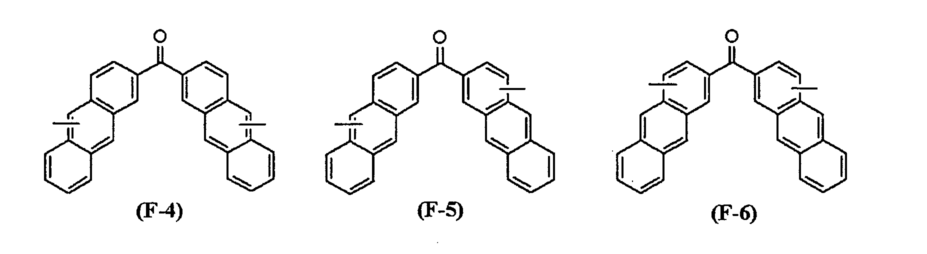

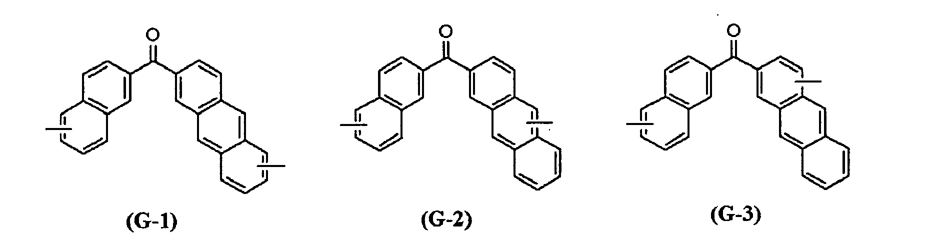

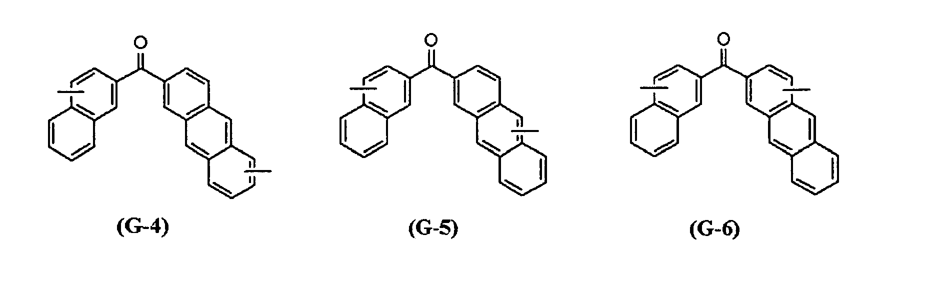

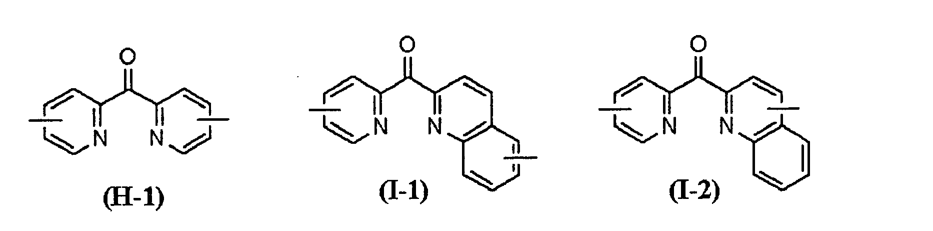

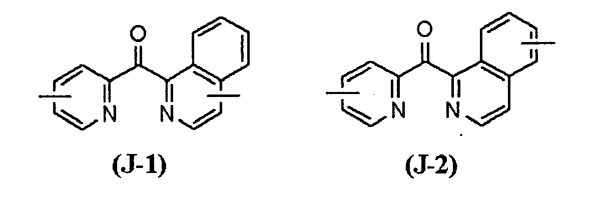

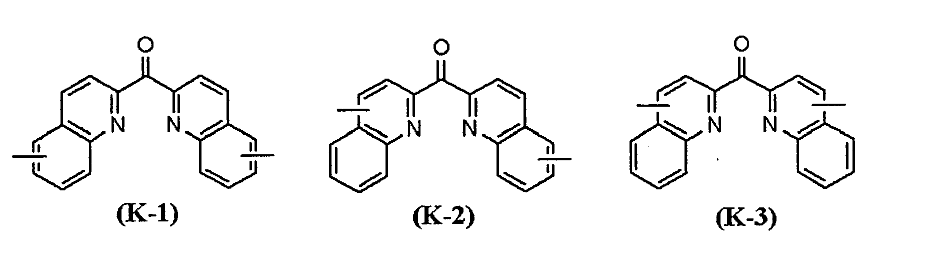

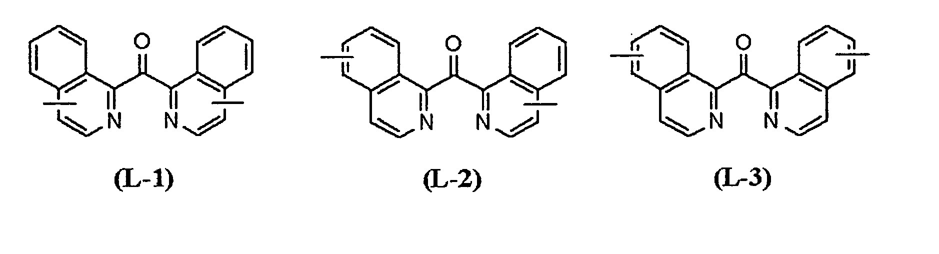

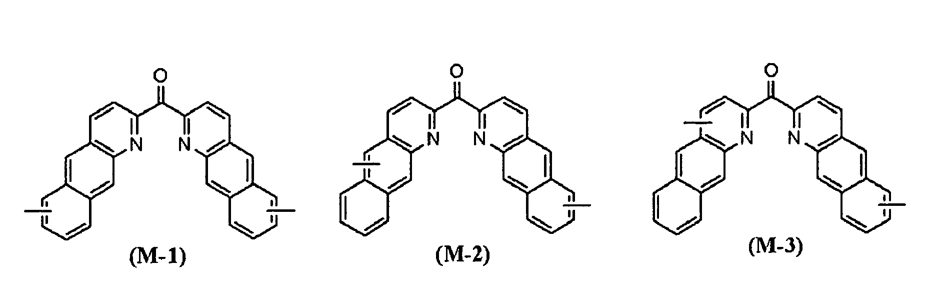

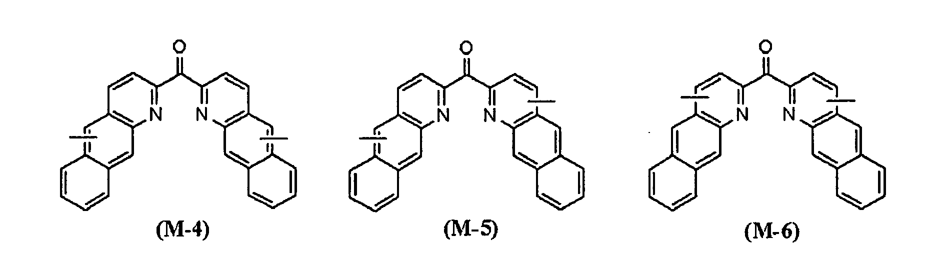

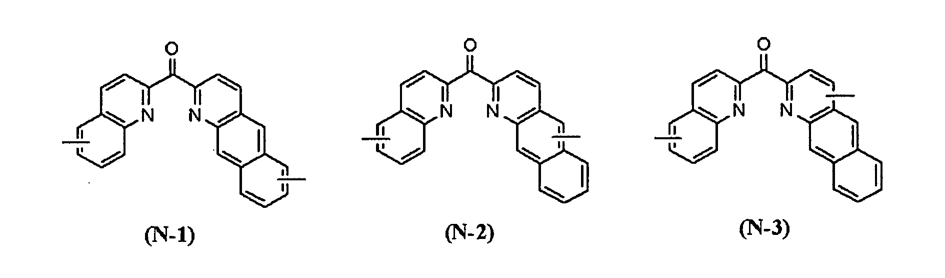

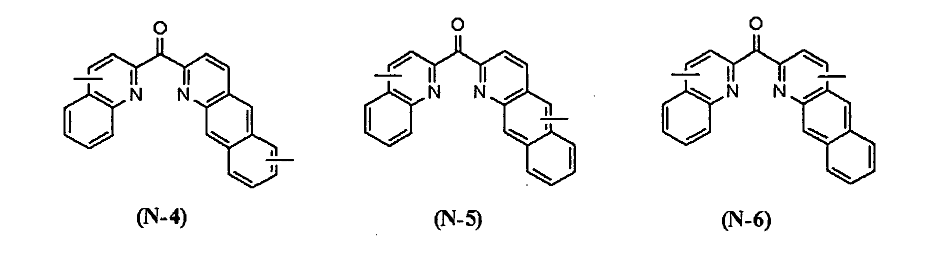

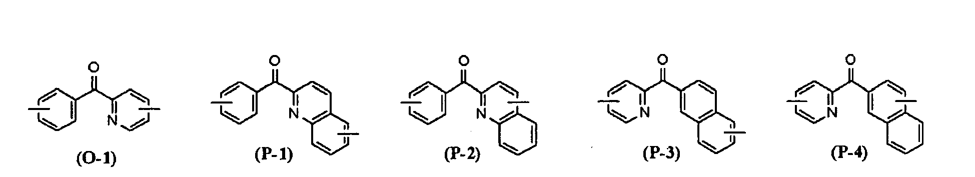

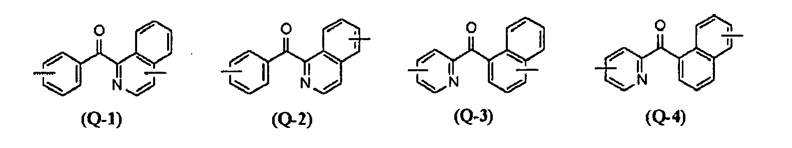

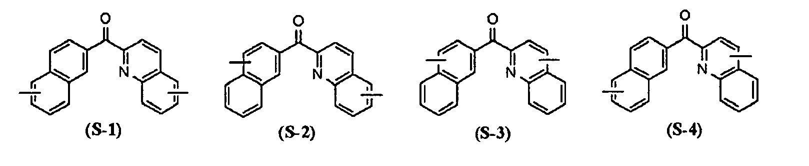

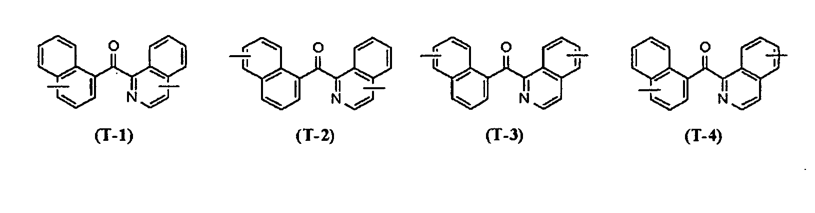

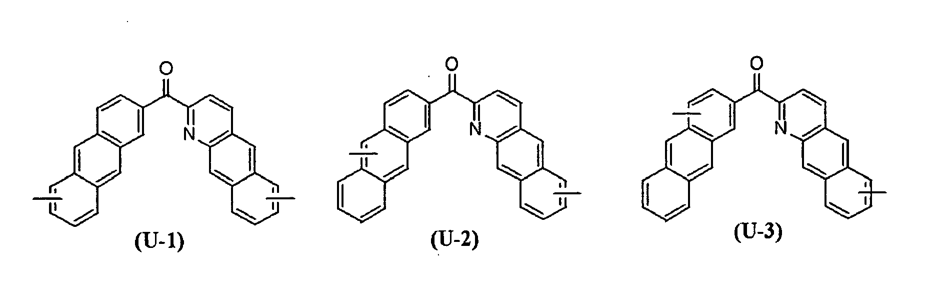

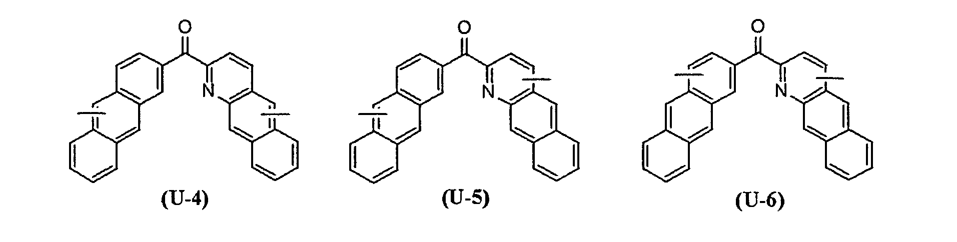

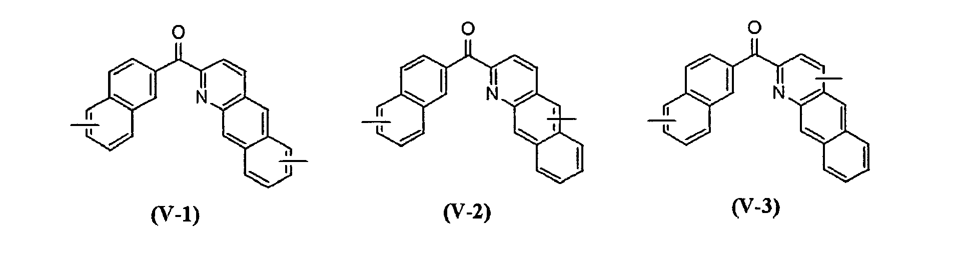

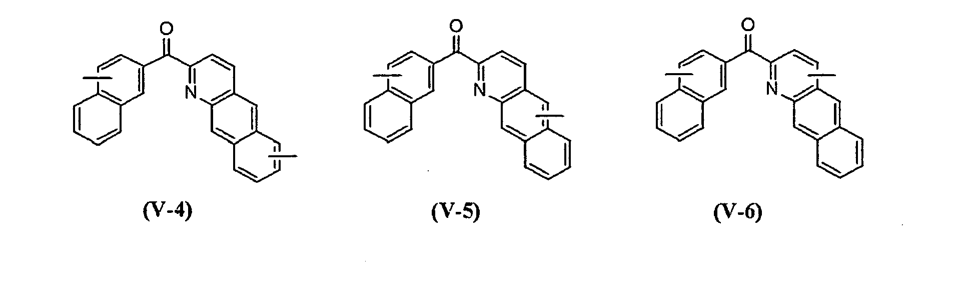

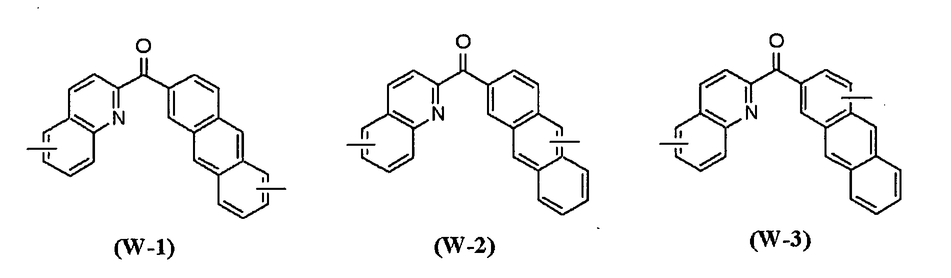

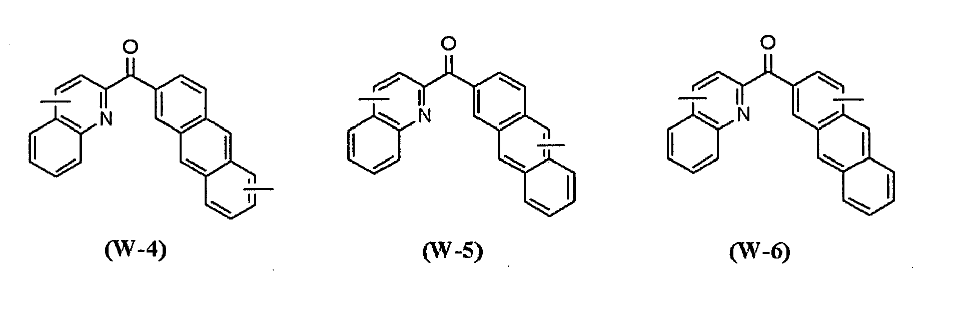

Solid lines projecting from aromatic rings in the above-described formulae (A-1) to (Q-4) and (S-1) to (W-6) represent connecting bonds. For example, a repeating unit of the above-described formula (B-1) has one connecting bond on any position of b1 to b5, and has one connecting bond on any position of b7 to b10.

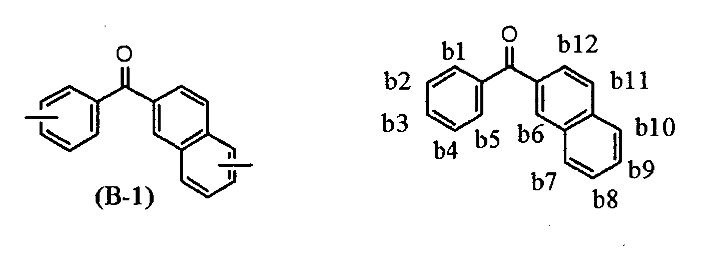

When the polymer compound of the present invention contains a group of the above-described formula (2), examples of the above-described formula (2) in which Ar³ represents an aryl group include the same groups as explained and exemplified for the substituent on the fluorenediyl group described above. Among aryl groups, preferable are a phenyl group, naphthyl group, anthracenyl group.

Examples when Ar³ represents a mono-valent heterocyclic group include the same groups as explained and exemplified for the substituent on the fluorenediyl group described above. Among mono-valent heterocyclic groups, preferable are a thienyl group, pyrrolyl group, furyl group, pyridyl group, piperidyl group, quinolyl group, isoquinolyl group.

When Ar³ has a substituent, it is preferable from the standpoint of solubility in an organic solvent, device properties, easiness of synthesis of a polymer compound and the like that the substituent is selected from an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group and cyano group. The substituent is selected from more preferably an alkyl group, alkoxy group, aryl group, aryloxy group, arylalkyl group, arylalkoxy group, substituted amino group, substituted silyl group, acyl group, substituted carboxyl group and cyano group, still preferably an, alkyl group, alkoxy group, aryl group, aryloxy group, arylalkyl group and arylalkoxy group, further preferably an alkyl group, alkoxy group, aryl group, particularly preferably an alkyl group.

As the group of the above-described formula (2), groups of the following formula (2-1) are preferable. 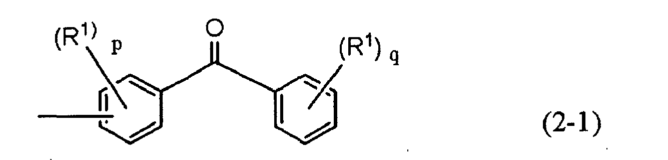 (in the formula (2-1), q represents an integer of 0 to 5. R¹ and p represents the same meaning as described above.).

As the group of the above-described formula (2-1), groups of the following formula (2-2) are preferable.

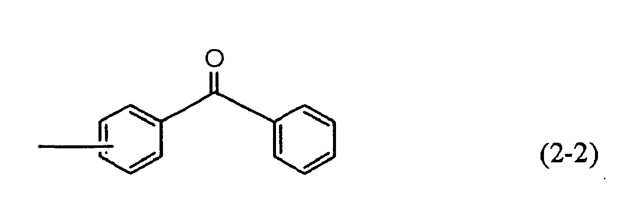

Examples of the group of the above-described formula (2) includes residual groups obtained by removing one hydrogen atom from the following compounds (formulae A, B, C, D, E, F, G, H, I, J, K, L, M, N, O, P, Q, S, T, U, V and W), and residual groups obtained by removing one hydrogen atom from the following compounds and further in which one or mo hydrogen atoms are substituted by a substituent such as an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group and cyano group and the like.

As the group of the above-described formula (2), the following groups are mentioned.

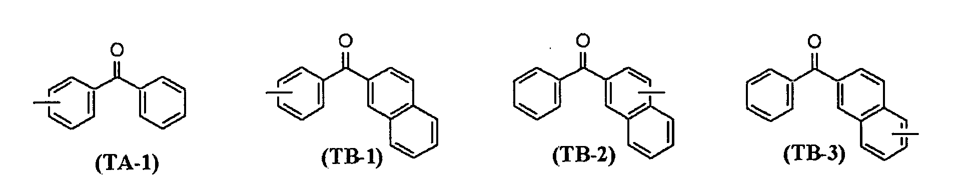

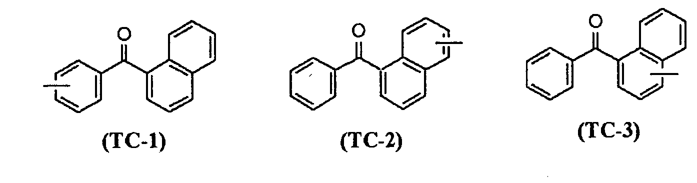

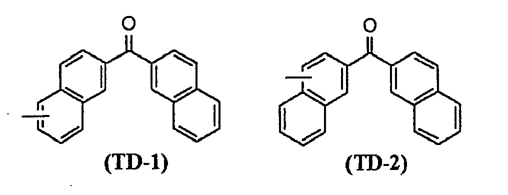

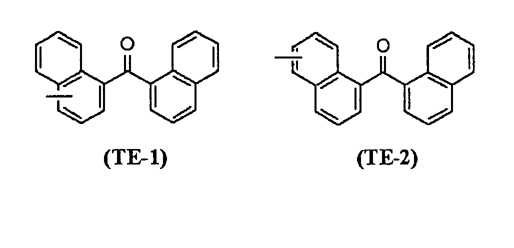

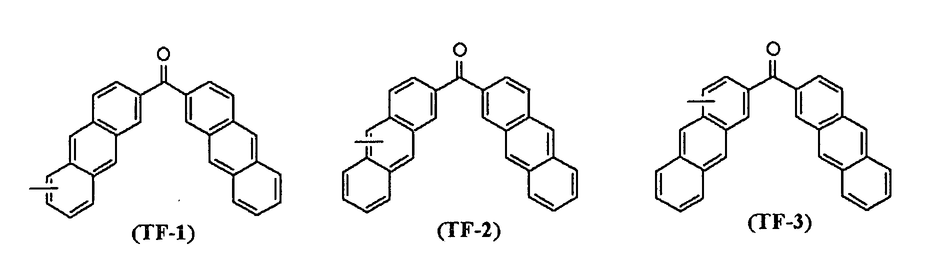

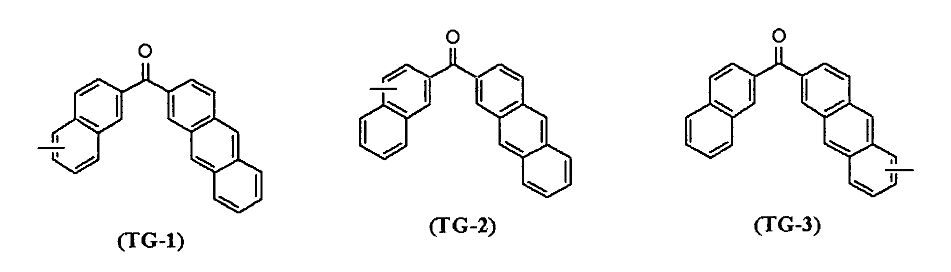

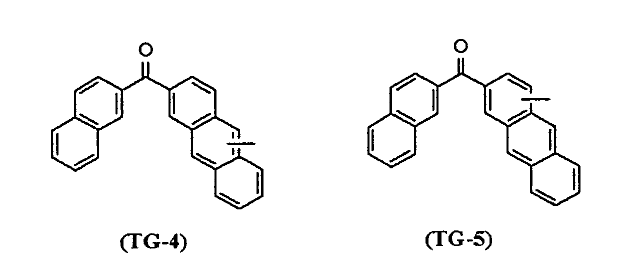

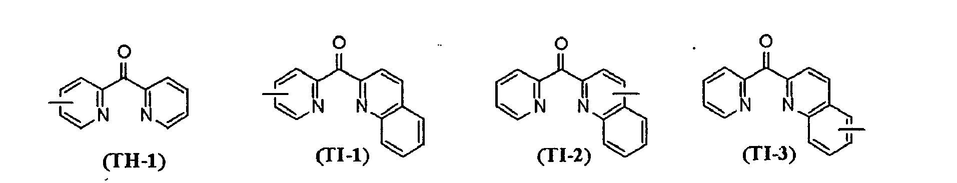

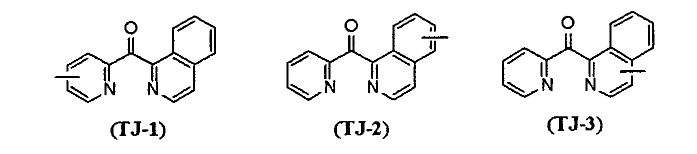

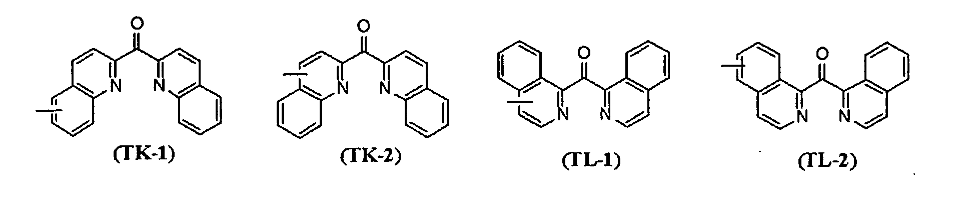

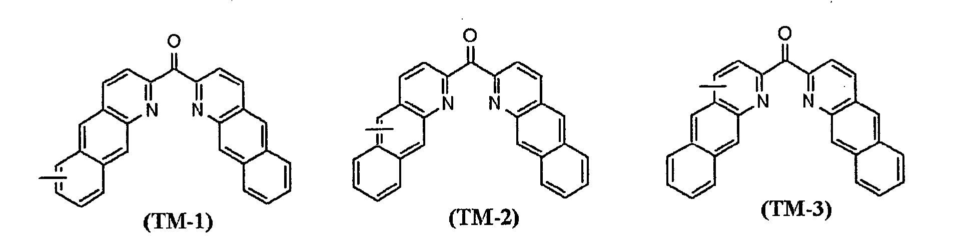

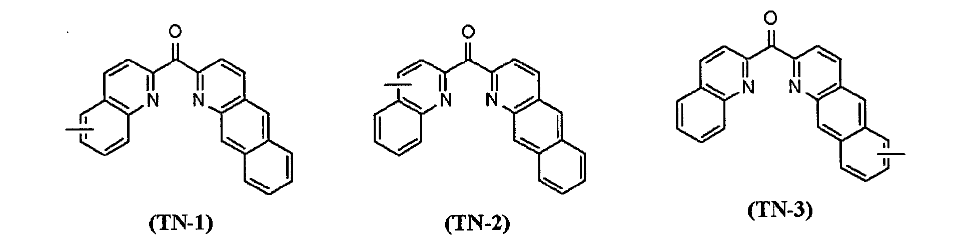

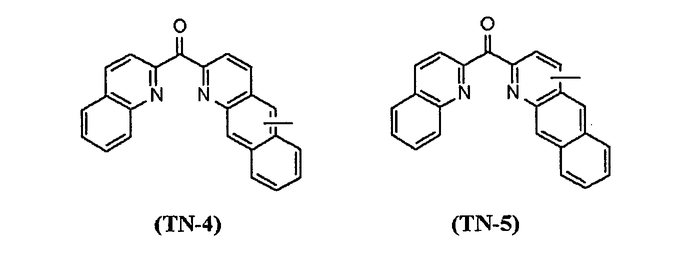

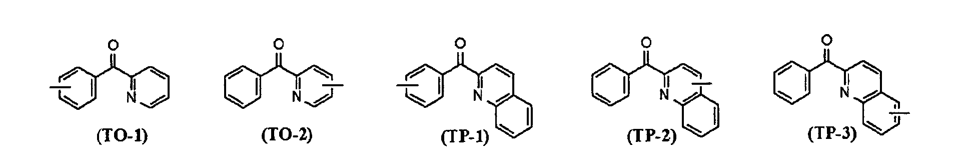

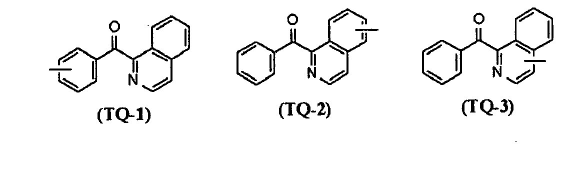

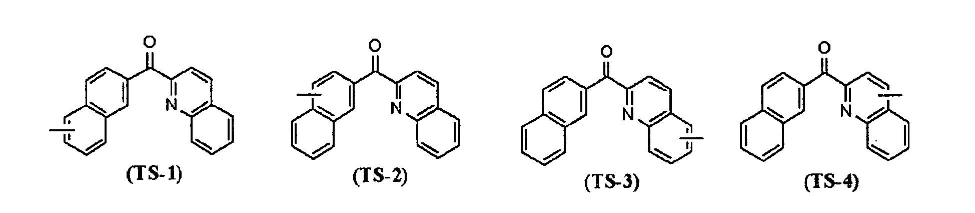

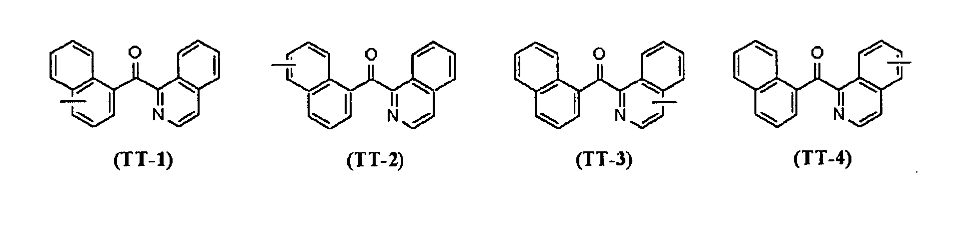

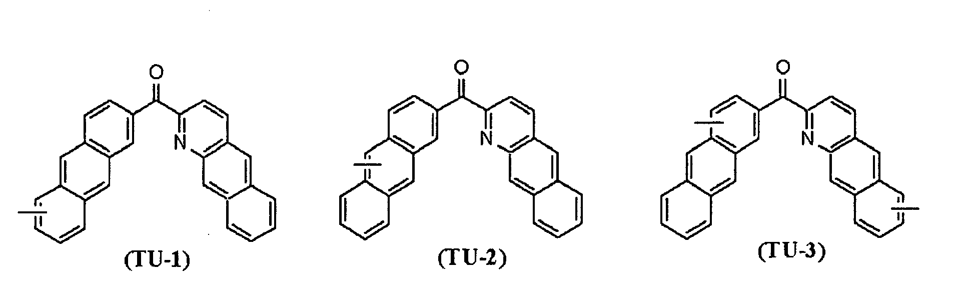

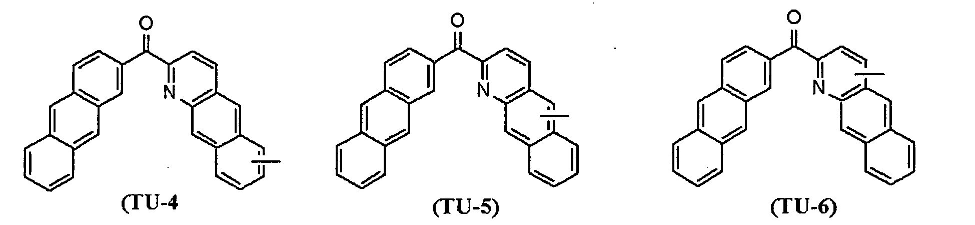

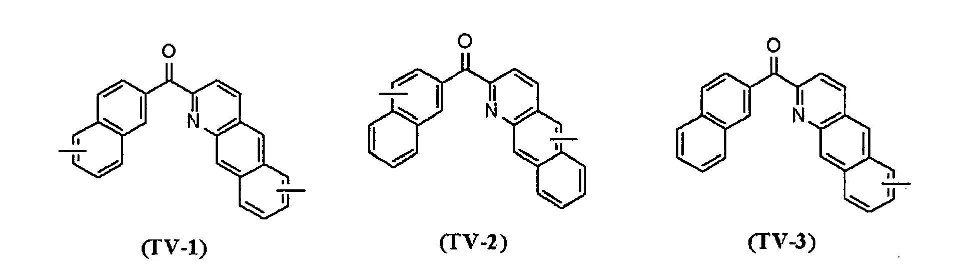

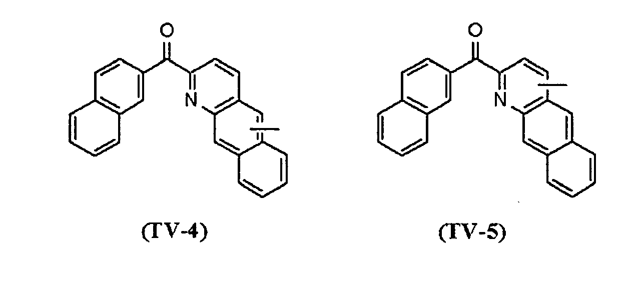

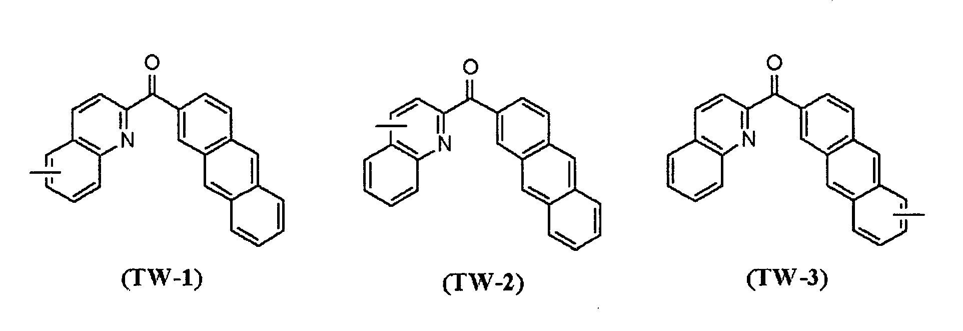

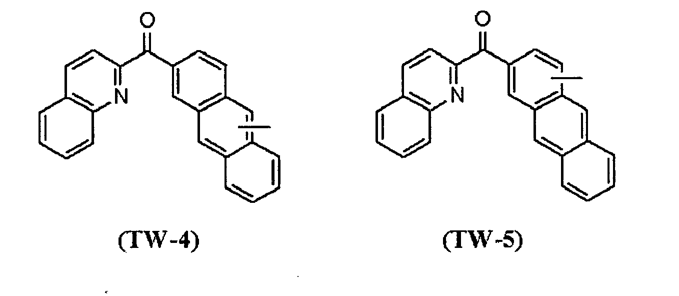

Solid lines projecting from aromatic rings in the above-described formulae (TA-1) to (TQ-3) and (TS-1) to (TW-5) represent the same meaning as in the above-described formula (B-1).

The polymer compound of the present invention may contain a repeating unit other than the optionally substituted fluorenediyl group, phenylene group having one or more substituents and a repeating unit of the above-described formula (1). Examples of this repeating unit include repeating units of the following formula (5):

-Ar₄- (5)

(in the formula, Ar₄ represents an arylene group, di-valent heterocyclic group or di-valent aromatic amine group. However, the optionally substituted fluorenediyl group, phenylene group having one or more substituents and a repeating unit of the above-described formula (1) are excluded.).

In the above-described formula (5), the arylene group represented by Ar₅ is an atomic group obtained by removing two hydrogen atoms from an aromatic hydrocarbon, and includes atomic groups obtained by removing two hydrogen atoms from those having a condensed ring, and those in which independent two or more benzene rings or condensed rings are connected directly or via a group such as vinylene and the like. The arylene group optionally has a substituent. The carbon number of a portion of the arylene group excluding the substituent is usually about 6 to 60, preferably 6 to 20. The total carbon number of the arylene group including the substituent is usually about 6 to 100.

Examples of the arylene group represented by Ar₄ include phenylene groups having no substituent (for example, the following formulae 1 to 3), naphthalenediyl groups (for example, the following formulae 4 to 13), anthracenediyl groups (for example, the following formulae 14 to 19), biphenyl-diyl groups (for example, the following formulae 20 to 25), terphenyl-diyl groups (for example, the following formulae 26 to 28), condensed ring compound groups (for example, the following formulae 29 to 35), benzofluorene-diyl groups (for example, the following formulae 36 to 38), dibenzofluorene-diyl groups (for example, the following formula Z), stilbene-diyl groups (for example, the following formulae 39 to 42), distilbenediyl groups (for example, the following formulae 43, 44), and the like. 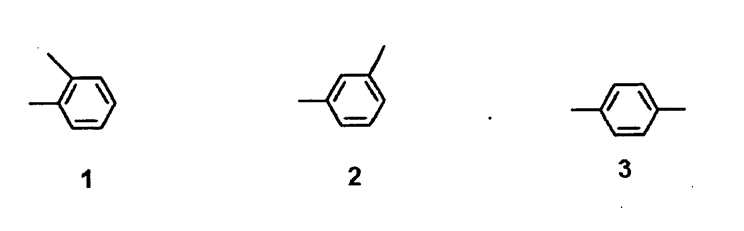 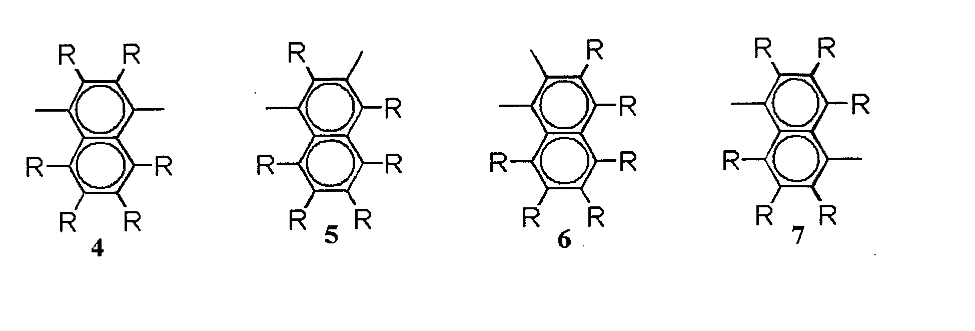 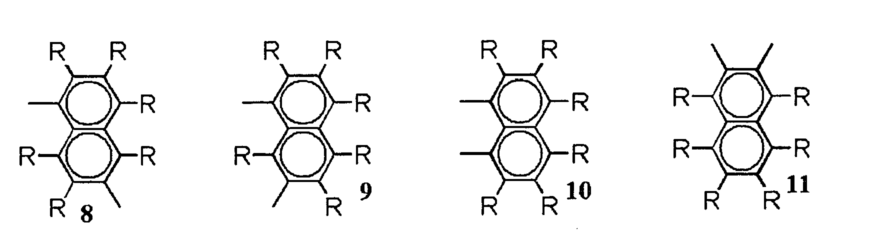 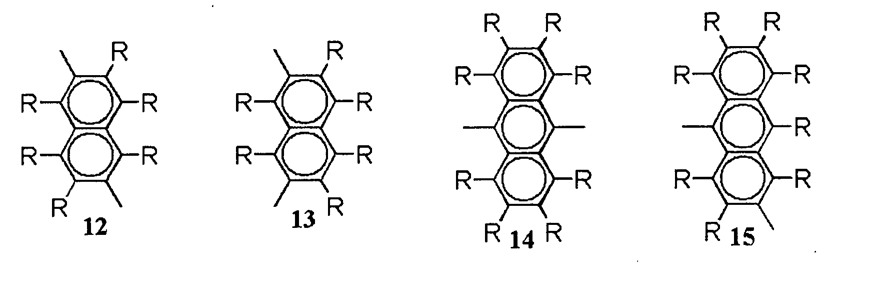 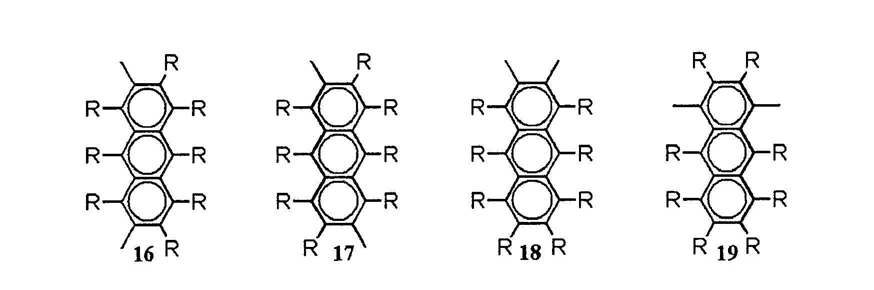 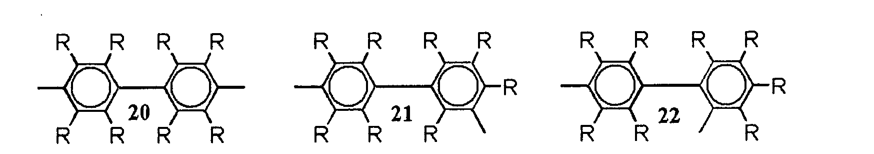 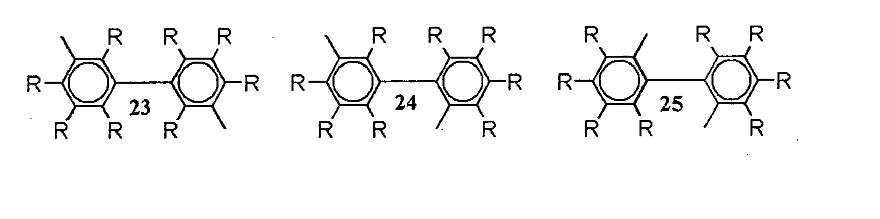 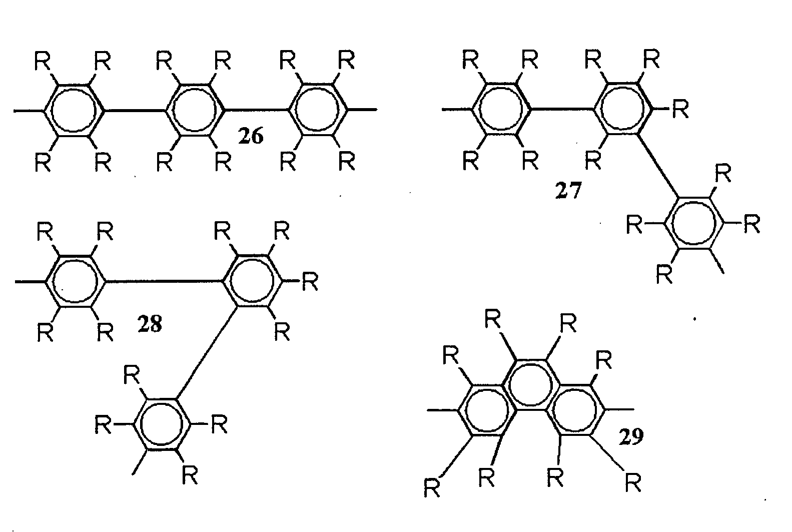 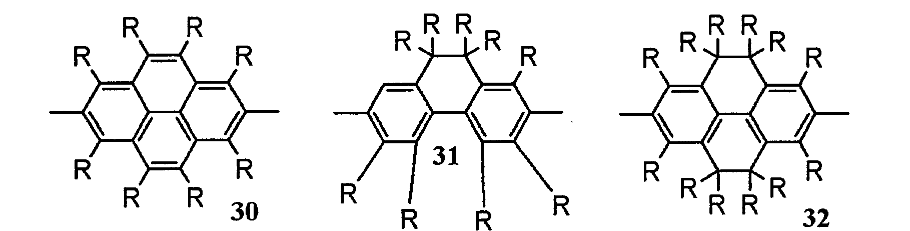 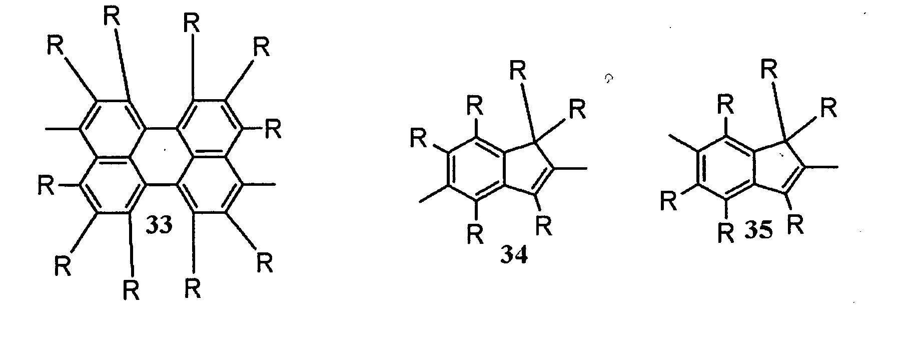 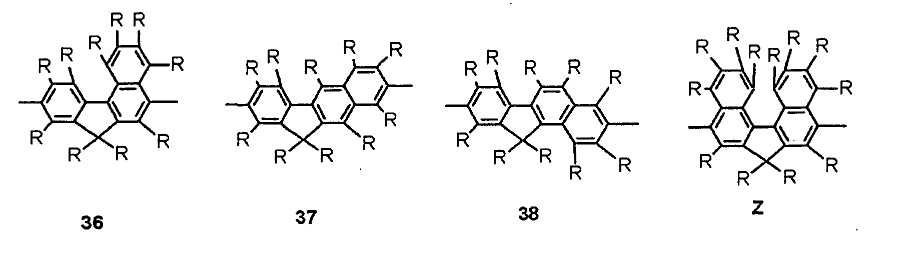 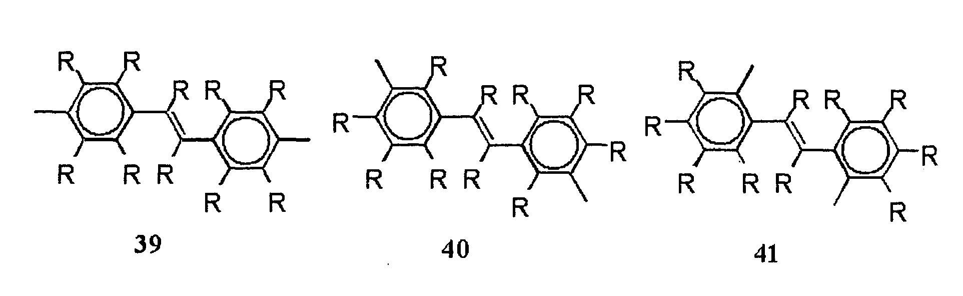 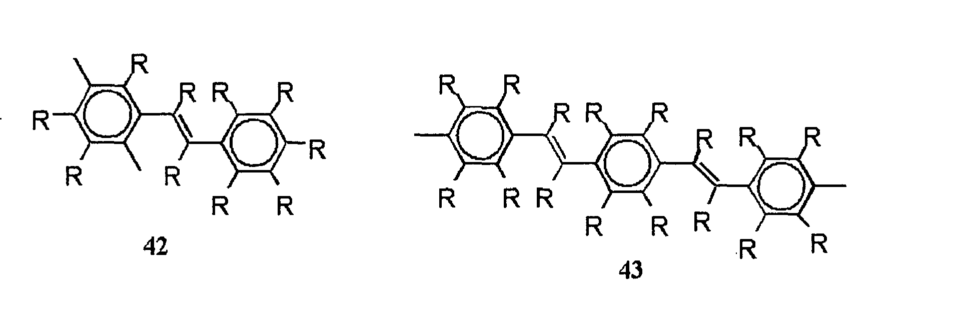 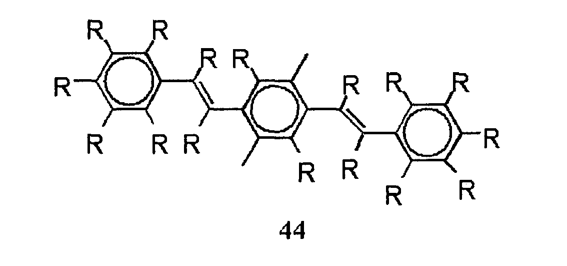 (in the formulae, R represents a hydrogen atom or substituent. A plurality of R's may be the same or different.).

Examples of the substituent represented by R in the above-described formulae 1 to 44 and Z include an alkyl groups, alkoxy groups, alkylthio groups, aryl groups, aryloxy groups, arylthio groups, arylalkyl groups, arylalkoxy groups, arylalkylthio groups, arylalkenyl groups, arylalkynyl groups, amino group, substituted amino groups, silyl group, substituted silyl groups, halogen atoms, acyl group, acyloxy group, imine residue, amide group, acid imide groups, monovalent heterocyclic groups, carboxyl group, substituted carboxyl groups, cyano group, groups of the above-described formula (2), and the like. A hydrogen atom contained in these substituents may be substituted by a fluorine atom. These groups, residues and atoms are the same as explained and exemplified in the column of the substituent on the fluorinedily group described above. Regarding the substituents represented by R, it is preferable that at least one R is other than a hydrogen atom from the standpoint of solubility of a polymer compound in an organic solvent and device properties. The substituent represented by R is preferably an alkyl group, alkoxy group, alkylthio group, aryl group, aryloxy group, arylthio group, arylalkyl group, aryl alkoxy group or monovalent heterocyclic group, and more preferably an alkyl group, alkoxy group or aryl group.

The divalent heterocyclic group represented by Ar₄ means an atomic group remaining after removal of two hydrogen atoms from a heterocyclic compound. The divalent heterocyclic group optionally has a substituent. The above-described heterocyclic compound refers to organic compounds having a cyclic structure in which elements constituting the ring include not only a carbon atom, but also a hetero atom such as oxygen, sulfur, nitrogen, phosphorus, boron, arsenic and the like contained in the ring. Of the divalent heterocyclic groups, aromatic heterocyclic groups are preferable. The carbon number of a portion of the divalent heterocyclic group excluding the substituent is usually about 3 to 60. The total carbon number of the divalent heterocyclic group including the substituent is usually about 3 to 100.

Examples of the divalent heterocyclic group represented by Ar₄ include divalent heterocyclic groups containing nitrogen as a hetero atom such as pyridine-diyl groups (for example, the following formulae 45 to 50), diazaphenylene groups (for example, the following formulae 51 to 54), quinolinediyl groups (for example, the following formulae 55 to 69), quinoxalinediyl groups (for example, the following formulae 70 to 74), acridinediyl groups (for example, the following formulae 75 to 78), bipyridyldiyl groups (for example, the following formulae 79 to 81), phenanthrolinediyl groups (for example, the following formulae 82 to 84), groups having a carbazole structure (for example, the following formulae 85 to 87) and the like; 5-membered heterocyclic groups containing as a hetero atom oxygen, silicon, nitrogen, sulfur, selenium and the like (for example, the following formulae 88 to 92); 5-membered condensed heterocyclic groups containing as a hetero atom oxygen, silicon, nitrogen, selenium and the like (for example, the following formulae 93 to 103); 5-membered heterocyclic groups containing as a hetero atom oxygen, silicon, nitrogen, sulfur, selenium and the like, having bonding at the α-position of its hetero atom to form a dimer or oligomer (for example, the following formulae 104 to 105); 5-membered heterocyclic groups containing as a hetero atom oxygen, silicon, nitrogen, sulfur, selenium and the like, bonding at the α-position of its hetero atom to a phenyl group (for example, the following formulae 106 to 112); 5-membered condensed heterocyclic groups containing as a hetero atom oxygen, nitrogen, sulfur and the like, substituted with a phenyl group, furyl group or thienyl group (for example, the following formulae 113 to 118), and the like. 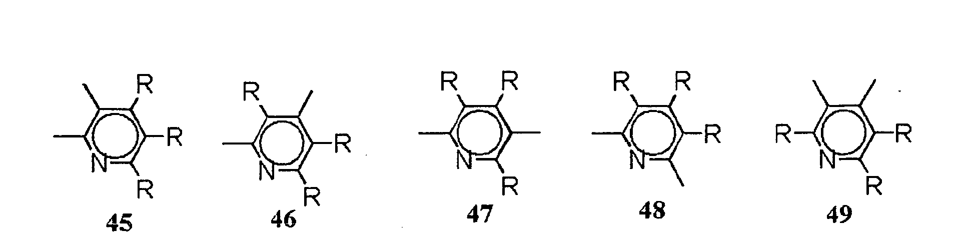 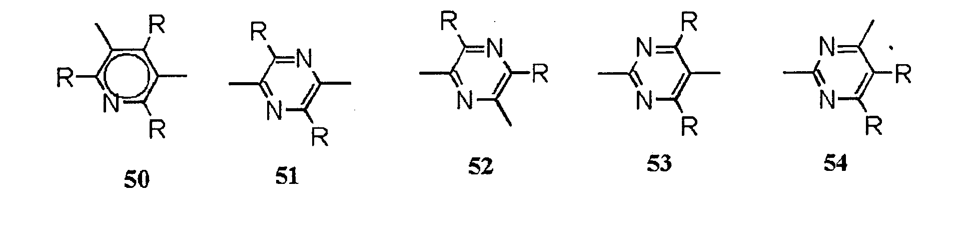 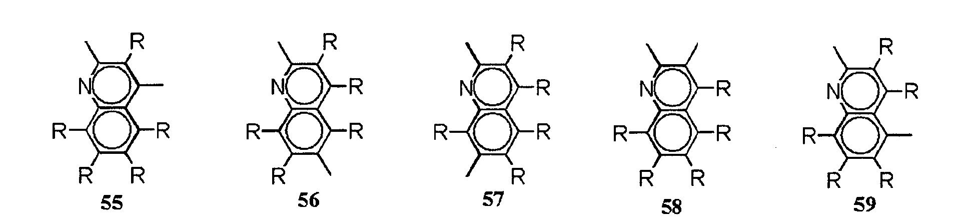 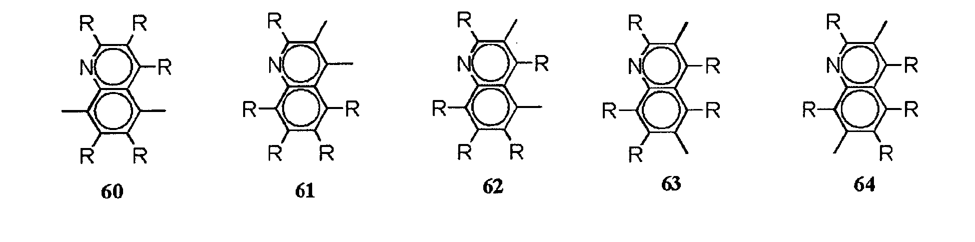 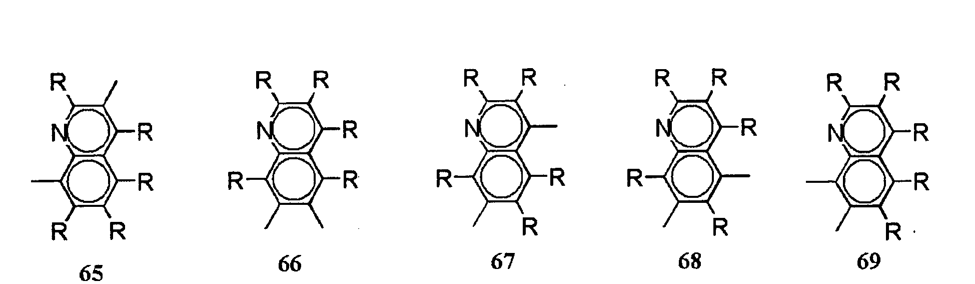 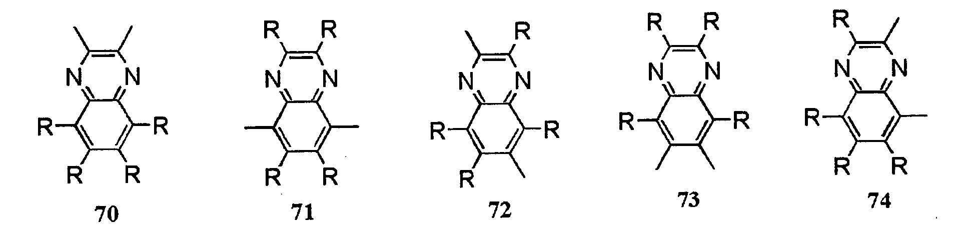 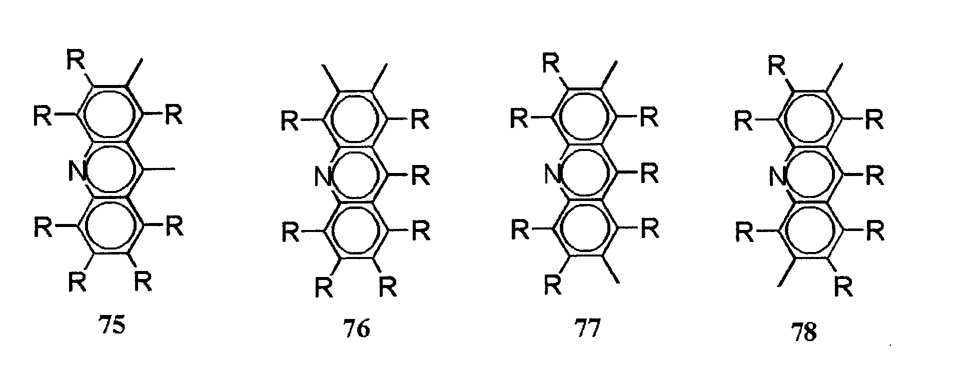 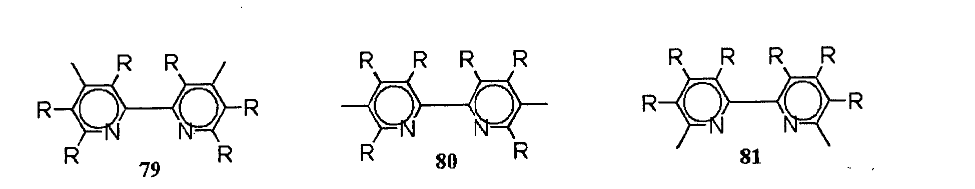 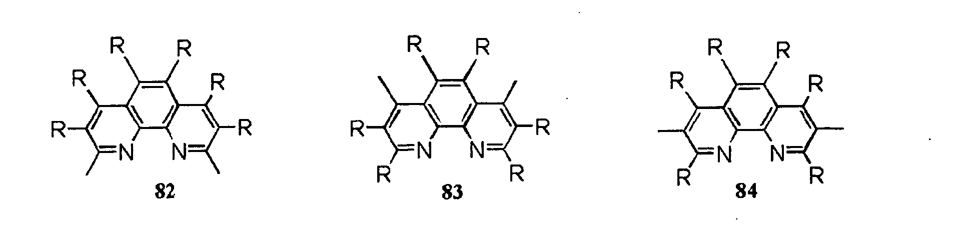 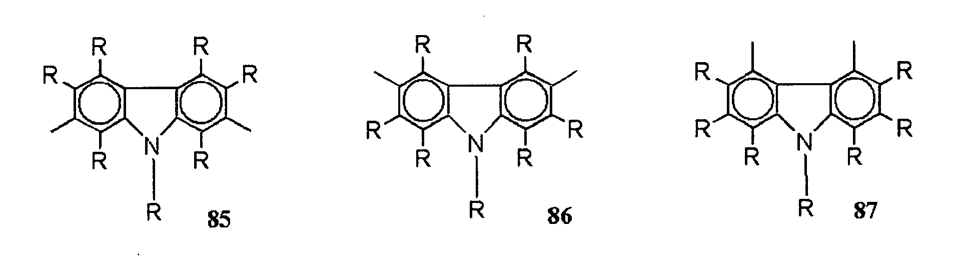 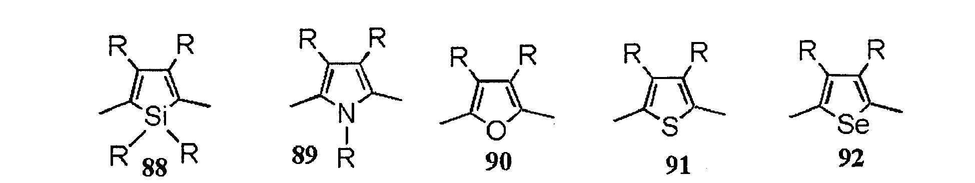 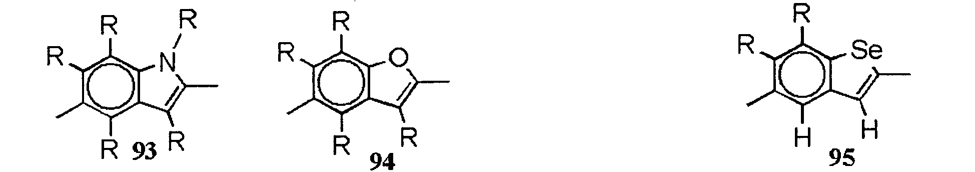 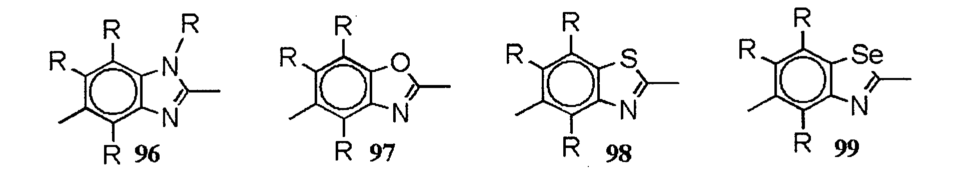 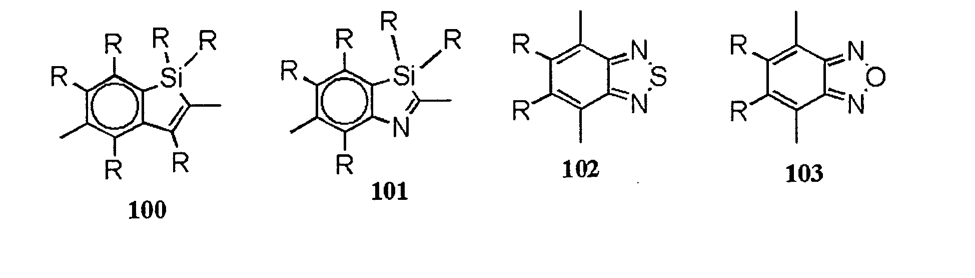 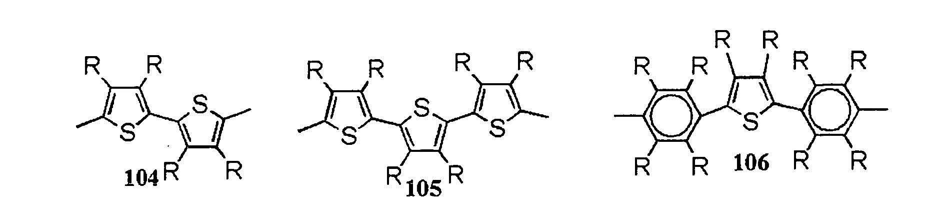 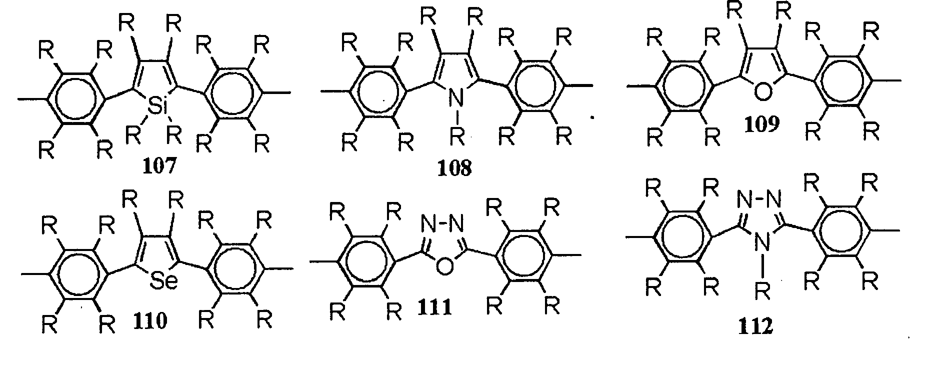 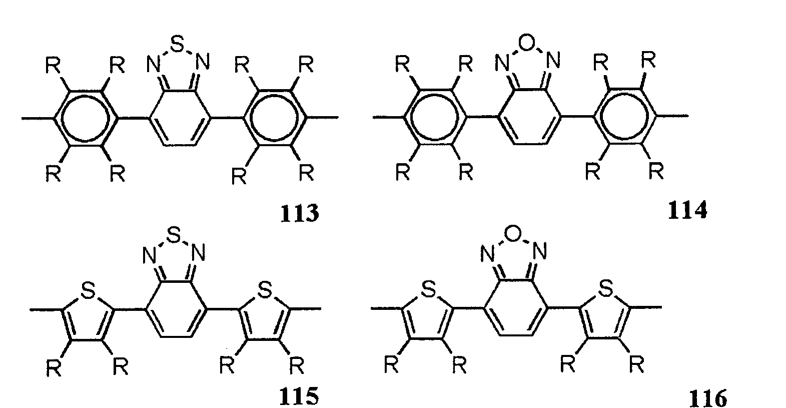 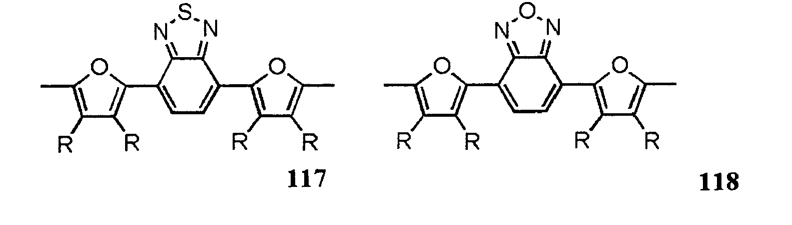 (in the formulae, R is as defined above. A plurality of R's may be the same or different.).

The divalent aromatic amine group represented by Ar₄ includes atomic groups obtained by removing two hydrogen atoms from an aromatic ring of aromatic tertiary amines or compounds derived from aromatic tertiary amines. Among the divalent aromatic amine groups, preferable are groups of the following formula (2-A): 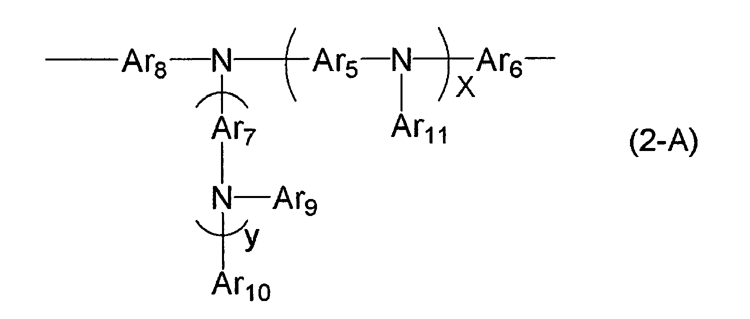 (wherein, Ar₅, Ar₆, Ar₇ and Ar₈ represent each independently an arylene group or divalent heterocyclic group. Ar₉, Ar₁₀ and Ar₁₁ represent each independently an aryl group or monovalent heterocyclic group. x and y represent each independently 0 or positive integer.) from the standpoint of changing of light emission wavelength, balancing of electric charges, enhancement of maximum luminous efficiency, and improvement in heat resistance.

In the above-described formula (2-A), x represents preferably an integer of 0 to 2, more preferably 0 or 1, from the standpoint of device properties such as maximum luminous efficiency, half luminance lifetime and the like, and easiness of synthesis of a polymer compound. In the above-described formula (2-A), y represents preferably an integer of 0 to 2, more preferably 0 or 1, from the standpoint of device properties such as maximum luminous efficiency, half luminance lifetime and the like, and easiness of synthesis of a polymer compound.

Examples of the group of the above-described formula (2-A) include those of the following formulae 119 to 126. 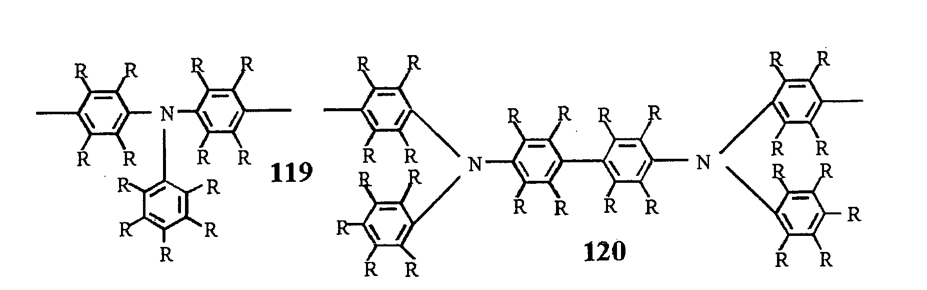 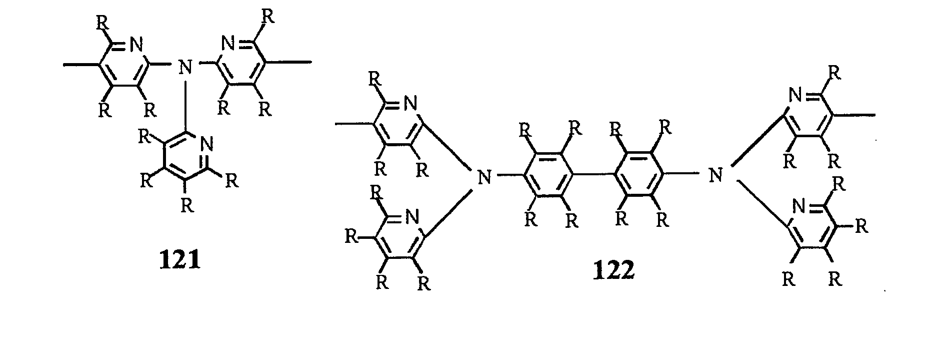 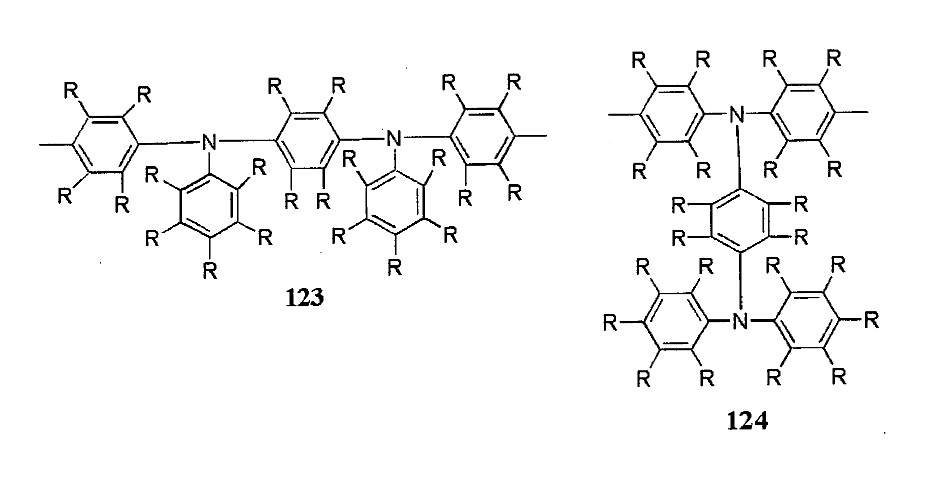 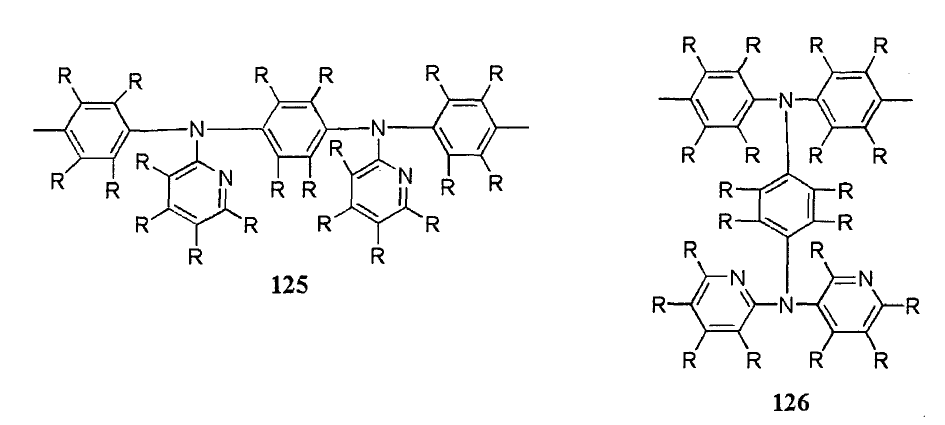 (in the formulae, R is as defined above. A plurality of R's may be the same or different.).

Among Ar₄'s of repeating units of the formula (5), preferable are repeating units of the following formulae (5-1) to (5-5): 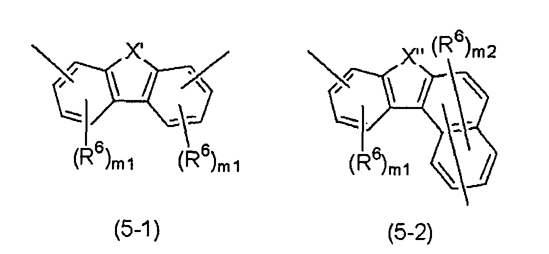 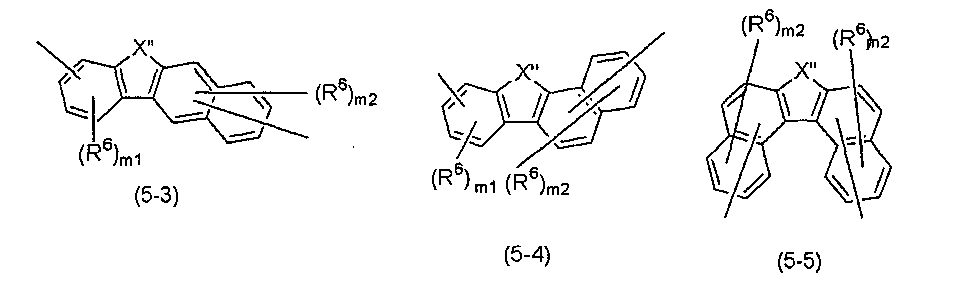 (in the formulae, R⁶ represents a substituent, m1 represents an integer of 0 to 3,and m2 represents an integer of 0 to 5.

When there exist a plurality of R⁶'s, they may be the same or different. In the formula (5-1), X' represents -O-, -S-, -S(=O)-, -S(=O)₂-, -Si(R⁷)₂-Si(R⁷)₂-, - Si(R⁷)₂-, -B(R⁷)-, -P(R⁷)-, -P(=O)(R⁷)-, -O-C(R⁷)₂- or N=C(R⁷)-, in the formulae (5-2), (5-3), (5-4) and (5-5), X'' represents -O-, -S-, -S(=O)-, -S(=O)₂-, - C(R⁷)₂-, -Si(R⁷)₂-Si(R⁷)₂-, -Si(R⁷)₂-, - B(R⁷)-, -P(R⁷)-, -P(=O)(R⁷)-, -O-C(R⁷)₂-, -C(R⁷)₂-O-, -C(R⁷)=N- or N=C(R⁷)-, and R⁷ represents a hydrogen atom or substituent. When there exist a plurality of R⁷'s, they may be the same or different.), and groups of the above-described formulae102, 103, 119, 120, 123, 124 (having this group as a repeating unit), from the standpoint of device properties such as maximum luminous efficiency and the like.

The substituent represented by R⁶ includes an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group, cyano group and the like. A hydrogen atom contained in these groups and residual groups may be substituted by a fluorine atom. These groups are the same as explaine and exemplified for the substituent on the fluorenediyl group.

R⁷ is prefeably a substituent, and the substituent represented by R⁷ includes an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group, nitro group, cyano group and the like. A hydrogen atom contained in these groups and residual groups may be substituted by a fluorine atom. Among the above-described R⁷'s, preferable from the standpoint of device properties such as half luminance lifetime and the like are an alkyl group, alkoxy group, alkylthio group, aryl group, aryloxy group, arylthio group, arylalkyl group, arylalkoxy group, mono-valent heterocyclic group, and more preferably an alkyl group, alkoxy group, aryl group, mono-valent heterocyclic group, particularly preferably an alkyl group, aryl group. These groups are the same as explained and exemplified for the substituent on the fluorenediyl group.

The polymer compound of the present invention may contain two or more fluorenediyl groups which are optionally substituted, two or more phenylene groups having one or more substituents, or two or more repeating units of the above-described formula (1). The polymer compound of the present invention may contain two or more repeating units of the above-described formula (2).

The polymer compound of the present invention may further contain a repeating unit of the following formula (6):

-CR⁸=CR⁹- (6)

(in the formula, R⁸ and R⁹ represent each independently a hydrogen atom, alkyl group, aryl group, mono-valent heterocyclic group, carboxyl group, substituted carboxyl group or cyano group.) and/or a repeating unit of the following formula (7):

-C≡C- (7)

In the above-described formula (6), the alkyl group, aryl group, mono-valent heterocyclic group and substituted carboxyl group represented by R⁸ and R⁹ are the same as explained and exemplified in the column of the substituent on the fluorenediyl group.

The polymer compound of the present invention may contain a mono-valent residual group of a compound showing light emission from the triplet excited state, as at least one of end groups.

### -- Compound showing light emission from triplet excited state (triplet compound)--

Here, the triplet compound is a compound showing light emission from the triplet excited state usually at room temperature (namely, 25°C), and includes, for example, also complexes in which phosphorescence emission is observed, and fluorescence emission is observed in addition to this phosphorescence emission.

As the triplet compound, metal complexes in which the center metal is a transition metal or lanthanoid are mentioned, and examples thereof include Ir(ppy)₃ containing iridium as the center metal, Btp₂Ir(acac), PtOEP containing platinum as the center metal, Eu(TTA)₃phen containing europium as the center metal, and the like.

Of the triplet compounds, examples of the complex compound (hereinafter, abbreviated as "triplet light emissive complex compound" in some cases) include metal complex compounds which have been conventionally used as EL light emission materials of low molecular weight. These are disclosed, for example, in Nature, (1998), 395, 151, Appl. Phys. Lett. (1999), 75(1), 4, Proc. SPIE-Int. Soc. Opt. Eng. (2001), 4105(Organic Light-Emitting Materials and DevicesIV), 119, J. Am. Chem. Soc., (2001), 123, 4304, Appl. Phys. Lett., (1997), 71(18), 2596, Syn. Met., (1998), 94(1), 103, Syn. Met., (1999), 99(2), 1361, Adv. Mater., (1999), 11(10), 852 and the like.

The center metal of the triplet light emitting complex compound is usually an atom having an atomic number of 50 or more which is a metal showing a spin-orbital interaction in the complex and capable of causing an intersystem crossing between the single state and the triplet state, and examples thereof include rhenium, iridium, osmium, scandium, yttrium, platinum, gold, and lanthanoids: europium, terbium, thulium, dysprosium, samarium, praseodymium, gadolinium and the like, and preferable are rhenium, iridium, platinum, gold, europium and terbium.

Examples of the ligand of the triplet light emitting complex compound include 8-quinolinol and derivatives thereof, benzoquinolinol and derivatives thereof, 2-phenylpyridine and derivatives thereof, 2-phenyl-benzothiazole and derivatives thereof, 2-phenyl-benzooxazole and derivatives thereof, porphyrin and derivatives thereof, and the like.

The triplet light emitting complex compound, for example, includes the following compounds.

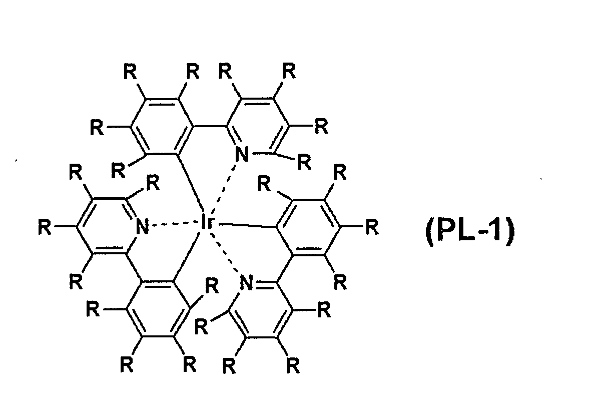

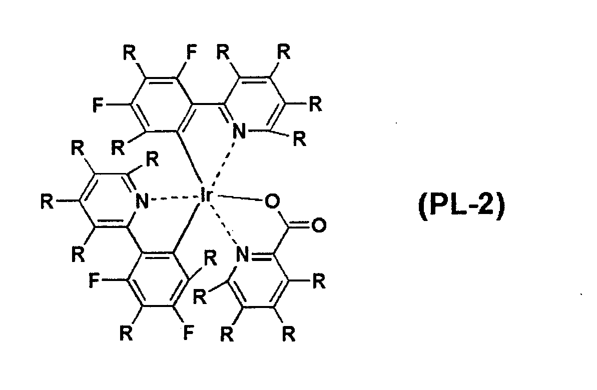

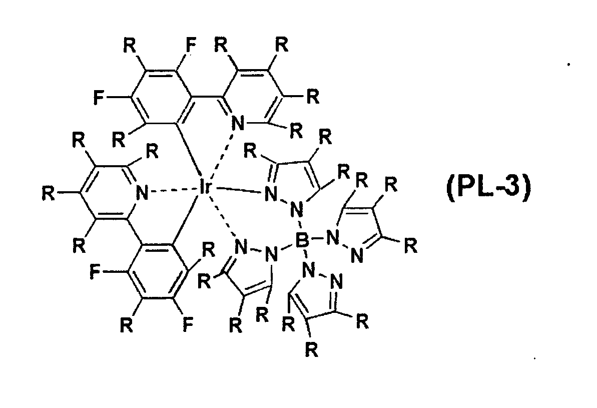

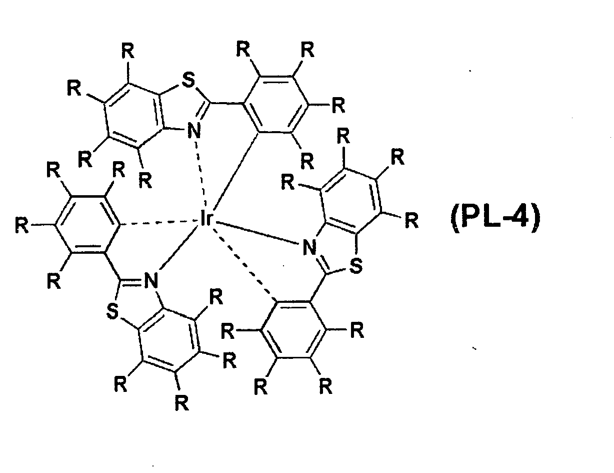

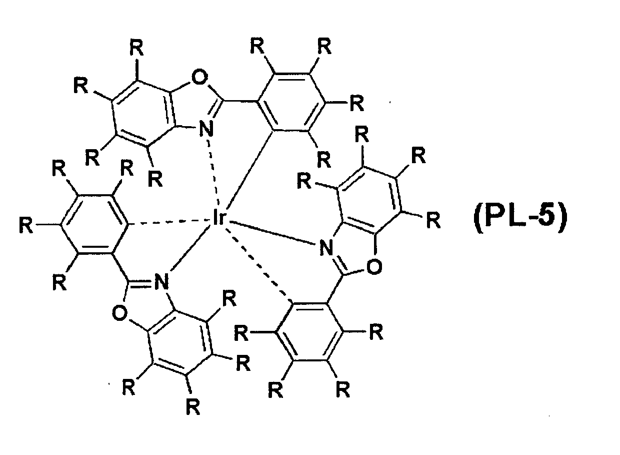

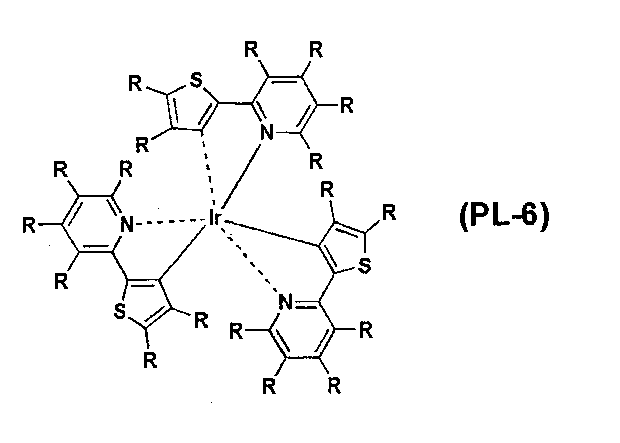

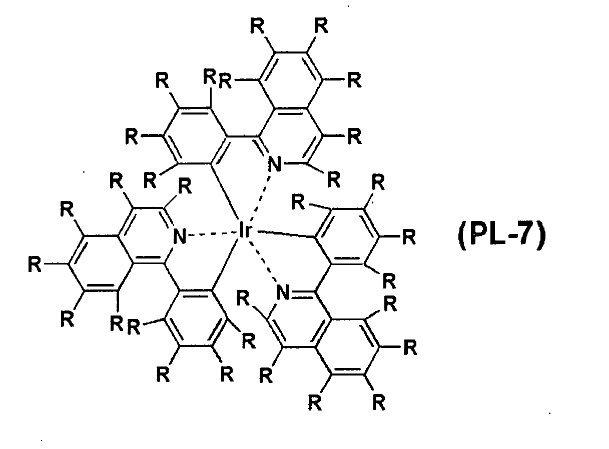

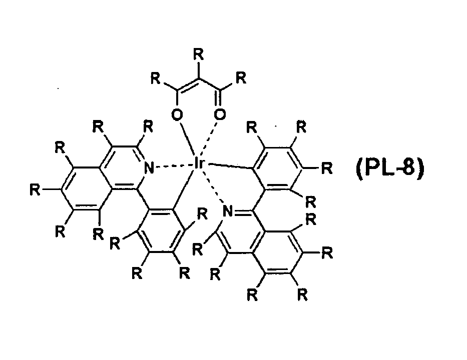

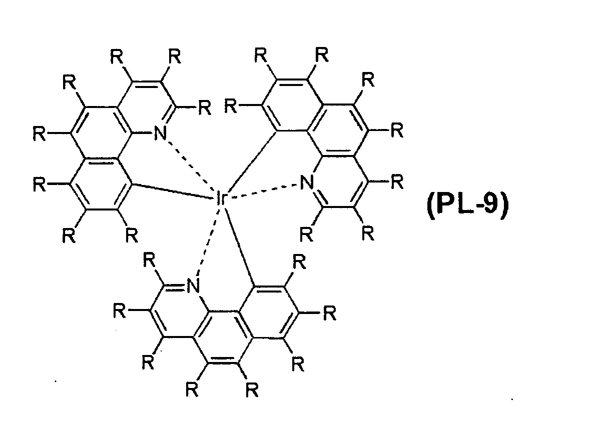

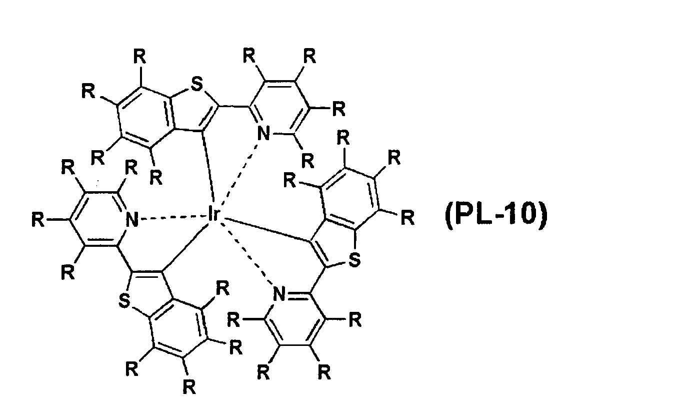

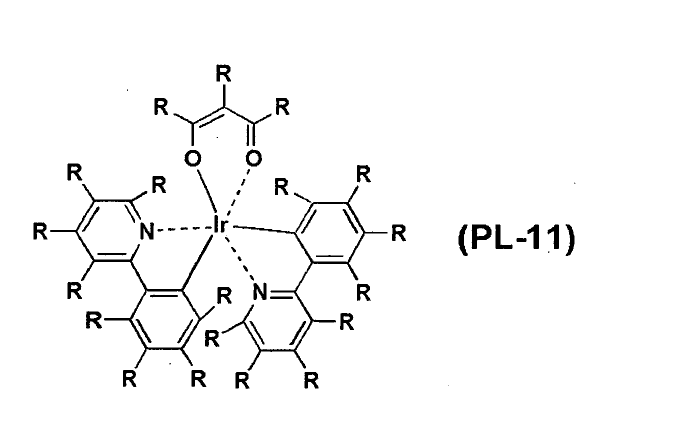

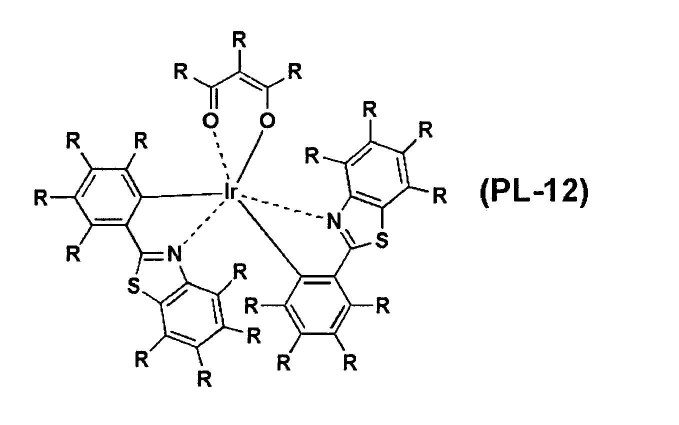

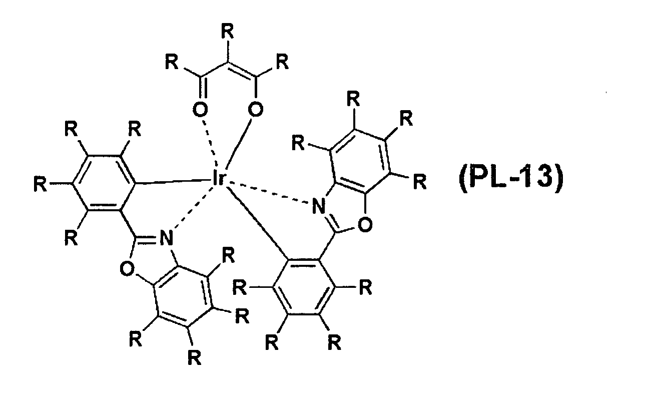

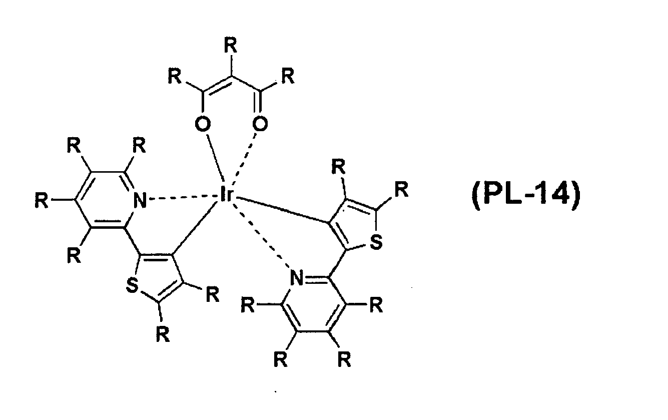

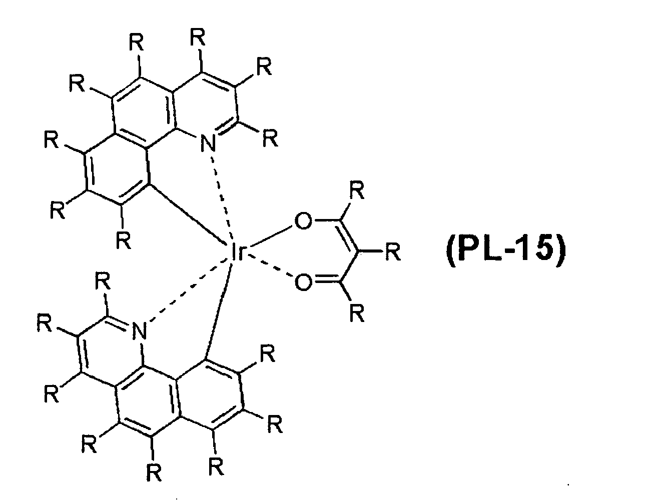

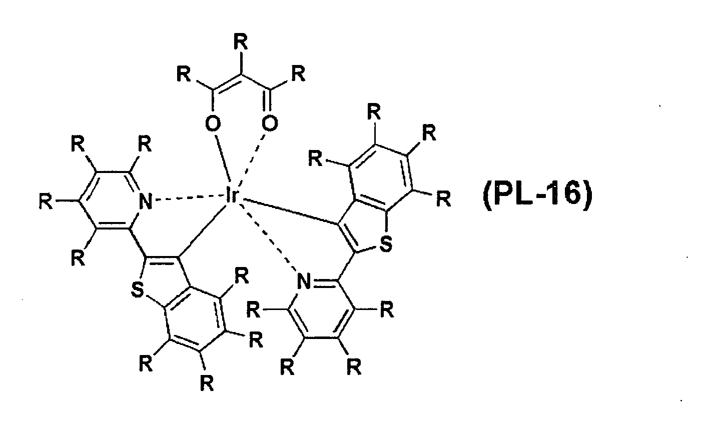

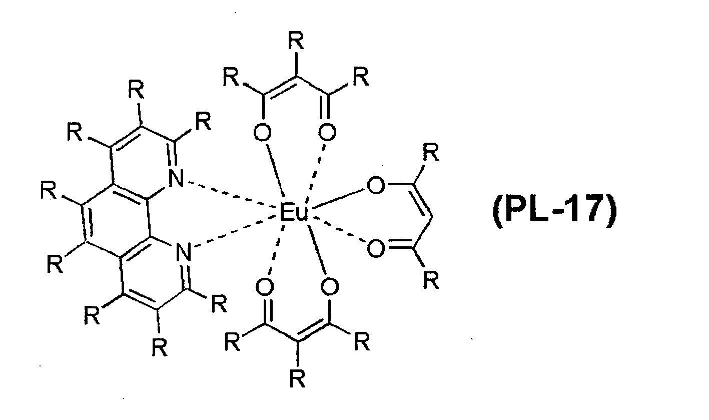

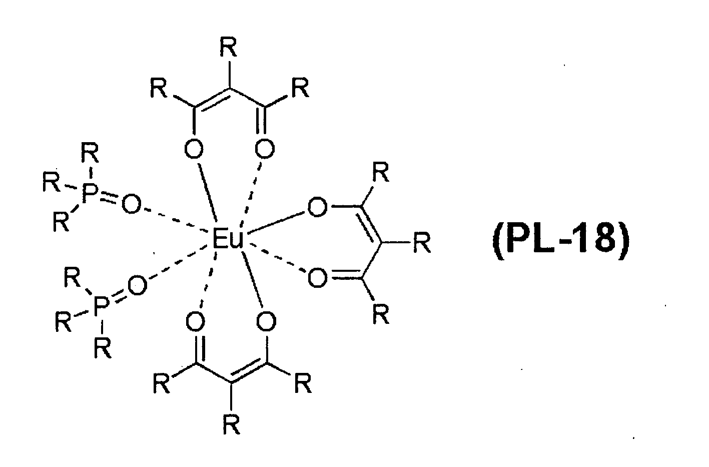

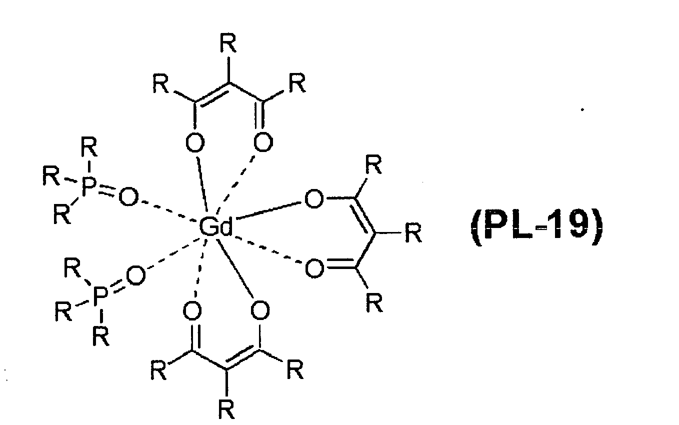

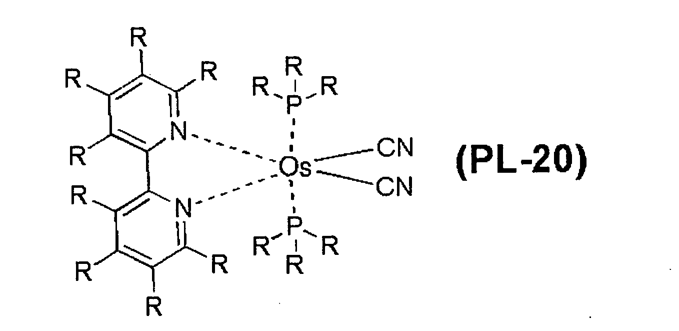

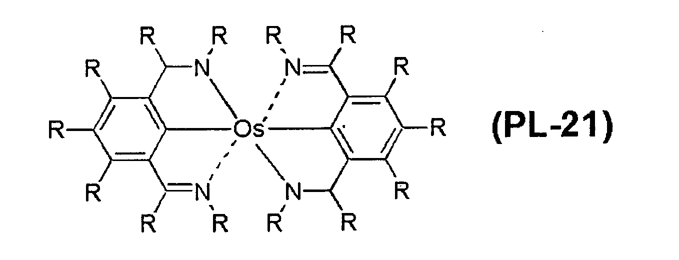

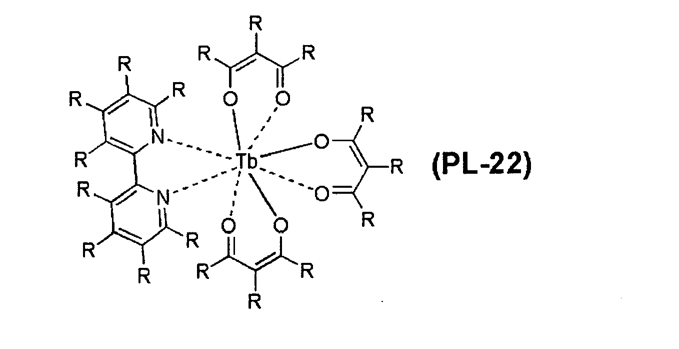

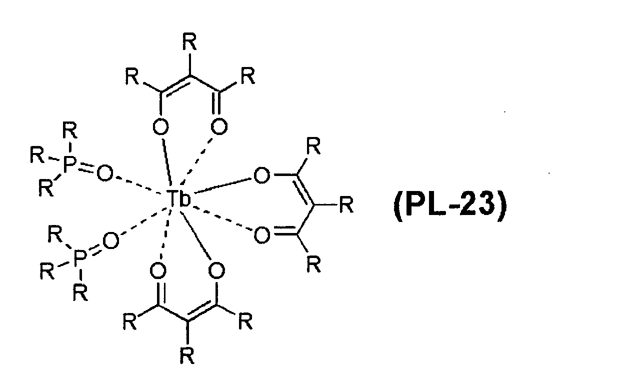

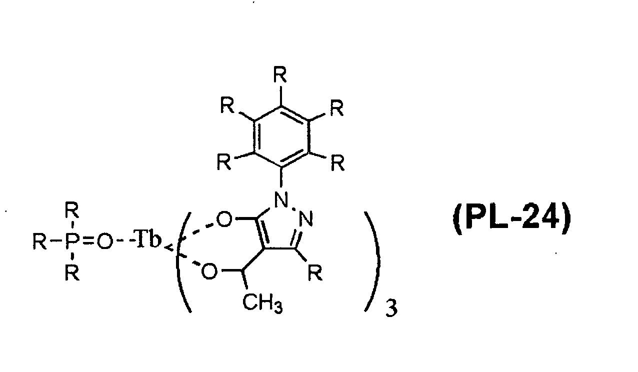

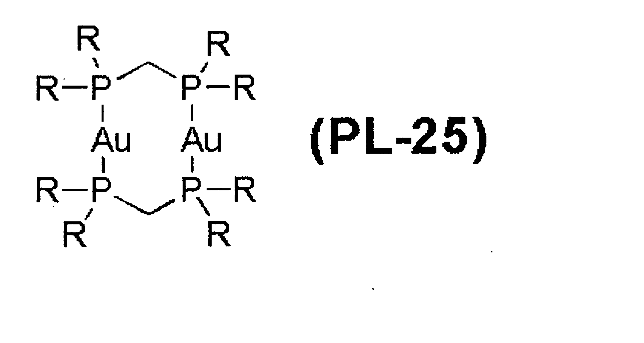

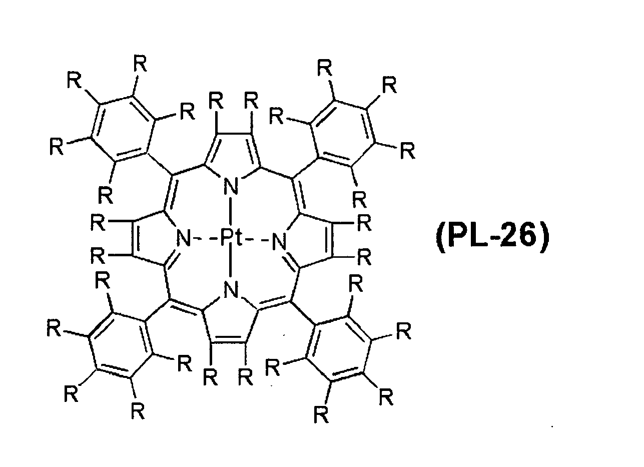

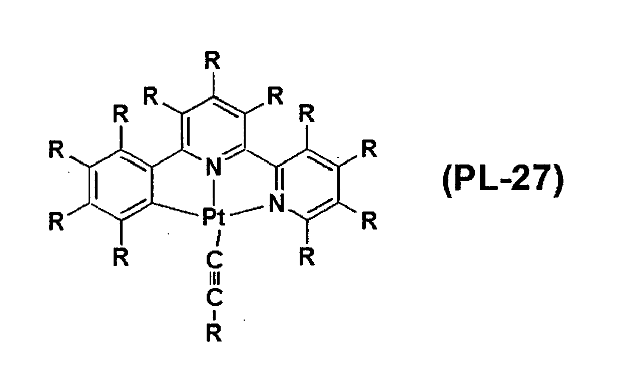

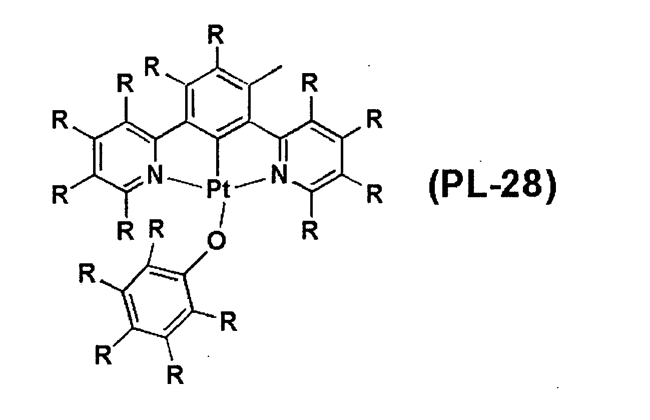

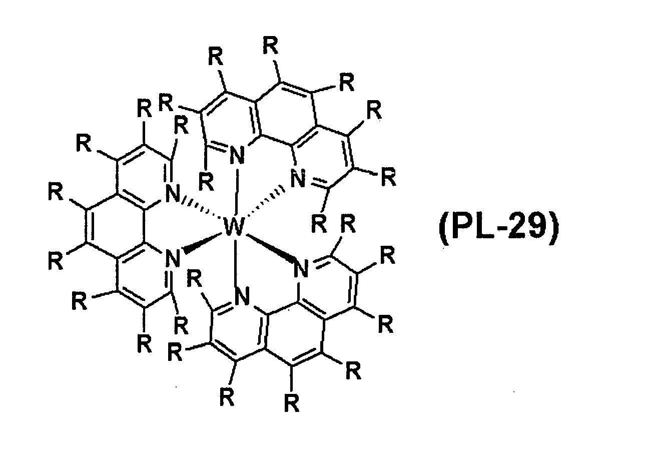

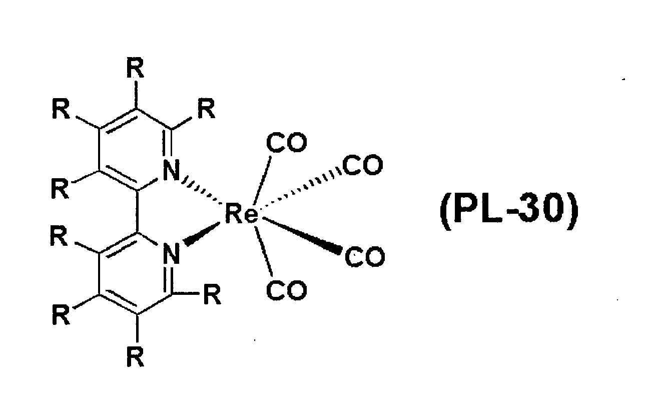

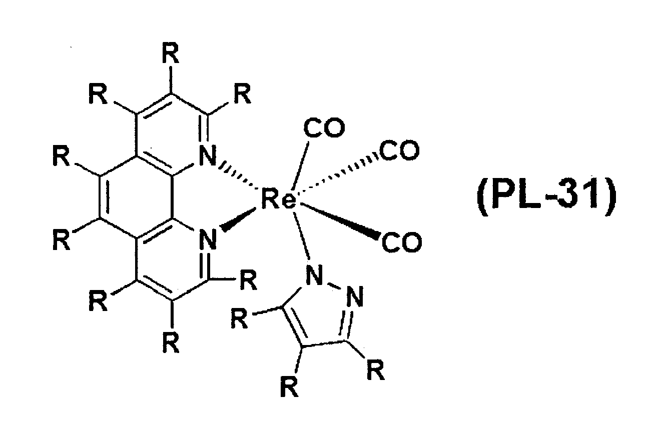

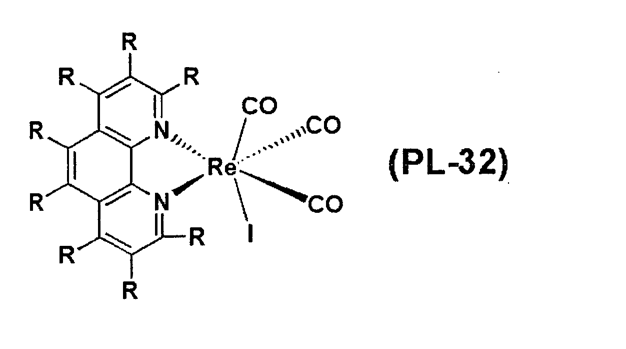

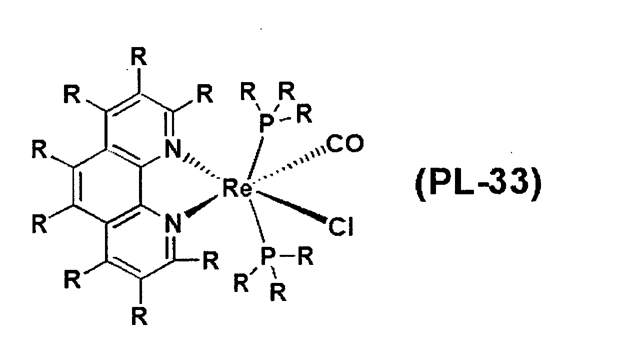

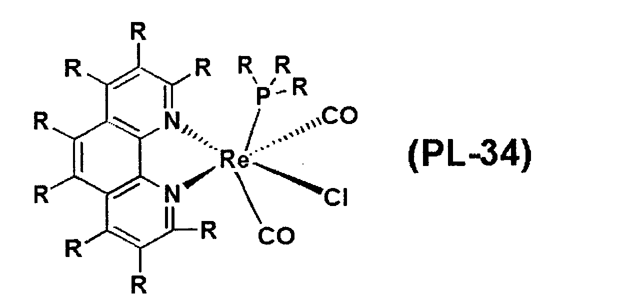

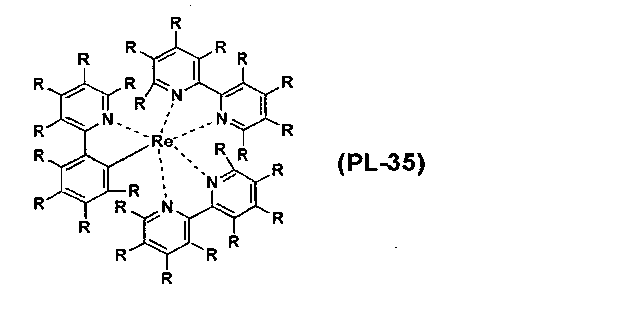

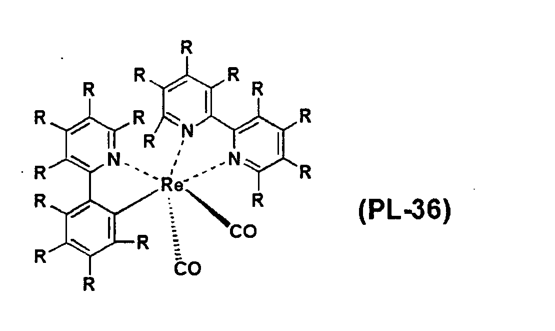

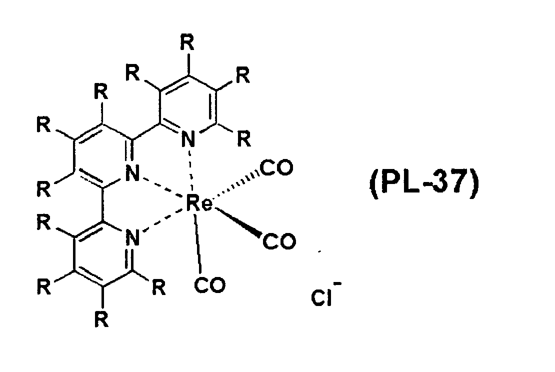

Additionally, examples include known compounds described in Jpn. J. Appl. Phys., 34, 1883 (1995), WO 01/41512, WO 03/33617, 04-2 Organic EL Study Group Proceedings (2004), WO 2005 113704, WO 2006 014599 and the like, and compound of the following structural formulae, and the like. 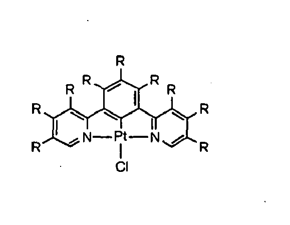 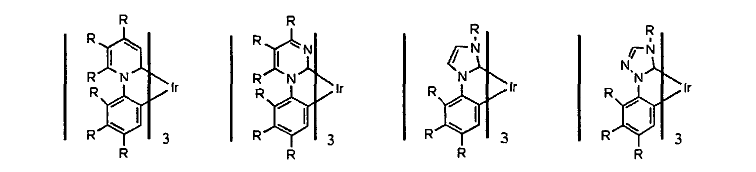 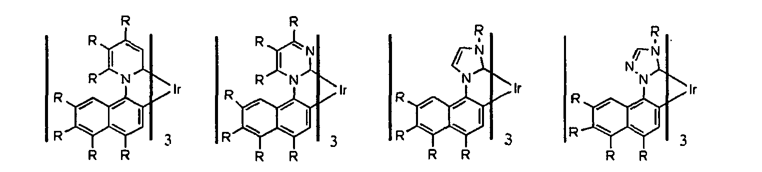 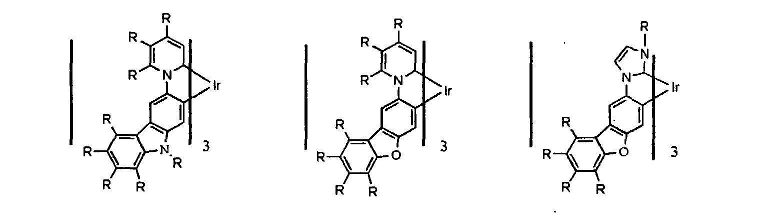 (in the formulae, R represents the same meaning as described above. A plurality of R's may be the same or different.).

Further, as the triplet compound, dendrimers showing light emission from the triplet excited state are more preferable. Here, the dendrimer showing light emission from the triplet excited state include, for example, compounds in which phosphorescence light emission is observed, and compounds in which fluorescence light emission is observed in addition to this phosphorescence light emission. Examples of the dendrimer are disclosed, for example, in WO 02/066552. As the light emission part of the dendrimer, for example, the metal complex structures described above are mentioned as examples.

Here, the dendrimer is constituted of a center molecule called core, and a side chain part called dendron. The branching number of the dendron part is called generation. Examples of the dendrimer is introduced in the literature (Kobunshi Vol. 47, Nov., p. 812, 1998) and WO02/066575, and designed and synthesized in order to have various functions. Examples of the dendrimer include those of the following formula.

CORE-[D¹]_{Z1}[D²]_{Z2}

(wherein, CORE represents a (Z1+Z2)-valent atom or atomic group, and Z1 and Z2 represent an integer of 1 or more. D¹ and D² each independently represent a dendron having a dendric structure, and when there exist a plurality of D¹'s and D²'s, they may be the same or different, and at least one of D¹ and D² is a conjugated system containing an aromatic ring optionally having a hetero atom.).

CORE represents a (Z1+Z2)-valent atom or atomic group, and for example, those described in IEEE2002, p195 (Conference proceeds), WO02/066575 and WO02/066552 are mentioned as examples.

The dendric structure mentioned above is disclosed, for example, in Kobunshi Vol. 52, Aug., p.578 (2003) and M&BE, Vol. 14, No. 3, p.169 (2003), and occasionally represented as a branched structure.

As the aromatic ring which may contain a heteroatom, a benzene ring, pyridine ring, pyrimidine ring, naphthalene ring, quinoline ring, isoquinoline ring, and rings such as carbazole, dibenzofurane, dibenzothiophene and the like, are mentioned as examples.

The dendrimer is further schematically represented as follows:

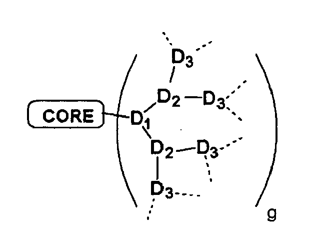

In the above figure, CORE represents a luminescent structural unit, for example, having a metal complex structure. D₁, D₂, and D₃ represent a dendron and are a unit of branching. Although the above figure shows branching units ranging to D3, the branching unit may repeat subsequently beyond D₃. Furthermore, the branching units may have a same or different structure. g is an integer of 1 or more, when g is 2 or more, the branching units belonging in the respective groups may be the same or different. The branching unit has, for example, structures such as trivalent aromatic ring, condensed ring and heterocycle and the like. Furthermore, the end of terminating the branching may have a surface group. The surface group is an atom other than a hydrogen atom, an alkyl group, an alkoxy group or the like.

In view of enhancing solubility, it is preferable that at least one of the surface groups on the dendrimer is the one other than a hydrogen atom.

A luminescent dendrimer among the dendrimers consists of a dendric multibranched structure having a luminescent structural unit at the center (CORE of the above-mentioned figure).

The mono-valent residual group of the triplet compound contained as an end group of the polymer compound of the present invention means a group remaining after removal of one hydrogen atom of the above-described triplet compound.

The polymer compound of the present invention may further contain in its main chain a di-valent or tri-valent residual group of a compound showing light emission from the triplet excited state. Here, the di-valent or tri-valent residual group of a triplet compound means a group remaining after removal of two or three hydrogen atoms from the above-described triplet compound.

When the polymer compound of the present invention contains in its main chain a tri-valent residual group of the above-described triplet compound, the polymer compound of the present invention has a branching at a position of the tri-valent residual group of the triplet compound.

When the polymer compound of the present invention contains in its main chain a di-valent or tri-valent residual group of the triplet compound, the number of the di-valent or tri-valent residual group of the triplet compound contained in the main chain may be one, or two or more of them may be contained as repeating units.

When the polymer compound of the present invention contains a di-valent or tri-valent residual group of a triplet compound as a repeating unit, the divalent or tri-valent residual group of a triplet compound is contained in an amount of preferably 0.01 to 60 mol, more preferably 0.1 to 25 mol, with respect to 100 mol of the sum of a repeating unit composed of an optionally substituted fluorenediyl group and a repeating unit composed of a phenylene group having one or more substituents.

The polymer compound of the present invention may further contain an arylene group or divalent heterocyclic group, having a mono-valent residual group of a compound showing light emission from the triplet excited state. Here, as the arylene group or divalent heterocyclic group, having a mono-valent residual group of a compound showing light emission from the triplet excited state, for example, groups of the following formula (8) are mentioned.

-Ar¹²- (8)

(in the formula, Ar¹² represents an arylene group, or a divalent heterocyclic group having one or more atoms selected from the group consisting of an oxygen atom, silicon atom, germanium atom, tin atom, phosphorus atom, boron atom, sulfur atom, selenium atom and tellurium atom. Ar¹² has 1 to 4 groups represented by -L-X. Here, X's independently represent a mono-valent residual group of a triplet compound, and when there exist a plurality of L's, they may be the same or different, and represent a single bond, - O-, -S-, -CO-, -CO₂-, -SO-, -SO₂-, - SiR¹⁰R¹⁰-, NR¹⁰-, -BR¹⁰-, -PR¹⁰-, - P(=O)(R¹⁰)-, optionally substituted alkylene group, optionally substituted alkenylene group, optionally substituted alkynylene group, optionally substituted arylene group, or optionally substituted di-valent heterocyclic group. When the alkylene group, alkenylene group and alkynylene group contain -CH₂- groups, one or more -CH₂- groups contained in the alkylene group, one or more -CH₂-groups contained in the alkenylene group and one or more -CH₂- groups container in the alkynylene group may each be substituted by a group selected from the group consisting of -O-, -S-, -CO-, -CO₂-, -SO-, -SO₂-, -SiR¹¹R¹¹-, NR¹¹-, -BR¹¹-, -PR¹¹- and P(=O)(R¹¹)-. Here, R¹⁰ and R¹¹ represent each independently a group selected from the group consisting of a hydrogen atom, alkyl group, aryl group, mono-valent heterocyclic group and cyano group, and these are the same as explained and exemplified for the substituent on the fluorenediyl group described above. Ar¹² may further have a substituent selected from the group consisting of an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, halogen atom, acyl group, acyloxy group, imine residue, amide group, acid imide group, mono-valent heterocyclic group, carboxyl group, substituted carboxyl group and cyano group, in addition to the group represented by -L-X. Examples of these substituents are the same as explained and exemplified for the substituent on the fluorenediyl group described above. When Ar¹² has a plurality of substituents, they may be the same or different.).

Examples of the arylene group as the divalent group represented by Ar¹² include a phenylene group, fluorenediyl group, benzofluorenediyl group, naphthylene group and the like, and example of the divalent heterocyclic group include pyridinylene group, pyrimidylene group and the like.

When the polymer compound of the present invention contains groups of the above-described formula (8), one group of the above-described formula (8) may be contained in the polymer compound, or two or more groups of the above-described formula (8) may be contained in the polymer compound as a repeating unit.

When the polymer compound of the present invention contains groups of the above-described formula (8) as a repeating unit, the repeating unit of the above-described formula (8) is contained in an amount of preferably 0.01 to 60 mol, more preferably 0.1 to 25 mol, with respect to 100 mol of the sum of a repeating unit composed of an optionally substituted fluorenediyl group and a repeating unit composed of a phenylene group having one or more substituents.

The polymer compound of the present invention may have a mono-valent residual group of a triplet compound as at least one of end groups of the polymer compound, and may contain a di-valent or tri-valent residual group of a triplet compound in the main chain, and further, may contain an arylene group or divalent heterocyclic group, having a mono-valent residual group of a triplet compound as a substituent. Further, it may contain a di-valent or tri-valent residual group of a triplet compound in the main chain and may contain an arylene group or divalent heterocyclic group, having a mono-valent residual group of a compound showing light emission from the triplet excited state as a substituent, or it may have a mono-valent residual group of a triplet compound as at least one of end groups of the polymer compound, and may contain an arylene group or divalent heterocyclic group, having a mono-valent residual group of a compound showing light emission from the triplet excited state as a substituent.

The polymer compound of the present invention may also contain a repeating unit other than the optionally substituted fluorenediyl group, phenylene group having one or more substituents and repeating units of the above-described formulae (1), (5) to (8), and may also contain a group other than the group of the above-described formula (2).

Repeating units in the polymer compound of the present invention may be connected by a non-conjugated structure, or the non-conjugated structure may be contained in the repeating units. Examples of this non-conjugated structure includethose shown below, and combinations of two or more of them, and the like. 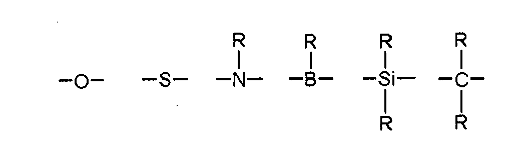 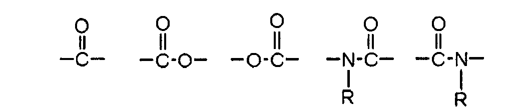 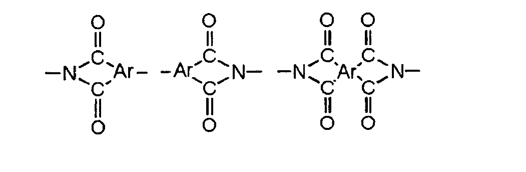 (in the formulae, R's are independently as defined above, and Ar represents a hydrocarbon group having 6 to 60 carbon atoms optionally containing a heteroatom. When there exist a plurality of R's, they may be the same or different.).

In the above-described formulae, the above-described heteroatom includes oxygen, sulfur, nitrogen, silicon, boron, phosphorus, selenium and the like.

The polymer compound of the present invention may be any of a random copolymerized polymer compound, graft copolymerized polymer compound and alternative copolymerized polymer compound. Further, those having branching in the main chain and thus having 3 or more end groups, and dendrimers are also included.

When the polymer compound of the present invention contains an optionally substituted fluorenediyl group, a phenylene group having one or more substituents and a repeating unit of the above-described formula (1), the amount of the optionally substituted fluorenediyl group is preferably 10 to 48 mol, more preferably 20 to 45 mol, with respect to 100 mol of the sum of all repeating units in the polymer compound. The amount of the phenylene group having one or more substituents is preferably 50 to 80 mol, more preferably 50 to 70 mol. The amount of the repeating unit of the above-described formula (1) is preferably 2 to 30 mol.

When the polymer compound of the present invention contains an optionally substituted fluorenediyl group, a phenylene group having one or more substituents and a group of the above-described formula (2), the amount of the optionally substituted fluorenediyl group is preferably 20 to 50 mol and the amount of the phenylene group having one or more substituents is preferably 50 to 80 mol, with respect to 100 mol of the sum of all repeating units in the polymer compound. The number of the group of the above-described formula (2) contained in the polymer compound is preferably 0.1 to 4 with respect to 100 of the total number of all repeating units.

One preferable embodiment of the polymer compound of the present invention includes polymer compounds containing a repeating unit of the above-described formula (1-2), a repeating unit of the above-described formula (3-2) and a repeating unit of the above-described formula (4-1), from the standpoint of high maximum luminous efficiency.

Another preferable embodiment of the polymer compound of the present invention includes polymer compounds containing a repeating unit of the above-described formula (3-2) and a repeating unit of the above-described formula (4-1) and having a group of the above-described formula (2-2) as at least one of end groups of the polymer compound, from the standpoint of high maximum luminous efficiency.

The polymer compound of the present invention has a polystyrene-equivalent number average molecular weight of usually about 1×10³ to 1×10⁸, preferably 1×10⁴ to 1×10⁶. The polystyrene-equivalent weight average molecular weight is usually about 3×10³ to 1×10⁸, and from the standpoint of film formability and from the standpoint of luminous efficiency when made into a device, it is preferably 5×10⁴ or more, further preferably 1×10⁵ or more, and from the standpoint of solubility of a polymer compound in an organic solvent, it is preferably 1×10⁵ to 5×10⁶. Even if a polymer compound having a number average molecular weight and a weight average molecular weight in such ranges is used singly to produce a device, and even if two kinds or more of such polymer compounds are used together to produce a device, the resultant device manifests high luminous efficiency. From the standpoint of enhancement of the film formability of a composition of the present invention, the degree of dispersion defined by weight average molecular weight/number average molecular weight is preferably 3 or less.

If a group correlated with polymerization (usually, called a polymerization active group) remains as a group situated at the end of the molecular chain of the polymer compound of the present invention (namely, end group), there is a possibility of decrease in the life and light emitting property when the composition is used in a light emitting device, thus, it is preferable that the end group is protected by a group of the above-described formula (2) or a mono-valent residual group of a triplet compound. Stable groups not correlated with polymerization other than the above-described groups may also be permissible, and those having a conjugated bond consecutive to the conjugated structure of the main chain of the molecular chain are preferable. For example, examples include structures having a bond to an aryl group or heterocyclic group via a carbon-carbon bond. Specific examples include, substituents described in chemical formula 10 of JP-A No. 9-45478, and the like.

It is expected to add various properties to a polymer compound by capping the end of the molecular chain of the polymer compound of the present invention with a group of the above-described formula (2) or an aromatic end group selected from a mono-valent residual group of a triplet compound, mono-valent heterocyclic group, mono-valent aromatic amine group and aryl group. As such properties, an effect of elongating the time necessary for decrease in the luminance of a device, an effect of enhancing charge injectability, charge transportability, light emitting property and the like, an effect of enhancing the compatibility and interaction between polymer compounds, an anchor-like effect, and the like, are mentioned.

For producing a polymer compound of the present invention, a compound having several reactive substituents as a monomer is, if necessary, dissolved in an organic solvent, and for example, an alkali and suitable catalyst are used, and the production can be performed at a temperature not lower than the melting point and not higher than the boiling point of the organic solvent. For example, known methods can be used described in "Organic Reactions", vol. 14, p. 270 to 490, John Wiley & Sons, Inc., 1965, "Organic Syntheses", Collective Volume VI, p. 407 to 411, John Wiley & Sons, Inc., 1988, Chem. Rev., vol. 95, p. 2457 (1995), J. Organomet. Chem., vol. 576, p. 147 (1999), Makromol. Chem., Macromol. Symp., vol. 12, p. 229 (1987), and the like.

In condensation polymerization in the method of producing a polymer compound of the present invention, production can be carried out by using a known condensation reaction. When a double bond is generated in condensation polymerization, for example, a method described in JP-A No. 5-202355 is mentioned. Namely, polymerization by the Wittig reaction of a compound having a formyl group and a compound having a phosphoniummethyl group, or of a compound having a formyl group and a phosphoniummethyl group, polymerization by the Heck reaction of a compound having a vinyl group and a compound having a halogen atom, polycondensation by a dehydrohalogenation method of a compound having two or more methyl monohalide groups, polycondensation by a sulfonium salt decomposition method of a compound having two or more sulfoniummethyl groups polymerization by the Knoevenagel reaction of a compound having a formyl group and a compound having a cyano group, polymerization by the McMurry reaction of compound having two or more formyl groups, and the like, are exemplified.

When the polymer compound of the present invention generates a triple bond in the main chain by condensation polymerization, for example, the Heck reaction can be utilized.

In the case of no generation of double bond or triple bond, for example, a method of polymerization by the Suzuki coupling reaction from the corresponding monomer, a method of polymerization by the Grignard method (Kyoritsu Publication, Polymer Functional Material Series Vol. 2, Synthesis and Reaction of Polymer (2), p. 432 to 433), a method of polymerization by a Ni(0) complex (Prog. Polym. Sci., vol. 17, p. 1153 to 1205, 1992), a method of polymerization with an oxidizer such as FeCl₃ and the like, a method of electrochemical oxidation polymerization (Maruzen, Experimental Chemistry IV, vol. 28, p. 339 to 340), a method by decomposition of an intermediate polymer having a suitable leaving group, and the like, are exemplified.

Of them, polymerization by the Wittig reaction, polymerization by the Heck reaction, polymerization by the Knoevenagel reaction, method of polymerization by the Suzuki coupling reaction, method of polymerization by the Grignard reaction and method of polymerization by a nickel 0-valent complex are preferable from the standpoint of easiness of control of the structure.

When the reactive substituent carried on a raw material monomer of a polymer compound to be used in the present invention is a halogen atom, alkyl sulfonate group, aryl sulfonate group or arylalkyl sulfonate group, a production method of performing condensation polymerization in the presence of a nickel 0-valent complex is preferable.

The raw material compound includes dihalogenated compounds, bis(alkyl sulfonate) compounds, bis(aryl sulfonate) compounds, bis(arylalkyl sulfonate) compounds or halogen-alkyl sulfonate compounds, halogen-aryl sulfonate compounds, halogen-arylalkyl sulfonate compounds, alkyl sulfonate-aryl sulfonate compounds, alkyl sulfonate-arylalkyl sulfonate compounds, and aryl sulfonate-arylalkyl sulfonate compounds.

When the reactive substituent carried on a raw material monomer of a polymer compound to be used in the present invention is a halogen atom, alkyl sulfonate group, aryl sulfonate group, arylalkyl sulfonate group,boronic acid group or boronate group, preferable is a production method in which the ratio of the sum of the mol number of halogen atom, alkyl sulfonate group, aryl sulfonate group and arylalkyl sulfonate group to the sum of the mol number of boronic acid group and boronate group is substantially 1 (usually, in the range of 0.7 to 1.2) and condensation polymerization is performed using a nickel catalyst or palladium catalyst.

As examples of combinations of raw material compounds, there are mentioned combinations of a dihalogenated compound, bis(alkyl sulfonate) compound, bis(aryl sulfonate) compound or bis(arylalkyl sufonate) compound with a diboronic acid compound or di boronate compound.

Further mentioned are a halogen-boronic acid compound, halogen-boronate compound, alkyl sulfonate-boronic acid compound, alkyl sulfonate-boronate compound, aryl sulfonate-boronic acid compound, aryl sulfonate-boronate compound, arylalkyl sulfonate-boronic acid compound, arylalkyl sulfonate-boronic acid compound and arylalkyl sulfonate-boronate compound.

The organic solvent differs depending on the compound to be used and the reaction and, and for suppressing a side reaction, in general, it is preferable that the solvent to be used is subjected to a sufficient deoxygenation treatment and the reaction is progressed in an inert atmosphere. Further, it is preferable to perform a dehydration treatment likewise. However, this shall not apply in the case of a reaction with water in a two-phase system such as the Suzuki coupling reaction.

For reacting, an alkali or suitable catalyst is appropriately added. These may be advantageously selected depending on the reaction to be used. As the alkali or catalyst, those which are sufficiently dissolved in the solvent used in the reaction are preferable. As the method of mixing an alkali or catalyst, there is exemplified a method in which a solution of an alkali or catalyst is added slowly while stirring the reaction liquid under an inert atmosphere such as argon and nitrogen and the like, or reversely, the reaction liquid is slowly added to a solution of an alkali or catalyst.

When the polymer compound of the present invention is used in a polymer light emitting device and the like, the purity of the polymer compound exerts an influence on the device performances such as light emitting property and the like, thus, it is preferable to purify the monomer before polymerization by a method such as distillation, sublimation purification, re-crystallization and the like, then, to polymerize the monomer. Further, it is preferable, after synthesis, to carry out a purification treatment such as re-precipitation purification, chromatographic fractionation and the like.

### <Composition>

The composition of the present invention comprises the above-described polymer compound, and the above-described compound showing light emission from the triplet excited state (triplet compound).

In the composition of the present invention, the proportion of the above-described polymer compound and the above-described triplet compound is not particularly restricted since it varies depending on the kind of the polymer compound to be combined and the property to be optimized, and the proportion of the above-described triplet compound is usually 0.01 to 50 parts by weight, preferably 0.1 to 40 parts by weight, more preferably 5 to 40 parts by weight with respect to 100 parts by weight of the above-described polymer compound.

In the composition of the present invention, the above-described polymer compound and the above-described triplet compound may be used singly or in combination with another or more.

The composition of the present invention may further contain at least one material selected from the group consisting of hole transporting materials, electron transporting materials and light emitting materials.

As the light emitting material which may be contained in the composition of the present invention, there are mentioned low molecular weight fluorescent materials, or polymer compounds not having the above-described repeating unit of the formula (1) and the above-described group of the formula (2).

The low molecular weight fluorescent material which may be contained in the composition of the present invention usually shows a photoluminescence emission peak in the wavelength range of 400 to 700 nm. The molecular weight of the low molecular weight fluorescent material is usually less than 3000, preferably about 100 to 1000, more preferably about 100 to 500.

Examples of the above-described low molecular weight fluorescent material include low molecular weight fluorescent materials such as naphthalene derivatives, anthracene, anthracene derivatives, perylene, perylene derivatives, polymethine coloring matters, xanthene coloring matters, coumarin coloring matters, cyanine coloring matters, metal complexes having a metal complex of 8-hydroxyquinoline as a ligand, metal complexes having a 8-hydroxyquinoline derivative as a ligand, other fluorescent metal complexes, aromatic amines, tetraphenylcyclopentadiene, tetraphenylcyclopentadiene derivatives, tetraphenylcyclobutadiene, tetraphenylcyclobutadiene derivatives, ,stilbenes, silicon-containing aromatics, oxazoles, furoxans, thiazoles, tetraarylmethanes, thiadiazoles, pyrazoles, metacyclophanes, acetylenes and the like. Specific examples thereof include those described in JP-A Nos. 57-51781, 59-194393 and the like, and known materials.Hereinafter, in examples of the low molecular weight fluorescent material, R in the formulae represents the same meaning as described above, and particularly, represents preferably a hydrogen atom, alkyl group, monovalent heterocyclic group, substituted amino group, cyano group or halogen atom. A hydrogen atom contained in these substituents may be substituted by a fluorine atom.

As the polymer compound not having the above-described repeating unit of the formula (1) and not having the above-described group of the formula (2), there are mentioned a polymer compound having only the above-described repeating unit of the formula (3), a polymer compound having only the above-described repeating unit of the formula (3) and the above-described repeating unit of the formula (4), a polymer compound having only the above-described repeating unit of the formula (3) and the above-described repeating unit of the formula (5), a polymer compound having only the above-described repeating unit of the formula (5), and the like.

Examples of the hole transporting material which may be contained in the composition of the present invention include polyvinylcarbazole and derivatives thereof, polysilane and derivatives thereof, polysiloxane derivatives having an aromatic amine on the side chain or main chain, pyrazoline derivatives, arylamine derivatives, stilbene derivatives,triphenyldiamine derivatives, polyaniline and derivatives thereof, polythiophene and derivatives thereof, polypyrrole and derivatives thereof, poly(p-phenylenevinylene) and derivatives thereof, poly(2,5-thienylenevinylene) and derivatives thereof, and the like.

Examples of the electron transporting material which may be contained in the composition of the present invention include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, and the like.

Additionally, the composition of the present invention may contain a solvent, stabilizer, additives for controlling viscosity and/or surface tension, antioxidant and the like. These optional components may be used each singly or in combination with another or more.

Examples of the stabilizer which may be contained in the composition of the present invention include phenol antioxidants, phosphorus antioxidants and the like.

As the additives for controlling viscosity and/or surface tension which may be contained in the composition of the present invention, for example, a high molecular weight compound for increasing viscosity (thickening agent) and a poor solvent, a low molecular weight compound for decreasing viscosity, a surfactant for decreasing surface tension, and the like may be appropriately combined and used.

As the above-described high molecular weight compound, those not disturbing light emission and charge transportation may be permissible, and when the composition contains a solvent, usually, these are soluble in the solvent. As the high molecular weight compound, for example, polystyrene of high molecular weight, polymethyl methacrylate of high molecular weight, and the like can be used. The above-described high molecular weight compound has a polystyrene equivalent number average molecular weight of preferably 500000 or more, more preferably 1000000 or more. Also a poor solvent can be used as a thickening agent. That is, when the composition of the present invention contains a solvent (namely, in the case of liquid composition described later), the viscosity of the composition can be enhanced by adding a smaller amount of poor solvent than the amount of solid components in the composition. In the case of adding a poor solvent for this purpose, the kind of the,poor solvent and the addition amount thereof may be advantageously selected in a range not causing deposition of solid components in the composition. When also stability in preservation is taken into consideration, the amount of the poor solvent is preferably 50 wt% or less, more preferably 30 wt% or less with respect to the whole composition.

As the antioxidant which may be contained in the composition of the present invention, those not disturbing light emission and charge transportation may be permissible, and when the composition contains a solvent, usually, these are soluble in the solvent. Examples of the antioxidant include phenol antioxidants, phosphorus antioxidants and the like. By use of the antioxidant, preservation stability of the composition of the present invention and the solvent can be improved.

When the composition of the present invention contains a hole transporting material, the proportion of the hole transporting material in the composition is usually 1 wt% to 80 wt%, preferably 5 wt% to 60 wt%. When the composition of the present invention contains an electron transporting material, the proportion of the electron transporting material in the composition is usually 1 wt% to 80 wt%, preferably 5 wt% to 60 wt%

### <Liquid composition>

The composition of the present invention is useful for light emitting devices such as polymer light emitting devices and the like, particularly as a liquid composition.

The liquid composition is composed of the composition of the present invention containing if necessary a solvent. In this specification, "liquid composition" means a composition which is liquid in device manufacturing, and typically, one which is liquid at normal pressure (namely, 1 atm) and 25°C. The liquid composition is, in general, referred to as ink, ink composition, solution or the like in some cases.

In the case of film formation using this liquid composition (for example, composition in solution condition) in producing a polymer light emitting device, it may be advantageous to only remove a solvent by drying after application of the liquid composition, and also in the case of mixing of a charge transporting material and a light emitting material, the same means can be applied, that is, this method is extremely advantageous for production. In drying, drying may be effected under heating at about 50 to 150°C, alternatively, drying may be carried out under reduced pressure of about 10⁻³ Pa.

As the film formation method from liquid composition, application methods such as a spin coat method, casting method, micro gravure coat method, gravure coat method, bar coat method, roll coat method, wire bar coat method, dip coat method, slit coat method, capillary coat method, spray coat method, screen printing method, flexo printing method, offset printing method, inkjet printing method, nozzle coat method, dispenser method, micro dispenser method and the like can be used.

From the standpoint of easiness of pattern formation and multi-color separate painting, preferable are printing methods such as a screen printing method, flexo printing method, offset printing method, ink jet printing method and the like.

From the standpoint of use efficiency of a solution, an ink jet printing method, nozzle coat method and dispenser method are preferable.

From the standpoint of film formation speed, a micro gravure coat method, spin coat method, flexo printing method and offset printing method are preferable.

The proportion of a solvent in the liquid composition is usually 1 wt% to 99.9 wt%, preferably 60 wt% to 99.9 wt%, further preferably 90 wt% to 99.8 wt% with respect to the total weight of the liquid composition. Though the viscosity of the liquid composition varies depending on the printing method, the viscosity at 25°C is preferably in the range of 0.5 to 500 mPa•s, and when a liquid composition passes through a discharge apparatus such as in an inkjet printing method and the like, the viscosity at 25°C is preferably in the range of 0.5 to 20 mPa•s, for preventing clogging and flying curving in discharging. The sum of the weight of a polymer compound containing a repeating unit of the formula (1) and the weight of a low molecular weight fluorescent material is usually 20 wt% to 100 wt%, preferably 40 wt% to 100 wt% with respect to the total weight of all components remaining after removal of a solvent from the liquid composition.

As the solvent contained in the liquid composition, those capable of dissolving or dispersing components other than the solvent in the composition are preferable. Examples of the solvent include chlorinated solvents such as chloroform, methylene dichloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene, trimethylbenzene, mesitylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, methyl benzoate, ethylcellosolve acetate and the like, polyols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexane diol and the like, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide, and the like. These solvents may be used singly or in combination with another or more. Among the above-described solvents, one or more organic solvents having a structure containing at least one benzene ring and having a melting point of 0°C or lower and a boiling point of 100°C or higher are preferably contained from the standpoint of viscosity, film formability and the like.

Regarding the kind of the solvent, aromatic hydrocarbon solvents, aliphatic hydrocarbon solvents, ester solvents and ketone solvents are preferable from the standpoint of solubility of components other than the solvent in a liquid composition into the organic solvent, uniformity in film formation, viscosity property and the like, and preferable are toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone and dicyclohexyl ketone, and it is more preferable to contain at least one of xylene, anisole, mesitylene, cyclohexylbenzene and bicyclohexyl, methyl benzoate.

The number of the solvent to be contained in the liquid composition is preferably 2 or more, more preferably 2 to 3, further preferably 2 from the standpoint of film formability and from the standpoint of device properties and the like.

When two solvents are contained in the liquid composition, one of them may be solid at 25°C. From the standpoint of film formability, it is preferable that one solvent has a boiling point of 180°C or higher and another solvent has a boiling point of lower than 180°C, and it is more preferable that one solvent has a boiling point of 200°C or higher and another solvent has a boiling point of lower than 180°C. From the standpoint of viscosity, it is preferable that 0.2 wt% or more of components excepting solvents from the liquid composition are dissolved at 60°C in solvents, and it is preferable that 0.2 wt% or more of components excepting solvents from the liquid composition are dissolved at 25°C in one of two solvents.

When three solvents are contained in the liquid composition, one or two of them may be solid at 25°C. From the standpoint of film formability, it is preferable that at least one of three solvents has a boiling point of 180°C or higher and at least one solvent has a boiling point of lower than 180°C, and it is more preferable that at least one of three solvents has a boiling point of 200°C or higher and 300°C or lower and at least one solvent has a boiling point of lower than 180°C. From the standpoint of viscosity, it is preferable that 0.2 wt% or more of components excepting solvents from the liquid composition are dissolved at 60°C in two of three solvents, and it is preferable that 0.2 wt% or more of components excepting solvents from the liquid composition are dissolved at 25°C in one of three solvents.

When two or more solvents are contained in the liquid composition, the content of a solvent having highest boiling point is preferably 40 to 90 wt%, more preferably 50 to 90 wt%, further preferably 65 to 85 wt% with respect to the weight of all solvents contained in the liquid composition, from the standpoint of viscosity and film formability.

As the solvent contained in the liquid composition, a combination of anisole and bicyclohexyl, a combination of anisole and cyclohexylbenzene, a combination of xylene and bicyclohexyl, a combination of xylene and cyclohexylbenzene, and a combination of mesitylene and methyl benzoate are preferable from the standpoint of viscosity and film formability.

From the standpoint of solubility of components other than a solvent contained in the liquid composition into the solvent, the difference between the solubility parameter of the solvent and the solubility parameter of the polymer compound contained in the composition of the present invention is preferably 10 or less, more preferably 7 or less. The solubility parameters can be measured by a method described in "Solvent Handbook (published by KODANSHA Co., Ltd., 1976)".

### <Thin film>

Next, the thin film of the present invention will be illustrated. This thin film is obtained by using the above-described composition, the above-described polymer compound or the above-described liquid composition. Examples of the thin film include a luminous thin film, electric conductive thin film and organic semiconductor thin film.

The luminous thin film has a quantum yield of light emission of preferably 50% or more, more preferably 60% or more, further preferably 70% or more from the standpoint of the luminance, light emission voltage and the like of a device.

The electric conductive thin film preferably has a surface resistance of 1 KΩ/□ or less. By doping a thin film with a Lewis acid, ionic compound or the like, electric conductivity can be enhanced. The surface resistance is more preferably 100 Ω/□ or less, further preferably 10 Ω/□ or less.

In the organic semiconductor thin film, it is preferable that either electron mobility or hole mobility is larger, and its value is preferably 10⁻⁵ cm²/Vs or more, more preferably 10⁻³ cm²/Vs or more, and further preferably 10⁻¹ cm²/Vs or more.

### <Use of polymer compound, composition>

Next, uses of the polymer compound and composition (including liquid composition) of the present invention will be illustrated.

The polymer compound and composition of the present invention usually emit light in solid state and can be used as a polymer light emitter (namely, light emitting material of high molecular weight). The composition of the present invention has an excellent charge transporting ability, and can be suitably used as a material for organic EL device containing a polymer compound (hereinafter, abbreviated as "polymer light emitting device" in some cases) or as a charge transporting material. The polymer light emitting device using this polymer light emitter is a high performance polymer light emitting device which can be driven with high luminous efficiency. Therefore, the composition of the present invention is useful as a sheet light source such as a curved light source, flat light source and the like (for example, for illumination and the like); a material of displays such as segment displays (for example, segment type display and the like), dot matrix displays (for example, dot matrix flat display and the like), liquid crystal displays (for example, liquid crystal display, back light for liquid crystal display, and the like) and so on. The composition of the present invention can also be used as a coloring matter for laser, a material for organic solar battery, a material for conductive thin film such as an electric conductive thin film, organic semiconductor thin film and the like, a luminous thin film material, and the like.

### <Polymer light emitting device>

Next, the polymer light emitting device of the present invention will be described.

The polymer light emitting device of the present invention has electrodes composed of an anode and a cathode, and an organic layer provided between the electrodes and having the above-described composition and/or the above-described polymer compound (namely, a layer containing an organic substance). The above-described organic layer may be any of a light emitting layer, hole transporting layer, electron transporting layer and the like, and it is preferable that the organic layer is a light emitting layer. The polymer light emitting device of the present invention includes also those in which the composition of the present invention is contained in a hole transporting layer and/or an electron transporting layer.

The light emitting layer is a layer having a function of emitting light. The hole transporting layer is a layer having a function of transporting holes. The electron transporting layer is a layer having a function of transporting electrons. The hole transporting layer and the electron transporting layer are collectively called a charge transporting layer. The light emitting layers, hole transporting layers and electron transporting layers may each be independently present in combination with another or more.

When the polymer light emitting device of the present invention has a light emitting layer, the thickness of the light emitting layer shows an optimum value varying depending on the material to be used, and may be advantageously selected so as to give appropriate values of driving voltage and luminous efficiency, and is, for example, 1 nm to 1 µm, preferably 2 nm to 500 nm, further preferably 5 nm to 200 nm.

As the method for forming a light emitting layer, for example, a method of film formation from a liquid composition is mentioned.

For film formation from a liquid composition, application methods such as a spin coat method, casting method, micro gravure coat method, gravure coat method, bar coat method, roll coat method, wire bar coat method, dip coat method, spray coat method, screen printing method, flexo printing method, offset printing method, inkjet printing method and the like can be used. Printing methods such as a screen printing method, flexo printing method, offset printing method, inkjet printing method and the like are preferable since pattern formation and multicolor separate painting are easy.

The polymer light emitting device of the present invention manifests a maximum outer quantum yield of preferably 1% or more, more preferably 1.5% or more when voltage is applied between an anode and a cathode, from the standpoint of device luminance and the like.

Examples of the polymer light emitting device of the present invention include a polymer light emitting device having an electron transporting layer between a cathode and a light emitting layer, a polymer light emitting device having a hole transporting layer between an anode and a light emitting layer, a polymer light emitting device having an electron transporting layer between a cathode and a light emitting layer, and having a hole transporting layer between an anode and a light emitting layer, and the like.

Examples of the polymer light emitting device of the present invention include the following structures a) to d).
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode
(wherein, / means adjacent lamination of layers, applicable also in the followings)

When the composition of the present invention is used in a hole transporting layer, it is preferable that the composition of the present invention contains a polymer compound having a hole transportable group (for example, aromatic amino group, thienyl group and the like), or a polymer compound containing a repeating unit of the formula (1) has the above-described hole transportable group. Examples of the polymer compound containing the hole transportable group include polymers containing an aromatic amine, polymers containing stilbene, and the like.

When the composition of the present invention is used in an electron transporting layer, it is preferable that the composition of the present invention contains a polymer compound having an electron transportable group (for example, oxadiazole group, oxathiadiazole and the like), or a polymer compound containing a repeating unit of the formula (1) has the above-described electron transportable group. Examples the polymer compound containing the electron transportable group include polymer compounds containing oxadiazole, polymer compounds containing triazole, polymer compounds containing quinoline, polymer compounds containing quinoxaline, polymer compounds containing benzothiadiazole, and the like.

When the polymer light emitting device of the present invention has a hole transporting layer, hole transporting materials (including those of low molecular weight and those of high molecular weight) are usually used in the hole transporting layer. As this hole transporting material, mentioned are those exemplified for the hole transporting material which may be contained in the composition of the present invention described above.

Examples of the hole transporting material include those described in JP-A Nos. 63-70257, 63-175860, 2-135359, 2-135361, 2-209988, 3-37992 and 3-152184, and the like.

Among them, preferable as the hole transporting material used in a hole transporting layer are high molecular weight hole transporting materials such as polyvinylcarbazole and its derivatives, polysilane and its derivatives, polysiloxane derivatives having an aromatic amine compound group on the side chain or main chain, polyaniline and its derivatives, polythiophene and its derivatives, poly(p-phenylenevinylene) and its derivatives, poly(2,5-thienylenevinylene) and its derivatives, and the like, and further preferable are polyvinylcarbazole and its derivatives, polysilane and its derivatives, and polysiloxane derivatives having an aromatic amine on the side chain or main chain.

Examples of the hole transporting material of low molecular weight include pyrazoline derivatives, arylamine derivatives, stilbene derivatives and triphenyldiamine derivatives. In the case of the hole transporting material of low molecular weight, it is preferably dispersed in a polymer binder in use.

The polymer binder is preferably one which does not extremely disturb charge transportation, and those showing not strong absorption of visible light are suitably used. Examples of the polymer binder include poly(N-vinylcarbazole), polyaniline and its derivatives, polythiophene and its derivatives, poly(p-phenylenevinylene) and its derivatives, poly(2,5-thienylenevinylene) and its derivatives, polycarbonate, polyacrylate, polymethyl acrylate, polymethyl methacrylate, polystyrene, polyvinyl chloride, polysiloxane and the like.

Polyvinylcarbazole and its derivatives can be obtained, for example, from a vinyl monomer by cation polymerization or radical polymerization.

Examples of the polysilane and its derivatives include compounds described in Chem. Rev., vol. 89, p. 1359 (1989), GB Patent No. 2300196 publication, and the like. Also as the synthesis method, methods described in them can be used, and particularly, the Kipping method is suitably used.

In the polysiloxane and its derivatives, the siloxane skeleton structure shows little hole transportability,thus, those having a structure of the above-described hole transporting material of low molecular weight on the side chain or main chain are suitably used Particularly, those having a hole transportable aromatic amine on the side chain or main chain are exemplified.

The film formation method of a hole transporting layer is not particularly restricted, and in the case of a hole transporting material of low molecular weight, a method of film formation from a mixed solution with a polymer binder is exemplified. In the case of a hole transporting material of high molecular weight, a method of film formation from a solution (that is, mixture of hole transporting material with solvent) is exemplified.

As the solvent used for film formation from a solution, those which can dissolve or uniformly disperse a hole transporting material are preferable. Exemplified of the solvent include chlorinated solvents such as chloroform, methylene dichloride, 1,2-dichloroethane, 1,1,2-trichloroethane, chlorobenzene, o-dichlorobenzene and the like, ether solvents such as tetrahydrofuran, dioxane and the like, aromatic hydrocarbon solvents such as toluene, xylene and the like, aliphatic hydrocarbon solvents such as cyclohexane, methylcyclohexane, n-pentane, n-hexane, n-heptane, n-octane, n-nonane, n-decane and the like, ketone solvents such as acetone, methyl ethyl ketone, cyclohexanone and the like, ester solvents such as ethyl acetate, butyl acetate, ethylcellosolve acetate and the like, polyols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol and the like, alcohol solvents such as methanol, ethanol, propanol, isopropanol, cyclohexanol and the like, sulfoxide solvents such as dimethyl sulfoxide and the like, amide solvents such as N-methyl-2-pyrrolidone, N,N-dimethylformamide and the like. These organic solvents may be used singly or in combination with another or more.

As the method for film formation from a solution, there can be used application methods from a solution such as a spin coat method, casting method, micro gravure coat method, gravure coat method, bar coat method, roll coat method, wire bar coat method, dip coat method, spray coat method, screen printing method, flexo printing method, offset printing method, inkjet printing method and the like.

Regarding the thickness of a hole transporting layer, the optimum value varies depending on the material to be used, and it may be advantageously selected so that the driving voltage and luminous efficiency show suitable values, and a thickness at least not causing formation of pinholes is necessary, and when the thickness is too large, the driving voltage of a device increases undesirably. Therefore, the thickness of the hole transporting layer is usually 1 nm to 1 µm, preferably 2 nm to 500 nm, further preferably 5 nm to 200 nm.

When the polymer light emitting device of the present invention has an electron transporting layer, electron transporting materials (including those of low molecular weight and those of high molecular weight) are usually used in the electron transporting layer. As this electron transporting material, mentioned are those exemplified for the electron transporting material which may be contained in the composition of the present invention described above.

Examplse of the electron transporting material include those described in JP-A Nos. 63-70257, 63-175860, 2-135359, 2-135361, 2-209988, 3-37992 and 3-152184, and the like.

Of them, oxadiazole derivatives, benzoquinone and its derivatives, anthraquinone and its derivatives, metal complexes of 8-hydroxyquinoline and its derivatives, polyquinoline and its derivatives, polyquinoxaline and its derivatives, polyfluorene and its derivatives are preferable, and 2-(4-biphenylyl)-5-(4-t-butylphenyl)-1,3,4-oxadiazole, benzoquinone, anthraquinone, tris(8-quinolinol)aluminum and polyquinoline are further preferable.

The film formation method of an electron transporting layer is not particularly restricted, and in the case of an electron transporting material of low molecular weight, examples include a vacuum vapor-deposition method from powder, film formation methods from solution or melted conditions, and in the case of an electron transporting material of high molecular weight,examples include film formation methods from solution or melted condition, respectively. In film formation from solution or melted condition, the above-described polymer binder may be used together.

As the solvent used for film formation from a solution, compounds which can dissolve or uniformly disperse an electron transporting material and/or polymer binder are preferable. As examples of the solvent, those exemplified as the solvent to be used for film formation of a hole transporting layer from a solution in the column of the above-described hole transporting layer are mentioned. The solvents may be used singly or in combination with another or more.

As the film formation method from solution or melted condition, mentioned are those exemplified as the film formation method of a hole transporting layer from a solution in the column of the above-described hole transporting layer.

Regarding the thickness of an electron transporting layer, the optimum value varies depending on the material to be used, and it may be advantageously selected so that the driving voltage and luminous efficiency show suitable values, and a thickness at least not causing formation of pinholes is necessary, and when the thickness is too large, the driving voltage of a device increases undesirably. Therefore, the thickness of the electron transporting layer is usually 1 nm to 1 µm, preferably 2 nm to 500 nm, further preferably 5 nm to 200 nm.

Among hole transporting layers and electron transporting layers provided next to an electrode, those having a function of improving charge injecting efficiency from an electrode and having an effect of lowering the driving voltage of a device are, in particularly, called generally a hole injection layer and an electron injection layer, respectively (hereinafter, these are collectively called "charge injection layer" in some cases).

Further, for improving close adherence with an electrode or improving charge injection from an electrode, the above-described charge injection layer or an insulation layer may be provided next to the electrode, alternatively, for improving close adherence of an interface or preventing mixing, a thin buffer layer may be inserted into an interface of a charge transporting layer and a light emitting layer.

The order and number of layers to be laminated, and thickness of each layer can be appropriately determined in view of luminous efficiency and device life.

In the present invention, examples of the polymer light emitting device carrying a provided charge injection layer include polymer light emitting devices having a charge injection layer provided next to a cathode and polymer light emitting devices having a charge injection layer next to an anode. Examples of the structure of the polymer light emitting device include the following structures e) to p).
e) anode/hole injection layer/light emitting layer/cathode
f) anode/light emitting layer/electron injection layer/cathode
g) anode/hole injection layer/light emitting layer/electron injection layer/cathode
h) anode/hole injection layer/hole transporting layer/light emitting layer/cathode
i) anode/hole transporting layer/light emitting layer/electron injection layer/cathode
j) anode/hole injection layer/hole transporting layer/light emitting layer/electron injection layer/cathode
k) anode/hole injection layer/light emitting layer/electron transporting layer/cathode
l) anode/light emitting layer/electron transporting layer/electron injection layer/cathode
m) anode/hole injection layer/light emitting layer/electron transporting layer/electron injection layer/cathode
n) anode/hole injection layer/hole transporting layer/light emitting layer/electron transporting layer/cathode
o) anode/hole transporting layer/light emitting layer/electron transporting layer/electron injection layer/cathode
p) anode/hole injection layer/hole transporting layer/light emitting layer/electron transporting layer/electron injection layer/cathode

The polymer light emitting device of the present invention includes also those in which a polymer compound of the present invention is contained in a hole transporting layer and/or electron transporting layer, as described above. The polymer light emitting device of the present invention includes also those in which a polymer compound of the present invention is contained in a hole injection layer and/or electron injection layer.

When the composition of the present invention is used in a hole injection layer, it is preferable that the compound is used collectively with an electron receptive compound. When the composition of the present invention is used in an electron transporting layer, it is preferable that the compound is used collectively with an electron donating compound. Here, for collective use, there are methods such as mixing, copolymerization, introduction as a side chain, and the like.

As examples of the charge injection layer, mentioned are a layer containing an electric conductive polymer, a layer provided between an anode and a hole transporting layer and containing a material having ionization potential of a value between an anode material and a hole transporting material contained in a hole transporting layer, a layer provided between a cathode and an electron transporting layer and containing a material having electron affinity of a value between a cathode material and an electron transporting material contained in an electron transporting layer, and the like.

When the charge injection layer contains an electric conductive polymer, the electric conductivity of the electric conductive polymer is preferably 10⁻⁵ S/cm or more and 10³ S/cm or less, and for decreasing leak current between light emission pixels, more preferably 10⁻⁵ S/cm or more and 10² or less, further preferably 10⁻⁵ S/cm or more and 10¹ or less. Usually, for controlling the electric conductivity of the electric conductive polymer to 10⁻⁵ S/cm or more and 10³ or less, the electric conductive polymer is doped with a suitable amount of ions.

As the kind of ions to be doped, an anion is used in a hole injection layer and a cation is used in an electron injection layer. Examples of the anion include a polystyrenesulfonic ion, alkylbenzenesulfonic ion, camphorsulfonic ion and the like. Examples of the cation include a lithium ion, sodium ion, potassium ion, tetrabutylammonium ion and the like.

The thickness of the charge injection layer is usually 1 nm to 100 nm, preferably 2 nm to 50 nm.

The material used in the charge injection layer may be appropriately selected depending on a relation with the material of an electrode and an adjacent layer, and exemplified are polyaniline and its derivatives, polythiophene and its derivatives, polypyrrole and its derivatives, polyphenylenevinylene and its derivatives, polythienylenevinylene and its derivatives, polyquinoline and its derivatives, polyquinoxaline and its derivatives, electric conductive polymers such as polymers containing an aromatic amine structure on the side chain or main chain, metal phthalocyanine (copper phthalocyanine and the like), carbon and the like.

The insulation layer usually has a thickness of 0.5 to 4.0 nm, and has a function of rendering charge injection easy. The material of the insulation layer includes metal fluorides, metal oxides, organic insulation materials and the like.

The polymer light emitting device carrying an insulation layer includes a polymer light emitting device in which an insulation layer is provided next to a cathode, and a polymer light emitting device in which an insulation layer is provided next to an anode, and as examples thereof, devices having the following structures q) to ab) are mentioned.
q) anode/insulation layer/light emitting layer/cathode .
r) anode/light emitting layer/insulation layer/cathode
s) anode/insulation layer/light emitting layer/insulation layer/cathode
t) anode/insulation layer/hole transporting layer/light emitting layer/cathode
u) anode/hole transporting layer/light emitting layer/insulation layer/cathode
v) anode/insulation layer/hole transporting layer/light emitting layer/insulation layer/cathode
w) anode/insulation layer/light emitting layer/electron transporting layer/cathode
x) anode/light emitting layer/electron transporting layer/insulation layer/cathode
y) anode/insulation layer/light emitting layer/electron transporting layer/insulation layer/cathode
z) anode/insulation layer/hole transporting layer/light emitting layer/electron transporting layer/cathode
aa) anode/hole transporting layer/light emitting layer/electron transporting layer/insulation layer/cathode
ab) anode/insulation layer/hole transporting layer/light emitting layer/electron transporting layer/insulation layer/cathode

The polymer light emitting device of the present invention contains a composition of the present invention in any of the hole injection layer, hole transporting layer, light emitting layer, electron transporting layer and electron injection layer, in the above-exemplified device structures a) to ab).

The polymer light emitting device of the present invention is usually formed on a substrate. This substrate may advantageously be one forming an electrode and which does not change in forming a layer of an organic substance. Examples of the material of the substrate include glass, plastic, polymer film, silicon substrate and the like. In the case of an opaque substrate, it is preferable that the opposite electrode (namely, an electrode farther from the substrate) is transparent or semi-transparent. Usually, at least one of an anode and a cathode contained in a polymer light emitting device of the present invention is transparent or semi-transparent. It is preferable that an anode side is transparent or semi-transparent.

As the material of the anode, an electric conductive metal oxide film, semi-transparent metal thin film and the like are used, and examples thereof include indium oxide, zinc oxide, tin oxide, and composite thereof: indium•tin•oxide (ITO), films (NESA and the like) formed using electric conductive glass composed of indium•zinc•oxide etc., gold, platinum, silver, copper and the like are used, and ITO, indium•zinc•oxide, tin oxide are preferable. As the anode manufacturing method, a vacuum vapor-deposition method, sputtering method, ion plating method, plating method and the like are mentioned. As the anode, organic transparent electric conductive films made of polyaniline and its derivative, polythiophene and its derivative, and the like may be used.

The thickness of an anode can be appropriately selected in view of light transmission and electric conductivity, and it is usually 10 nm to 10 µm, preferably 20 nm to 1 µm, further preferably 50 nm to 500 nm.

For making charge injection easy, a layer made of a phthalocyanine derivative, electric conductive polymer, carbon and the like, or a layer made of a metal oxide, metal fluoride, organic insulation material and the like, may be provided on an anode.

As the material of a cathode, materials of small work function are preferable. For example, metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys made of two or more of them, or alloys made of at least one of them and at least one of gold, silver, platinum, copper, manganese, titanium, cobalt, nickel, tungsten and tin, graphite or graphite intercalation compounds and the like are used. Examples of the alloy include magnesium-silver alloy, magnesium-indium alloy, magnesium-aluminum alloy, indium-silver alloy, lithium-aluminum alloy, lithium-magnesium alloy, lithium-indium alloy, calcium-aluminum alloy and the like. The cathode may take a laminated structure including two or more layers.

The thickness of a cathode can be appropriately selected in view of electric conductivity and durability, and it is, for example, 10 nm to 10 µm, preferably 20 nm to 1 µm, further preferably 50 nm to 500 nm.

As the cathode manufacturing method, a vacuum vapor-deposition method, sputtering method, lamination method of thermally press-bonding a metal thin film, and the like are used. A layer made of an electric conductive polymer, or a layer made of a metal oxide, metal fluoride, organic insulation material and the like, may be provided between a cathode and an organic substance layer, and after manufacturing a cathode, a protective layer for protecting the polymer light emitting device may be installed. For use of the polymer light emitting device stably for a long period of time, it is preferable to provide a protective layer and/or protective cover, for protecting a device from outside.

As the protective layer, a polymer compound, metal oxide, metal fluoride, metal boride, metal nitride, organic inorganic hybrid material and the like can be used. As the protective cover, a glass plate, and a plastic plate having a surface subjected to low water permeation treatment, and the like can be used, and a method of pasting the cover to a device substrate with a thermosetting resin or photo-curable resin to attain close sealing is suitably used. When a space is maintained using a spacer, prevention of blemishing of a device is easy. If an inert gas such as nitrogen, argon and the like is filled in this space, oxidation of a cathode can be prevented, further, by placing a drying agent such as barium oxide and the like in this space, it becomes easy to suppress moisture adsorbed in a production process from imparting damage to the device. It is preferable to at least adopt one strategy among these methods.

The polymer light emitting device of the present invention can be used for sheet light sources such as a curved light source, flat light source and the like (for example, for illumination and the like); displays such as segment displays (for example, segment type display and the like), dot matrix displays (for example, dot matrix flat display and the like), liquid crystal displays (for example, liquid crystal display, back light for liquid crystal display, and the like) and so on.

For obtaining light emission in the form of sheet using a polymer light emitting device of the present invention, it may be advantages to place a sheet anode and a sheet cathode so as to overlap. For obtaining light emission in the form of pattern, there are a method in which a mask having a window in the form of pattern is placed on the surface of the sheet light emitting device, a method in which an organic substance layer in non-light emitting parts is formed with extremely large thickness to give substantially no light emission, and a method in which either anode or cathode, or both electrodes are formed in the form pattern. By forming a pattern by any of these methods, and placing several electrodes so that On/Off is independently possible, a display of segment type is obtained which can display digits, letters, simple signs and the like. Further, for providing a dot matrix device, it may be permissible that both an anode and a cathode are formed in the form of stripe, and placed so as to cross. By using a method in which several polymer fluorescent materials showing different emission colors are painted separately or a method in which a color filter or a fluorescence conversion filter is used, partial color display and multi-color display are made possible. In the case of a dot matrix device, passive driving is also possible, and active driving may also be carried out in combination with TFT and the like. These displays can be used as a display of a computer,television set, portable terminal, cellular telephone, car navigation system, view finder of video camera, and the like.

The sheet light emitting device is of self emitting and thin type, and can be suitably used as a sheet light source for back light of a liquid crystal display, or as a sheet light source for illumination. If a flexible substrate is used, it can also be used as a curved light source or display.

### <Organic transistor (polymer electric field effect transistor)>

The polymer compound of the present invention can also be used as a material of an organic transistor. The organic transistor has the above-described thin film. The polymer compound of the present invention can be suitably used as a material of a polymer electric field effect transistor, particularly, as an active layer. Regarding the structure of a polymer electric field effect transistor, it may be usually advantageous that a source electrode and a drain electrode are placed in contact with an active layer made of a polymer, further, a gate electrode is placed sandwiching an insulation layer in contact with the active layer.

The polymer electric field effect transistor is usually formed on a supporting substrate. The material of the supporting substrate is not particularly restricted providing it does not disturb a property as an electric field effect transistor, and glass substrates and flexible film substrates and plastic substrates can also be used.

The polymer electric field effect transistor can be produced by known methods, for example, a method described in JP-A No. 5-110069.

It is very advantageous and preferable for production to use a polymer compound soluble in an organic solvent, in forming an active layer. For film formation from a liquid composition composed of an organic solvent-soluble polymer compound containing a solvent , application methods such as a spin coat method, casting method, micro gravure coat method, gravure coat method, bar coat method, roll coat method, wire bar coat method, dip coat method, spray coat method, screen printing method, flexo printing method, offset printing method, inkjet printing method and the like can be used.

Preferable is an encapsulated polymer electric field effect transistor obtained by manufacturing a polymer electric field effect transistor, then, encapsulating this. By this, the polymer electric field effect transistor is blocked from atmospheric air, thereby, lowering of properties of the polymer electric field effect transistor can be suppressed.

As the encapsulation method, a method of covering with an ultraviolet (UV) hardening resin, thermosetting resin, or inorganic SiONx film and the like, a method of pasting a glass plate or film with an UV hardening resin, thermosetting resin or the like, and other methods are mentioned. For effectively performing blocking from atmospheric air, it is preferable that processes after manufacturing of a polymer electric field effect transistor until encapsulation are carried out without exposing to atmospheric air (for example, in dried nitrogen atmosphere, vacuum and the like).

Examples for explaining the present invention further in detail will be shown below, but the present invention is not limited to them.

In the following examples, photoluminescence was measured using Fluorolog manufactured by Horiba Ltd. or an organic EL emission property evaluation apparatus IES-150 manufactured by Optel K.K. at an excitation wavelength of 350 nm. The polystyrene-equivalent number average molecular weight was measured by gel permeation chromatography (GPC: HLC-8220 GPC, manufactured by Tosoh Corp., or SCL-10A, manufactured by Shimadzu Corporation) using tetrahydrofuran as a solvent.

### (Example 1)

### Synthesis of polymer compound (PO-1)

A polymer compound (PO-1) was produced according to a method described in Japanese Patent Application National Publication No. 2005-506439.

Under an inert gas atmosphere, a compound MO-1 (0.4984 g), a compound MO-2 (0.6031 g) and a compound MO-3 (0.0215 g) were dissolved in 7.7 mL of toluene through which an inert gas had been bubbled previously. Then, the reaction mass was heated up to 85°C, and palladium acetate (0.45 mg) and tris(2-methoxyphenyl)phosphine (7.05 mg) were added and the mixture was heated up to 100°C, then, 2.1 ml of a 2 mol% sodium carbonate aqueous solution was added and the mixture was refluxed for 7 hours and was poured into methanol (155 ml) to obtain 0.40 g of a polymer compound (PO-1).

The polystyrene-equivalent number average molecular weight and weight average molecular weight were Mn=2.9×10⁴ and Mw=6.1×10⁴, respectively.

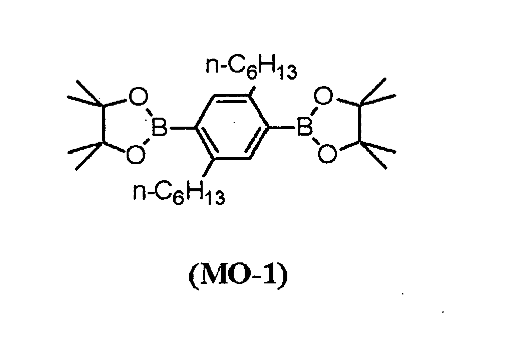

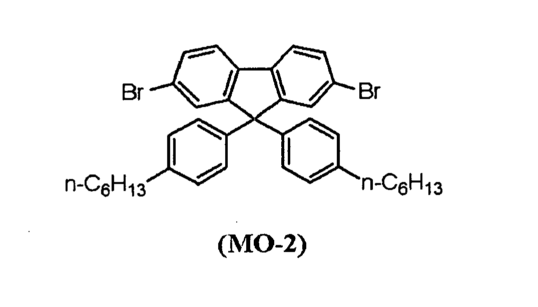

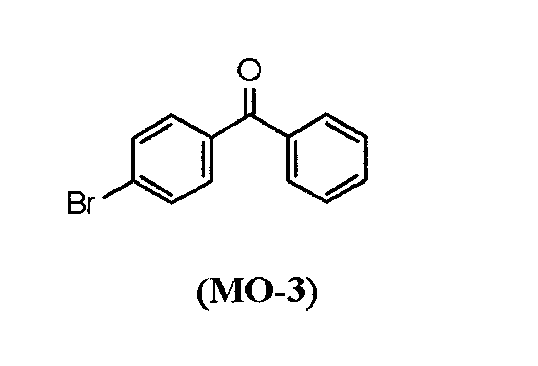

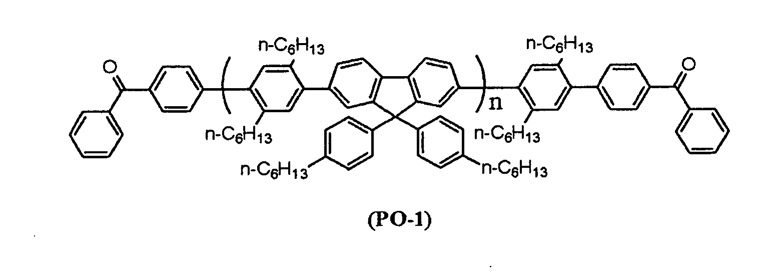

### (Example 2)

### Synthesis of polymer compound (PO-2)

Under an inert gas atmosphere, a compound MO-1 (0.4984 g), a compound MO-2 (0.5154 g) and a compound MO-4 (0.0680 g) were dissolved in 10.0 mL of toluene through which an inert gas had been bubbled previously. Then, the reaction mass was heated up to 85°C, and palladium acetate (0.70 mg) and tris(2-methoxyphenyl)phosphine (7.40 mg) were added and the mixture was heated up to 100°C, then, 2.7 ml of a 17.5 wt% sodium carbonate aqueous solution was added and the mixture was refluxed for 7 hours and was poured into methanol (155 ml) to obtain 0.29 g of a polymer compound (PO-2).

The polystyrene-equivalent number average molecular weight and weight average molecular weight were Mn=9.6×10⁴ and Mw=2.5×10⁵, respectively.

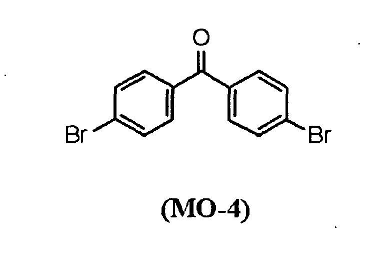

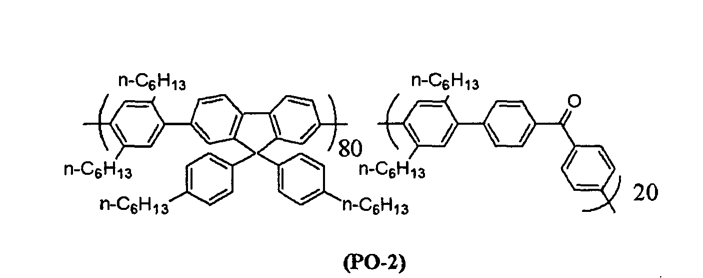

### (Example 3)

### Synthesis of polymer compound (PO-3)

Under an inert gas atmosphere, a compound MO-1 (0.9917 g), a compound MO-2 (0.5156 g), a compound MO-4 (0.3400 g) and a compound MO-5 (0.1477 g) were dissolved in 10.0 mL of toluene through which an inert gas had been bubbled previously. Then, the reaction mass was heated up to 85°C, and palladium acetate (1.30 mg) and tris(2-methoxyphenyl)phosphine (14.80 mg) were added and the mixture was heated up to 100°C, then, 5.4 ml of a 17.5 wt% sodium carbonate aqueous solution was added and the mixture was refluxed for 7 hours and was poured into methanol (155 ml) to obtain 0.36 g of a polymer compound (PO-3). The polystyrene-equivalent number average molecular weight and weight average molecular weight were Mn=6.6×10⁴ and Mw=1.4×10⁵, respectively.

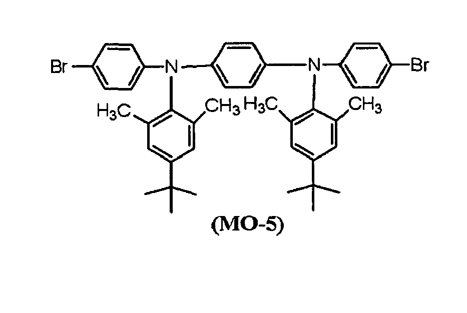

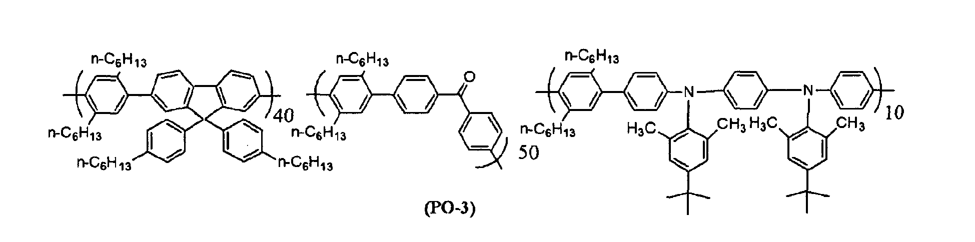

### (Synthesis Example 1)

### Synthesis of polymer compound (PO-4)

Under an inert gas atmosphere, a compound MO-6 (0.7387 g) and a compound MO-4 (0.3383 g) were dissolved in 10.0 mL of toluene through which an inert gas had been bubbled previously. Then, the reaction mass was heated up to 85°C, and palladium acetate (0.70 mg) and tris(2-methoxyphenyl)phosphine (7.40 mg) were added and the mixture was heated up to 100°C, then, 2.7 ml of a 17.5 wt% sodium carbonate aqueous solution was added and the mixture was refluxed for 7 hours and was poured into methanol (155 ml) to obtain 0.04 g of a polymer compound (PO-4). The polystyrene-equivalent number average molecular weight and weight average molecular weight were Mn=3.0×10⁴ and Mw=4.9×10⁴, respectively.

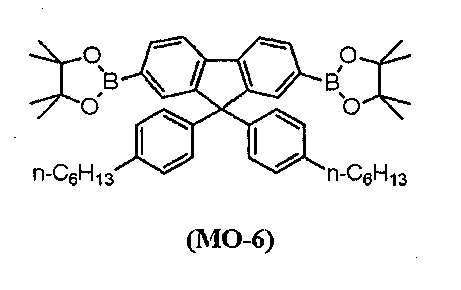

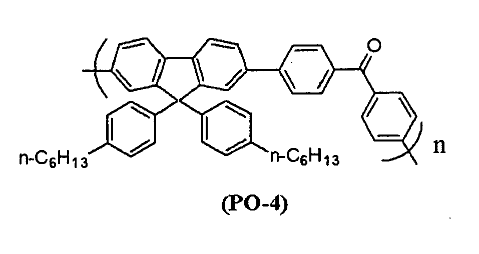

### Synthesis of iridium complex (CO-1)

Synthesis was performed according to a synthesis method described in WO 02/066552. That is, under an inert gas atmosphere, 2-bromopyridine and 1.2 equivalent of 3-bromophenyl boronic acid were subjected to the Suzuki coupling (catalyst: tetrakis (triphenylphosphine) palladium (0), base: 2M sodium carbonate aqueous solution, solvent: ethanol, toluene) to obtain 2-(3'-bromophenyl)pyridine.

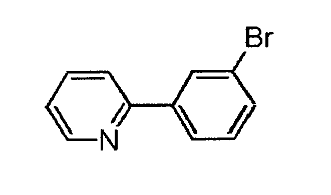

Next, under an inert gas atmosphere, tribromobenzene and 2.2 equivalent of 4-tert-butylphenyl boronic acid were subjected to the Suzuki coupling (catalyst: tetrakis (triphenylphosphine) palladium (0), base: 2M sodium carbonate aqueous solution, solvent: ethanol, toluene) to obtain the following bromo compound.

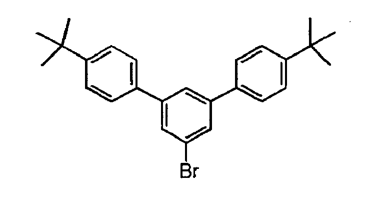

Under an inert gas atmosphere, this bromo compound was dissolved in anhydrous THF, then, cooled down to -78°C, and small excess of tert-BuLi was dropped. Under cooling, B(OC₄H₉)3 was further dropped, and reacted at room temperature. A post-treatment was performed with 3M hydrochloric acid water, to obtain the following boronic acid compound.

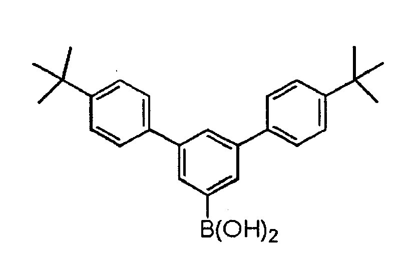

2-(3'-bromophenyl)pyridine and 1.2 equivalent of the above-describedboronic acid compound were subjected to the Suzuki coupling (catalyst: tetrakis (triphenylphosphine) palladium (0), base: 2M sodium carbonate aqueous solution, solvent: ethanol, toluene) to obtain the following ligand.

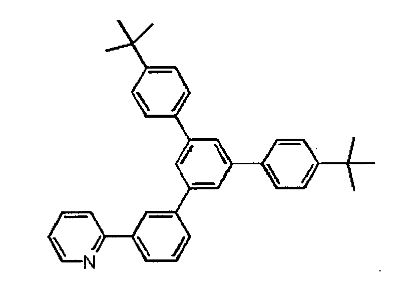

Under an argon atmosphere, the above-described ligand, 4 equivalent of IrCl₃· 3H₂O, 2-EtOEtOH and ion exchanged water were charged and refluxed. The precipitated solid was filtrated under suction. The resultant solid was washed with ethanol and ion exchanged water, then, dried to obtain a yellow powder.

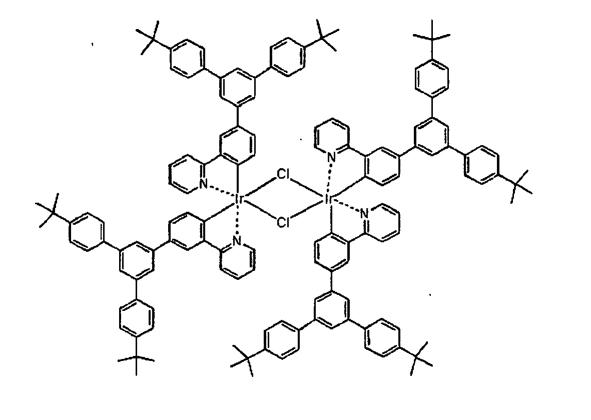

Under an argon atmosphere, 2 equivalent of the ligand was added to the yellow powder obtained above, and the mixture was heated in a glycol solvent, to obtain the following iridium complex (CO-1).

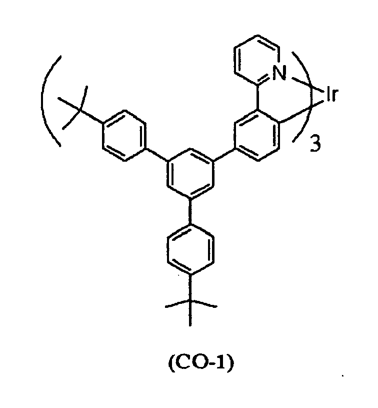

### (Example 4)

### --Preparation of composition 1--

A 1.9 wt% xylene solution of a mixture obtained by mixing the above-described polymer compound (PO-1) and the above-described iridium complex (CO-1) at a weight ratio of 80:20 was prepared (hereinafter, referred to as "composition 1")

### (Example 5)

### --Manufacturing of light emitting device--

On a glass substrate carrying thereon an ITO film with a thickness of 150 nm formed by a sputtering method, a solution of poly(ethylenedioxythiophene)/polystyrenes ulfonic acid (Baytron P, manufactured by Bayer) was spin-coated to form a film with a thickness of 65 nm which was then dried on a hot plate at 20.0°C for 10 minutes. Next, the composition 1 prepared above was spin-coated at a revolution of 1800 rpm to form a film. The film thickness was about 80 nm. This was dried under a nitrogen gas atmosphere at 130°C for 1 hour, then, as cathode, barium was vapor-deposited with a thickness of about 5 nm, then, aluminum was vapor-deposited with a thickness of about 80 nm, manufacturing an EL device. After the degree of vacuum reached 1×10⁻⁴ Pa or lower, metal vapor deposition was initiated.

Voltage was applied on the resultant device, to observe green EL emission (peak wavelength: 515 nm). The device showed light emission of 100 cd/m² at 8.5 V, and showed a maximum efficiency of 37.9 cd/A.

### (Example 6)

### --Preparation of composition 2--

A 1.5 wt% xylene solution of a mixture obtained by mixing the above-described polymer compound (PO-2) and the above-described iridium complex (CO-1) at a weight ratio of 80:20 was prepared (hereinafter, referred to as "composition 2").

### (Example 7)

### --Manufacturing of light emitting device--

Using the composition 2, an EL device was manufactured in the same manner as in Example 5. A light emitting layer was formed by spin coat at a revolution of 1800 rpm. The film thickness was about 80 nm. Voltage was applied on the resultant device, to observe green EL emission (peak wavelength: 515 nm). The device showed light emission of 100 cd/m² at 6.9 V, and showed a maximum efficiency of 36.1 cd/A.

### (Example 8)

### --Preparation of composition 3--

A 1.5 wt% xylene solution of a mixture obtained by mixing the above-described polymer compound (PO-3) and the above-described iridium complex (CO-1) at a weight ratio of 80:20 was prepared (hereinafter, referred to as "composition 3").

### (Example 9)

### --Manufacturing of light emitting device--

Using the composition 3, an EL device was manufactured in the same manner as in Example 5. A light emitting layer was formed by spin coat at a revolution of 1200 rpm. The film thickness was about 80 nm. Voltage was applied on the resultant device, to observe green EL emission (peak wavelength: 515 nm). The device showed light emission of 100 cd/m² at 5.2 V, and showed a maximum efficiency of 29.9 cd/A.

### (Comparative Example 1)

### --Preparation of composition 4--

The above-described polymer compound (PO-4) was used instead of the polymer compound (PO-1), and a 1.0 wt% chloroform solution of a mixture obtained by mixing the polymer compound (PO-4) and the above-described iridium complex (CO-1) at a weight ratio of 80:20 was prepared (hereinafter, referred to as "composition 4").

### (Comparative Example 2)

### --Manufacturing of light emitting device--

Using the composition 4, an EL device was manufactured in the same manner as in Example 5. A light emitting layer was formed by spin coat at a revolution of 1000 rpm. The film thickness was about 280 nm. Voltage was applied on the resultant device, to observe green EL emission (peak wavelength: 525 nm). Voltage up to 12 V was applied on the device, however, only light emission of 3 cd/m² was observed. The device showed a maximum efficiency of 1.1 cd/A.

### Industrial Applicability

The polymer compound and composition of the present invention show high maximum luminous efficiency when used for manufacturing of an organic EL device. Thus, the polymer compound and composition of the present invention are useful as a light emitting material.

Therefore, the polymer compound and composition of the present invention are suitable for sheet light sources such as a curved light source, flat light source and the like (for example, for illumination and the like); displays such as segment displays (for example, segment type display and the like), dot matrix displays (for example, dot matrix flat display and the like), liquid crystal displays (for example, liquid crystal display, back light for liquid crystal display, and the like) and so on.

## Claims

1. A polymer compound comprising, as repeating units, an optionally substituted fluorenediyl group and a phenylene group having one or more substituents, and comprising a repeating unit of the following formula (1) and/or a group of the following formula (2): 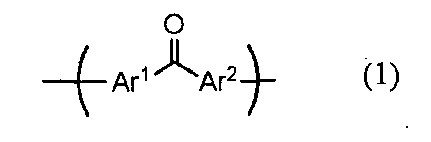 (in the formula (1), Ar¹ and Ar² represent an arylene group or di-valent aromatic heterocyclic group, and Ar¹ and Ar² may be the same or different.) 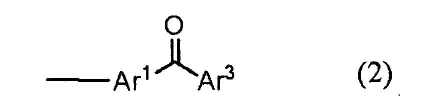 (in the formula (2), Ar¹ represents the same meaning as described above. Ar³ represents an aryl group or mono-valent aromatic heterocyclic group.).

2. The polymer compound according to Claim 1, comprising said repeating unit of the formula (1).

3. The polymer compound according to Claim 2, wherein said repeating unit of the formula (1) is represented by the following formula (1-1): 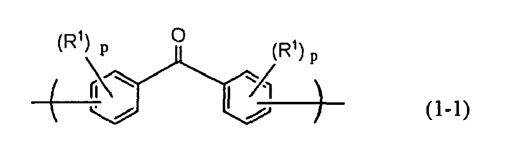 (in the formula (1-1), R¹ represents an alkyl group, alkoxy group, alkylthio group, aryl group, aryloxy group, arylthio group, arylalkyl group, arylalkoxy group, arylalkylthio group, arylalkenyl group, arylalkynyl group or mono-valent heterocyclic group. p's represent independently an integer of 0 to 4. When there exist a plurality of R¹'s, they may be the same or different.).

4. The polymer compound according to Claim 3, wherein said repeating unit of the formula (1-1) is represented by the following formula (1-2):

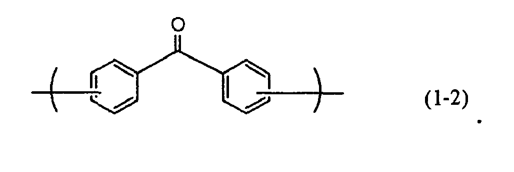

5. The polymer compound according to Claim 1, having said group of the formula (2) as at least one of end groups of the polymer compound.

6. The polymer compound according to Claim 5, wherein said group of the formula (2) is represented by the following formula (2-1): 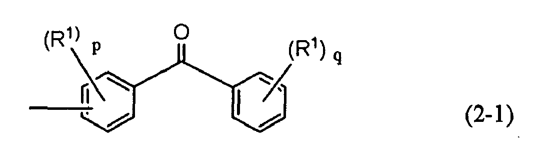 (in the formula (2-1), q represents an integer of 0 to 5. R¹ and p represent the same meanings as described above.).

7. The polymer compound according to Claim 6, wherein said group of the formula (2-1) is represented by the following formula (2-2):

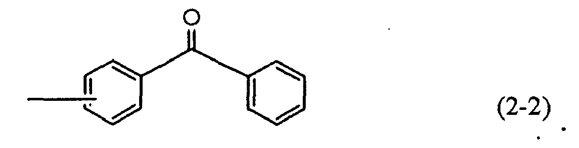

8. The polymer compound according to any one of Claim 1 to 7, wherein the optionally substituted fluorenediyl group is represented by the following formula (3): 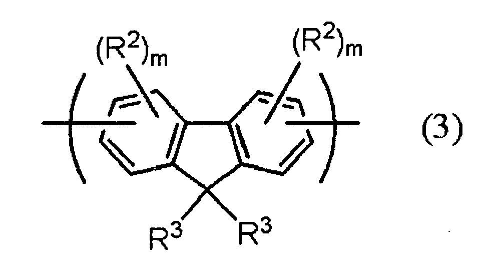 (in the formula (3), R² represents a substituent, R³ represents an alkyl group, alkoxy group, aryl group or mono-valent heterocyclic group, and m's represent independently an integer of 0 to 3. When there exist a plurality of R²'s, they may be the same or different. A plurality of R³'s may be the same or different.).

9. The polymer compound according to Claim 8, wherein said formula (3) is represented by the following formula (3-1): 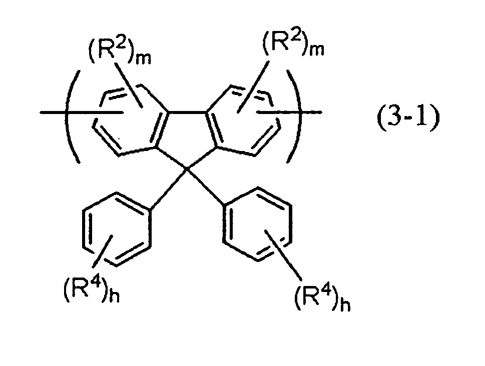 (in the formula (3-1), R² and m represent the same meanings as described above, R⁴ represents a substituent, and h represents an integer of 0 to 5. When there exist a plurality of R²'s and R⁴'s, they each may be the same or different. A plurality of m's and h's each may be the same or different.).

10. The polymer compound according to Claim 9, wherein said formula (3-1) is represented by the following formula (3-2): 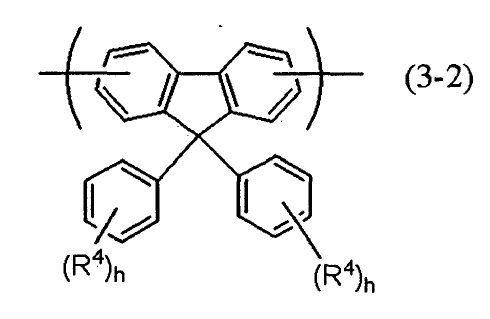 (in the formula (3-2), R⁴ and h represent the same meanings as described above. When there exist a plurality of R⁴'s, they may be the same or different. A plurality of h's may be the same or different.).

11. The polymer compound according to any one of Claims 1 to 10, wherein the phenylene group having one or more substituents is represented by the following formula (4): 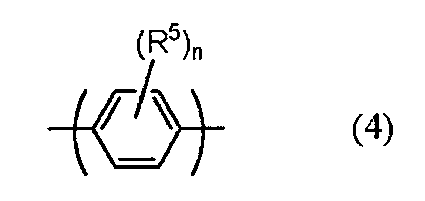 (in the formula (4), R⁵ represents an alkyl group, alkoxy group, alkylthio group, aryl group, aryloxy group, arylthio group, arylalkyl group, arylalkoxy group, arylalkylthio group, arylalkenyl group, arylalkynyl group or mono-valent heterocyclic group. n represents an integer of 1 to 4. When there exist a plurality of R⁵'s, they may be the same or different.).

12. The polymer compound according to Claim 11, wherein said formula (4) is represented by the following formula (4-1) : 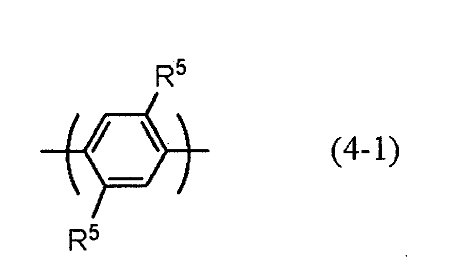 (in the formulae, R⁵ represents the same meaning as described above.).

13. The polymer compound according to Claim 1 comprising said repeating unit of the formula (1-2), said repeating unit of the formula (3-2) and said repeating unit of the formula (4-1).

14. The polymer compound according to Claim 1 comprising said repeating unit of the formula (3-2) and said repeating unit of the formula (4-1), and having said group of the formula (2-2) as at least one of end groups of the polymer compound.

15. The polymer compound according to any one of Claims 1 to 14, further having a mono-valent residue of a compound showing light emission from the triplet excited state as at least one of end groups of the polymer compound.

16. The polymer compound according to any one of Claims 1 to 15, further comprising a di-valent or tri-valent residue of a compound showing light emission from the triplet excited state, in the main chain.

17. The polymer compound according to any one of Claims 1 to 16, further comprising an arylene group or di-valent heterocyclic group which has as a substituent a mono-valent residue of a compound showing light emission from the triplet excited state.

18. The polymer compound according to any one of Claims 1 to 17, having a polystyrene-equivalent weight average molecular weight of 3×10³ to 1×10⁸.

19. A composition comprising the polymer compound according to any one of Claims 1 to 18, and a compound showing light emission from the triplet excited state.

20. The composition according to Claim 19, wherein the content of said compound showing light emission from the triplet excited state is 0.01 to 50 parts by weight with respect to 100 parts by weight of said polymer compound.

21. The composition according to Claim 19 or 20, further comprising at least one material selected from the group consisting of hole transporting materials, electron transporting materials and light emitting materials.

22. The composition according to any one of Claims 19 to 21, comprising a polymer compound not having said repeating unit of the formula (1) and said group of the formula (2).

23. A liquid composition comprising a solvent and the polymer compound as described in any one of Claims 1 to 18.

24. A liquid composition comprising a solvent and the composition as described in any one of Claims 19 to 22.

25. A thin film comprising the polymer compound as described in any one of Claims 1 to 18.

26. A thin film comprising the composition as described in any one of Claims 19 to 22.

27. A polymer light emitting device having electrodes composed of an anode and a cathode, and the thin film as described in Claim 25 or 26 between the electrodes.
